# EUROPEAN PATENT APPLICATION

(11) **EP 4 310 911 A1**
(43) Date of publication of application: **24.01.2024**
(21) Application number: 22770929.2
(22) Date of filing: 04.02.2022
(51) Int. Cl.: H01L 27/146, H04N 9/07, G02B 5/20

(54) **IMAGING DEVICE**

(30) Priority: 16.03.2021 JP 2021042341; 12.01.2022 JP 2022003238
(71) Applicant: Sony Semiconductor Solutions Corporation, Atsugi-shi, Kanagawa 243-0014 (JP)
(72) Inventor: SEKIGUCHI, Koji, Atsugi-shi, Kanagawa 243-0014 (JP); YOKOCHI, Kaito, Atsugi-shi, Kanagawa 243-0014 (JP); OGASAHARA, Takayuki, Atsugi-shi, Kanagawa 243-0014 (JP); IKEHARA, Shigehiro, Atsugi-shi, Kanagawa 243-0014 (JP); YAMANE, Chigusa, Atsugi-shi, Kanagawa 243-0014 (JP); KOBAYASHI, Hideki, Atsugi-shi, Kanagawa 243-0014 (JP); SAITO, Hiroshi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/004483
(87) International publication number: WO 2022/196169

(57) **Abstract**

Provided is an imaging device capable of further suppressing color mixing between pixels.

The imaging device includes: a semiconductor substrate provided with a photoelectric conversion unit for each of pixels two-dimensionally arranged; a color filter provided for each of the pixels on the semiconductor substrate; an intermediate layer provided between the semiconductor substrate and the color filter; and a low refraction region provided between the pixels by separating at least the color filter and the intermediate layer for each of the pixels, the low refraction region having a refractive index lower than a refractive index of the color filter.

## Description

### TECHNICAL FIELD

The present disclosure relates to an imaging device.

### BACKGROUND ART

As an imaging device used for a digital camera or a video camera, a charge coupled device (CCD) image sensor or a complementary MOS (CMOS) image sensor is known.

These image sensors are provided, for example, as a back-illuminated imaging device that receives light incident from the back surface side of a semiconductor substrate on which no wiring layer is formed by a photoelectric conversion unit (see, for example, Patent Document 1.).

### CITATION LIST

### PATENT DOCUMENT

Patent Document 1: Japanese Patent Application Laid-Open No. 2012-209542

### SUMMARY OF THE INVENTION

### PROBLEMS TO BE SOLVED BY THE INVENTION

In such an imaging device, it is required to suppress color mixing between pixels in order to further improve the image quality of an image to be captured.

In view of the above circumstances, it is desirable to provide a new and improved imaging device capable of further suppressing color mixing between pixels.

### SOLUTIONS TO PROBLEMS

According to the present disclosure, there is provided an imaging device including: a semiconductor substrate provided with a photoelectric conversion unit for each of pixels two-dimensionally arranged; a color filter provided for each of the pixels on the semiconductor substrate; an intermediate layer provided between the semiconductor substrate and the color filter; and a low refraction region provided between the pixels by separating at least the color filter and the intermediate layer for each of the pixels, the low refraction region having a refractive index lower than a refractive index of the color filter.

According to the present disclosure, light traveling to an adjacent pixel can be reflected at the interface between the color filter and the low refraction region and the interface between the intermediate layer and the low refraction region.

### BRIEF DESCRIPTION OF DRAWINGS

Fig. 1 is a schematic diagram illustrating an overall configuration of an imaging device according to an embodiment of the present disclosure.
Fig. 2 is a longitudinal cross-sectional view illustrating a cross-sectional configuration of a pixel unit according to the embodiment.
Fig. 3 is a longitudinal cross-sectional view illustrating a variation of a cross-sectional shape of a gap constituting a low refraction region.
Fig. 4A is a plan view illustrating an example of a planar configuration of a pixel unit.
Fig. 4B is a plan view illustrating an example of a planar configuration of a pixel unit.
Fig. 4C is a plan view illustrating an example of a planar configuration of a pixel unit.
Fig. 5 is a longitudinal cross-sectional view illustrating a cross-sectional configuration of a pixel unit according to a first modification.
Fig. 6 is a longitudinal cross-sectional view illustrating a cross-sectional configuration of a pixel unit according to a second modification.
Fig. 7 is a longitudinal cross-sectional view illustrating a cross-sectional configuration of a pixel unit according to a third modification.
Fig. 8 is a longitudinal cross-sectional view illustrating a cross-sectional configuration of a pixel unit according to a fourth modification.
Fig. 9 is a longitudinal cross-sectional view illustrating a cross-sectional configuration of a pixel unit according to a fifth modification.
Fig. 10 is a longitudinal cross-sectional view illustrating a cross-sectional configuration of a pixel unit according to a sixth modification.
Fig. 11 is a longitudinal cross-sectional view illustrating a cross-sectional configuration of a pixel unit according to a seventh modification.
Fig. 12 is a longitudinal cross-sectional view illustrating a cross-sectional configuration of a pixel unit according to an eighth modification.
Fig. 13 is a longitudinal cross-sectional view illustrating a cross-sectional configuration of a pixel unit according to a ninth modification.
Fig. 14 is a longitudinal cross-sectional view illustrating a cross-sectional configuration of a pixel unit according to a 10th modification.
Fig. 15 is a longitudinal cross-sectional view illustrating a cross-sectional configuration of a pixel unit according to an 11th modification.
Fig. 16 is a longitudinal cross-sectional view illustrating a cross-sectional configuration of a pixel unit according to a 12th modification.
Fig. 17 is a longitudinal cross-sectional view illustrating a cross-sectional configuration of a pixel unit according to a 13th modification.
Fig. 18 is a longitudinal cross-sectional view illustrating a cross-sectional configuration of a pixel unit according to a 14th modification.
Fig. 19 is a longitudinal cross-sectional view illustrating a cross-sectional configuration of a pixel unit according to a 15th modification.
Fig. 20 is a longitudinal cross-sectional view illustrating a cross-sectional configuration of a pixel unit according to a 16th modification.
Fig. 21 is a longitudinal cross-sectional view illustrating a cross-sectional configuration of a pixel unit according to a 17th modification.
Fig. 22 is a longitudinal cross-sectional view illustrating a cross-sectional configuration of a pixel unit according to an 18th modification.
Fig. 23 is a longitudinal cross-sectional view illustrating a cross-sectional configuration of a pixel unit according to a 19th modification.
Fig. 24 is a longitudinal cross-sectional view illustrating a cross-sectional configuration of a pixel unit according to a 20th modification.
Fig. 25 is a longitudinal cross-sectional view illustrating a cross-sectional configuration of a pixel unit according to a 21st modification.
Fig. 26 is a longitudinal cross-sectional view illustrating a cross-sectional configuration of a pixel unit according to a 22nd modification.
Fig. 27 is a longitudinal cross-sectional view illustrating a cross-sectional configuration of a pixel unit according to a 23rd modification.
Fig. 28A is a plan view illustrating an example of planar arrangement in a case where phase difference pixels and normal pixels are mixed.
Fig. 28B is a plan view illustrating an example of planar arrangement in a case where phase difference pixels and normal pixels are mixed.
Fig. 28C is a plan view illustrating an example of planar arrangement in a case where phase difference pixels and normal pixels are mixed.
Fig. 29A is a plan view illustrating an example of a planar arrangement in a case of only phase difference pixels.
Fig. 29B is a plan view illustrating an example of a planar arrangement in a case of only phase difference pixels.
Fig. 29C is a plan view illustrating an example of a planar arrangement in a case of only phase difference pixels.
Fig. 30 is a longitudinal cross-sectional view illustrating a cross-sectional configuration of a pixel unit according to a second embodiment of the present disclosure.
Fig. 31 is an enlarged longitudinal cross-sectional view of the vicinity of a light shielding unit in Fig. 30.
Fig. 32A is a longitudinal cross-sectional view illustrating a variation of a configuration in the vicinity of a light shielding unit according to a first modification.
Fig. 32B is a longitudinal cross-sectional view illustrating a variation of the configuration in the vicinity of the light shielding unit according to the first modification.
Fig. 32C is a longitudinal cross-sectional view illustrating a variation of the configuration in the vicinity of the light shielding unit according to the first modification.
Fig. 32D is a longitudinal cross-sectional view illustrating a variation of the configuration in the vicinity of the light shielding unit according to the first modification.
Fig. 32E is a longitudinal cross-sectional view illustrating a variation of the configuration in the vicinity of the light shielding unit according to the first modification.
Fig. 32F is a longitudinal cross-sectional view illustrating a variation of the configuration in the vicinity of the light shielding unit according to the first modification.
Fig. 33 is a longitudinal cross-sectional view illustrating a cross-sectional configuration of a pixel unit according to a second modification.
Fig. 34 is a longitudinal cross-sectional view illustrating a cross-sectional configuration of a pixel unit according to a third modification.
Fig. 35 is a longitudinal cross-sectional view illustrating a cross-sectional configuration of a pixel unit according to a fourth modification.
Fig. 36 is a longitudinal cross-sectional view illustrating a cross-sectional configuration of a pixel unit according to a fifth modification.
Fig. 37 is a longitudinal cross-sectional view illustrating a cross-sectional configuration of a pixel unit according to a sixth modification.
Fig. 38 is a longitudinal cross-sectional view illustrating a cross-sectional configuration of a pixel unit according to a seventh modification.
Fig. 39 is a longitudinal cross-sectional view illustrating a cross-sectional configuration of a pixel unit according to an eighth modification.
Fig. 40 is a longitudinal cross-sectional view illustrating a cross-sectional configuration of a pixel unit according to an eighth modification.
Fig. 41 is a longitudinal cross-sectional view illustrating a cross-sectional configuration of a pixel unit according to an eighth modification.
Fig. 42 is a longitudinal cross-sectional view illustrating a cross-sectional configuration of a pixel unit according to a ninth modification.
Fig. 43 is a longitudinal cross-sectional view illustrating a cross-sectional configuration of a pixel unit according to a 10th modification.
Fig. 44 is a longitudinal cross-sectional view illustrating a cross-sectional configuration of a pixel unit according to an 11th modification.
Fig. 45 is a longitudinal cross-sectional view illustrating a cross-sectional configuration of a pixel unit according to a 12th modification.
Fig. 46 is a longitudinal cross-sectional view illustrating a cross-sectional configuration of a pixel unit according to a 13th modification.
Fig. 47 is a longitudinal cross-sectional view illustrating a cross-sectional configuration of a pixel unit according to a 14th modification.
Fig. 48A is a plan view illustrating an example of a planar arrangement of color filters in a pixel unit.
Fig. 48B is a plan view illustrating an example of a planar arrangement of color filters in a pixel unit.
Fig. 48C is a plan view illustrating an example of a planar arrangement of color filters in a pixel unit.
Fig. 48D is a plan view illustrating an example of a planar arrangement of color filters in a pixel unit.
Fig. 48E is a plan view illustrating an example of a planar arrangement of color filters in a pixel unit.
Fig. 48F is a plan view illustrating an example of a planar arrangement of color filters in a pixel unit.
Fig. 48G is a plan view illustrating an example of a planar arrangement of color filters in a pixel unit.
Fig. 48H is a plan view illustrating an example of a planar arrangement of color filters in a pixel unit.
Fig. 48I is a plan view illustrating an example of a planar arrangement of color filters in a pixel unit.
Fig. 49A is a plan view illustrating an example of a combination of a color filter and a normal pixel or a phase difference pixel.
Fig. 49B is a plan view illustrating an example of a combination of a color filter and a normal pixel or a phase difference pixel.
Fig. 49C is a plan view illustrating an example of a combination of a color filter and a normal pixel or a phase difference pixel.
Fig. 49D is a plan view illustrating an example of a combination of a color filter and a normal pixel or a phase difference pixel.
Fig. 49E is a plan view illustrating an example of a combination of a color filter and a normal pixel or a phase difference pixel.
Fig. 49F is a plan view illustrating an example of a combination of a color filter and a normal pixel or a phase difference pixel.
Fig. 50 is a plan view for explaining a configuration of a pixel unit according to a 15th modification.
Fig. 51 is a longitudinal cross-sectional view illustrating a cross-sectional configuration taken along line A-AA in Fig. 50 and a cross-sectional configuration taken along line B-BB in comparison.
Fig. 52 is a longitudinal cross-sectional view for explaining a step of forming the pixel unit according to the 15th modification.
Fig. 53 is a longitudinal cross-sectional view for explaining a step of forming the pixel unit according to the 15th modification.
Fig. 54 is a longitudinal cross-sectional view for explaining a step of forming the pixel unit according to the 15th modification.
Fig. 55 is a longitudinal cross-sectional view for explaining a step of forming the pixel unit according to the 15th modification.
Fig. 56 is a longitudinal cross-sectional view for explaining a step of forming the pixel unit according to the 15th modification.
Fig. 57 is a longitudinal cross-sectional view for explaining a step of forming the pixel unit according to the 15th modification.
Fig. 58 is a longitudinal cross-sectional view for explaining a step of forming the pixel unit according to the 15th modification.
Fig. 59 is a longitudinal cross-sectional view for explaining a step of forming the pixel unit according to the 15th modification.
Fig. 60 is a longitudinal cross-sectional view for explaining a step of forming the pixel unit according to the 15th modification.
Fig. 61 is a longitudinal cross-sectional view for explaining a step of forming the pixel unit according to the 15th modification.
Fig. 62 is a longitudinal cross-sectional view for explaining a step of forming the pixel unit according to the 15th modification.
Fig. 63 is a longitudinal cross-sectional view for explaining a step of forming the pixel unit according to the 15th modification.
Fig. 64 is a longitudinal cross-sectional view for explaining a step of forming the pixel unit according to the 15th modification.
Fig. 65 is a longitudinal cross-sectional view illustrating a configuration in the vicinity of a light shielding unit of a pixel unit according to a 16th modification.
Fig. 66 is a longitudinal cross-sectional view for explaining a step of forming the pixel unit according to the 16th modification.
Fig. 67 is a longitudinal cross-sectional view for explaining a step of forming the pixel unit according to the 16th modification.
Fig. 68 is a block diagram illustrating a configuration example of an electronic device including an imaging device according to an embodiment of the present disclosure.
Fig. 69 is a block diagram depicting an example of schematic configuration of a vehicle control system.
Fig. 70 is a diagram of assistance in explaining an example of installation positions of an outside-vehicle information detecting section and an imaging section.

### MODE FOR CARRYING OUT THE INVENTION

A preferred embodiment of the present disclosure is hereinafter described in detail with reference to the accompanying drawings. Note that, in the present specification and the drawings, components having substantially the same functional configuration are denoted by the same reference numerals, and redundant description is omitted.

Note that, the description will be given in the following order.
1. Overall Configuration of Imaging Device
2. First Embodiment
   2.1. Configuration of Pixel Unit
   2.2. Modifications
3. Second Embodiment
   3.1. Configuration of Pixel Unit
   3.2. Modifications
4. Configuration of Electronic Device
5. Application Example

### <1. Overall Configuration of Imaging Device>

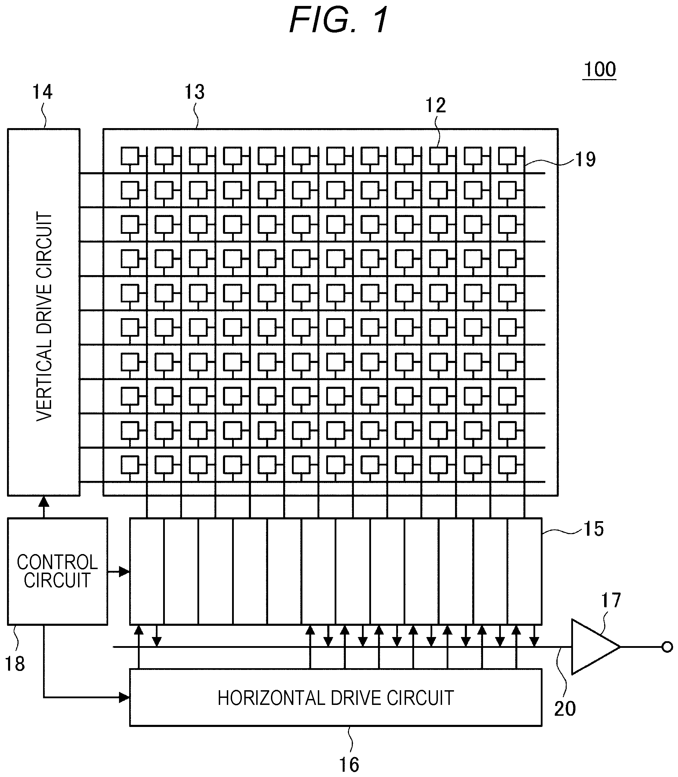

First, an overall configuration of an imaging device to which the technology according to the present disclosure is applied will be described with reference to Fig. 1. Fig. 1 is a schematic diagram illustrating an overall configuration of an imaging device 100 to which the technology according to the present disclosure is applied.

As illustrated in Fig. 1, the imaging device 100 includes a pixel unit 13 having a plurality of pixels 12 formed on a semiconductor substrate, a vertical drive circuit 14, a column signal processing circuit 15, a horizontal drive circuit 16, an output circuit 17, and a control circuit 18.

The pixel unit 13 includes the plurality of pixels 12 regularly arranged in a two-dimensional array. For example, the pixel unit 13 may include an effective pixel region including a pixel that amplifies a signal charge obtained by photoelectrically converting incident light and reads the signal charge to the column signal processing circuit 15, and a black reference pixel region (not illustrated) including a pixel that outputs optical black serving as a reference of a black level. The black reference pixel region is formed, for example, on an outer peripheral portion of the effective pixel region.

The pixel 12 includes, for example, a photodiode (not illustrated) which is a photoelectric conversion element, and a pixel circuit (not illustrated) including a transfer transistor, a reset transistor, a selection transistor, and an amplifier transistor. Note that the pixel circuit may not include the selection transistor. The signal charge photoelectrically converted by the photodiode is converted into a pixel signal by the pixel circuit.

Furthermore, the pixel 12 may be provided in a shared pixel structure. In the shared pixel structure, the plurality of pixels 12 includes a plurality of photodiodes, a plurality of transfer transistors, one shared floating diffusion (floating diffusion region), one shared reset transistor, one shared selection transistor, and one shared amplifier transistor. That is, in the shared pixel structure, the photodiodes and the transfer transistors included in the plurality of pixels 12 share the reset transistor, the selection transistor, and the amplifier transistor with each other.

The control circuit 18 generates a clock signal and a control signal serving as references of operations of the vertical drive circuit 14, the column signal processing circuit 15, and the horizontal drive circuit 16 on the basis of the vertical synchronization signal, the horizontal synchronization signal, and the master clock. The control circuit 18 controls the vertical drive circuit 14, the column signal processing circuit 15, and the horizontal drive circuit 16 using the clock signal and the control signal.

The vertical drive circuit 14 includes, for example, a shift register. The vertical drive circuit 14 selectively scans the pixels 12 sequentially in the vertical direction in units of rows. The vertical drive circuit 14 supplies a pixel signal generated according to the amount of light received in the pixel 12 to the column signal processing circuit 15 via a vertical signal line 19.

The column signal processing circuit 15 is arranged, for example, for each column of the pixels 12. On the basis of the signal from the black reference pixel region, the column signal processing circuit 15 performs signal processing such as noise removal and signal amplification on the pixel signals output from the pixels 12 of one row for each pixel column. A horizontal selection switch (not illustrated) is provided at an output stage of the column signal processing circuit 15 to be connected with a horizontal signal line 20.

The horizontal drive circuit 16 includes, for example, a shift register. The horizontal drive circuit 16 sequentially outputs horizontal scanning pulses and sequentially selects each of the column signal processing circuits 15 to cause each of the column signal processing circuits 15 to output a pixel signal to the horizontal signal line 20.

The output circuit 17 performs signal processing on the pixel signals sequentially supplied from each of the column signal processing circuits 15 via the horizontal signal line 20, and outputs the pixel signals subjected to the signal processing to the outside.

### <2. First Embodiment>

### (2.1. Configuration of Pixel Unit)

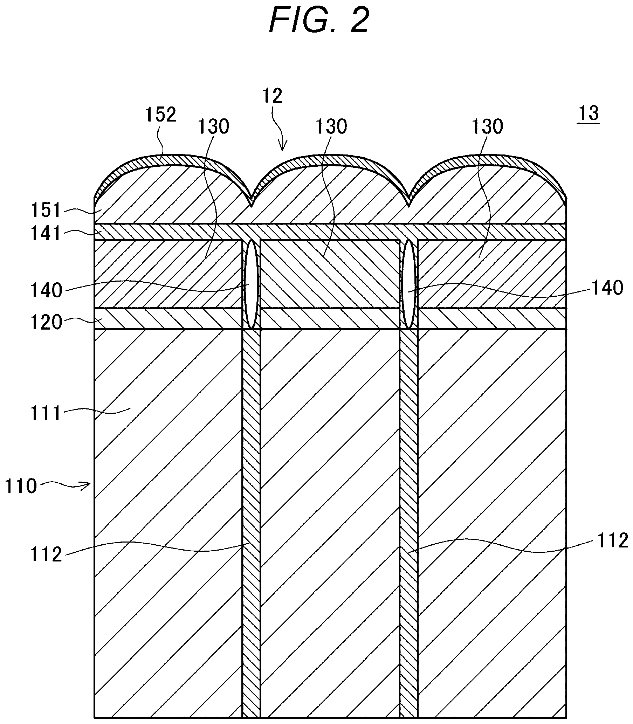

Next, a cross-sectional configuration of the pixel unit 13 according to the first embodiment of the present disclosure will be described with reference to Fig. 2. Fig. 2 is a longitudinal cross-sectional view illustrating a cross-sectional configuration of the pixel unit 13.

As illustrated in Fig. 2, the pixel unit 13 includes a semiconductor substrate 110, an intermediate layer 120, a color filter 130, an insulating layer 141, an on-chip lens 151, and an antireflection film 152.

The semiconductor substrate 110 is, for example, a substrate having a thickness of 1 µm to 6 µm and constituted by silicon (Si). The semiconductor substrate 110 is provided with a photoelectric conversion unit 111 that generates a signal charge corresponding to the amount of received incident light for each pixel 12. The photoelectric conversion unit 111 is, for example, a photodiode, and is configured by providing a semiconductor region of a second conductivity type (for example, N-type) inside a semiconductor region of a first conductivity type (for example, P-type) for each pixel 12.

Furthermore, the photoelectric conversion units 111 provided for the respective pixels 12 are electrically separated from each other by a pixel separation wall 112 constituted by an insulating material. The pixel separation wall 112 may be constituted by, for example, an insulating material such as silicon oxide (SiO₂), silicon nitride (SiN), or silicon oxynitride (SiON), and may be provided to extend in the thickness direction of the semiconductor substrate 110.

Note that a circuit layer including a pixel circuit that converts the signal charge photoelectrically converted by the photoelectric conversion unit 111 into a pixel signal is provided on a surface (also referred to as a front surface) opposite to a surface (also referred to as a back surface) of the semiconductor substrate 110 on which the intermediate layer 120 is provided. That is, the imaging device 100 according to the present embodiment is a back-illuminated imaging device that receives light incident from the back surface of the semiconductor substrate 110.

The intermediate layer 120 is a functional layer provided on the semiconductor substrate 110 with an insulating material. The intermediate layer 120 is provided on the semiconductor substrate 110 separately for each pixel 12 in a low refraction region 140 to be described later.

The intermediate layer 120 may include a layer having a negative fixed charge. Specifically, the intermediate layer 120 may include a layer constituted by a high dielectric material having a negative fixed charge such as hafnium oxide (HfO₂), zirconium oxide (ZrO₂), aluminum oxide (Al₂O₃), tantalum oxide (Ta₂O₅), titanium oxide (TiO₂), magnesium oxide (MgO), yttrium oxide (Y₂O₃), or an oxide of a lanthanoid. In such a case, since the intermediate layer 120 can form a region in which positive charges are accumulated in the interface region with the semiconductor substrate 110 by negative fixed charges, generation of dark current can be suppressed.

In addition, the intermediate layer 120 may include a layer having an antireflection function. Specifically, the intermediate layer 120 may include a dielectric layer having a refractive index lower than that of the semiconductor substrate 110. In such a case, since the intermediate layer 120 can suppress reflection of light at the interface with the semiconductor substrate 110, it is possible to improve the incident efficiency of light on the photoelectric conversion unit 111.

For example, the intermediate layer 120 may be provided by sequentially stacking aluminum oxide (Al₂O₃), tantalum oxide (Ta₂O₅), and silicon oxide (SiO₂) from the semiconductor substrate 110 side.

The color filter 130 is provided for each pixel 12 on the intermediate layer 120, and selectively transmits light (for example, red light (R), green light (G), and blue light (B)) in a wavelength band corresponding to each pixel 12. The color filter 130 may be provided in a predetermined RGB array such as a Bayer array, for example. The color filter 130 is provided on the semiconductor substrate 110 separately for each pixel 12 in the low refraction region 140 to be described later.

The color filter 130 may be provided, for example, by adding a pigment or dye to a transparent resin that transmits visible light. In addition, the color filter 130 may be a transparent filter constituted by a transparent resin that transmits visible light, an ND filter made by adding carbon black to a transparent resin, or the like.

In the pixel unit 13 of the imaging device 100 according to the present embodiment, the color filter 130 and the intermediate layer 120 are separated for each pixel 12 by the low refraction region 140 extending in the thickness direction of the semiconductor substrate 110.

The low refraction region 140 is a region having a refractive index lower than that of the color filter 130. For example, the low refraction region 140 may be a region having a refractive index of 1.0 or more and 1.35 or less. The low refraction region 140 is provided between the color filters 130 provided for each pixel 12 and between the intermediate layers 120 provided for each pixel 12, so that the color filters 130 and the intermediate layers 120 can function as a waveguide in which a high refractive index material is sandwiched between low refractive index materials. According to this, since the low refraction region 140 can reflect the light traveling to the adjacent pixel 12 at the interface with the color filter 130 and the interface with the intermediate layer 120, the incident efficiency of the light on the photoelectric conversion unit 111 can be improved.

The low refraction region 140 may be constituted by any material as long as the refractive index is lower than that of the color filter 130. For example, the low refraction region 140 may be a gap, and may be constituted by an inorganic material such as silicon oxide (SiO₂), silicon nitride (SiN), or silicon oxynitride (SiON), or a resin material such as a styrene resin, an acrylic resin, a styrene-acrylic copolymer resin, or a siloxane resin. Furthermore, the low refraction region 140 may be constituted by a so-called low-k material such as SiOF, SiOC, or porous silica.

The insulating layer 141 is constituted by an insulating material on the color filter 130. For example, the insulating layer 141 is provided by forming a film of silicon oxide (SiO₂) or the like on the color filter 130. According to this, the insulating layer 141 formed with a high coverage on the color filter 130 separated for each pixel 12 seals the upper end while keeping the gap without burying the low refraction region 140 between the color filters 130, so that the low refraction region 140 can be configured as the gap.

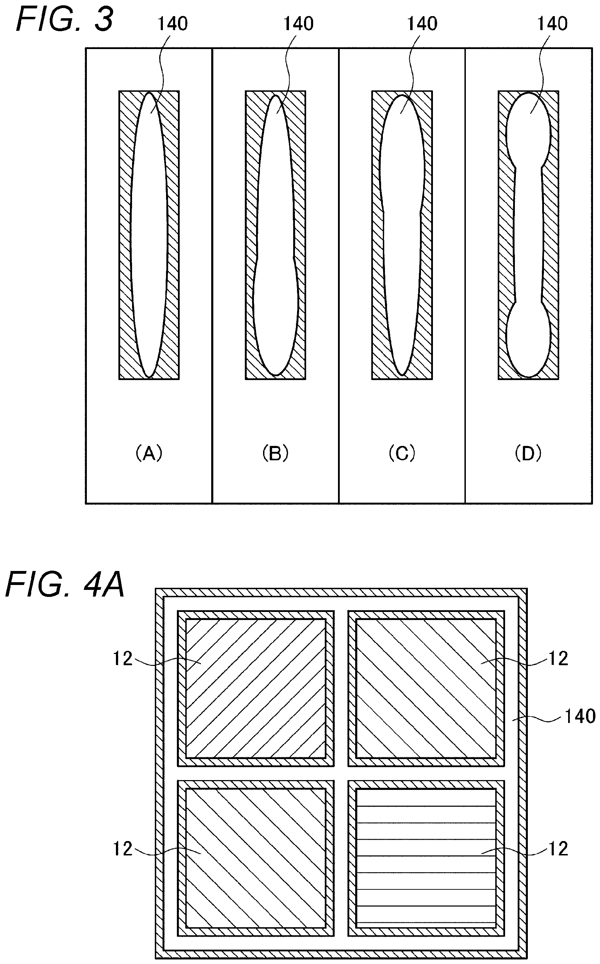

However, at least a part of the inner wall of the low refraction region 140, which is the gap, can be covered with the insulating material that has entered during the formation of the insulating layer 141. Here, the cross-sectional shape of the low refraction region 140 which is a gap will be described with reference to Fig. 3. Fig. 3 is a longitudinal cross-sectional view illustrating a variation of the cross-sectional shape of the gap constituting the low refraction region 140.

As illustrated in Fig. 3, the cross-sectional shape of the gap constituting the low refraction region 140 may change depending on the covering situation of the inner wall of the low refraction region 140 by the insulating material that has entered the inside of the low refraction region 140 at the time of forming the insulating layer 141.

For example, the cross-sectional shape of the gap constituting the low refraction region 140 may be a spindle shape in which the upper end and the lower end are thinner than the central portion as illustrated in (A) of Fig. 3. In addition, the cross-sectional shape of the gap constituting the low refraction region 140 may be a spindle shape in which the upper end is thinner than the central portion and the lower end is thicker than the central portion as illustrated in (B) of Fig. 3. Furthermore, the cross-sectional shape of the gap constituting the low refraction region 140 may be a spindle shape in which the upper end is thicker than the central portion and the lower end is thinner than the central portion as illustrated in (C) of Fig. 3. Furthermore, the cross-sectional shape of the gap constituting the low refraction region 140 may be a dumbbell shape in which the upper end is thicker than the central portion and the lower end is thicker than the central portion as illustrated in (D) of Fig. 3.

The on-chip lens 151 is provided for each pixel 12 on the insulating layer 141. The on-chip lens 151 may be constituted by, for example, a resin material such as a styrene resin, an acrylic resin, a styrene-acrylic copolymer resin, or a siloxane resin. The on-chip lens 151 condenses the light incident on the pixel 12, so that the light incident on the pixel 12 can be efficiently incident on the photoelectric conversion unit 111.

Furthermore, the antireflection film 152 may be formed on the surface layer of the on-chip lens 151. The antireflection film 152 is configured as, for example, a dielectric multilayer film. The antireflection film 152 can suppress reflection of light incident on the on-chip lens 151.

Next, a planar configuration of the pixel unit 13 of the imaging device 100 according to the present embodiment will be described with reference to Figs. 4A to 4C. Figs. 4A to 4C are plan views illustrating examples of planar configurations of the pixel unit 13.

As illustrated in Fig. 4A, the low refraction region 140 may be provided over the entire circumference of the pixel 12 so as to surround each of the pixels 12 provided in the two-dimensional array. In such a case, the low refraction region 140 can more reliably reflect the light transmitted through the color filter 130 and the intermediate layer 120 and traveling to the adjacent pixel 12, so that color mixing with the adjacent pixel 12 can be more reliably suppressed.

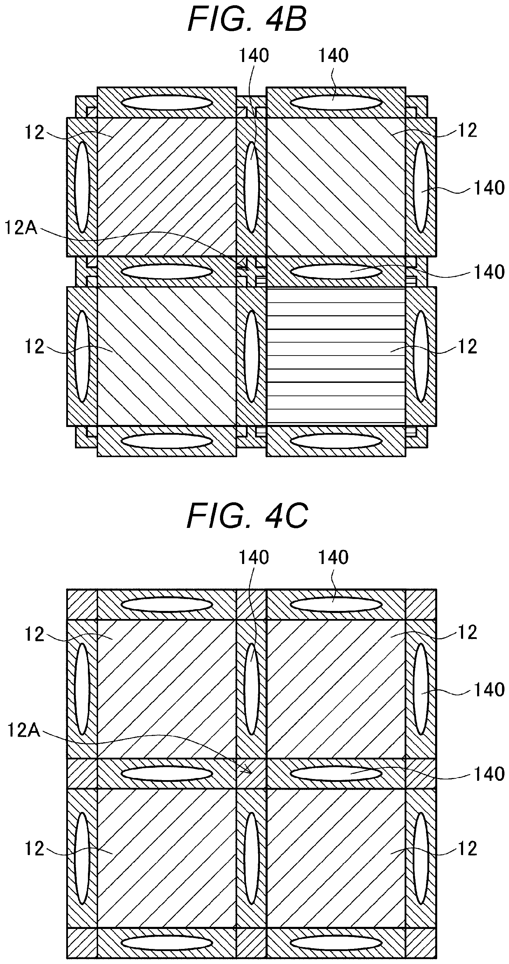

As illustrated in Figs. 4B and 4C, the low refraction region 140 may be provided in a region corresponding to each side of the pixels 12 provided in the two-dimensional array. Even in such a case, the low refraction region 140 can reflect most of the light transmitted through the color filter 130 and the intermediate layer 120 and traveling to the adjacent pixel 12, so that color mixing with the adjacent pixel 12 can be suppressed.

Furthermore, in a case where the low refraction region 140 is provided in a region corresponding to each side of the pixel 12, the interval between the pixels 12 is thicker in the diagonal region 12A of each of the pixels 12 than in the region corresponding to the side of the pixel 12. Therefore, as illustrated in Fig. 4B, each of pixels 12 may be provided so as to protrude in a rectangular shape with respect to the diagonal region 12A, so that the intervals between the pixels 12 may be substantially the same in both the diagonal region 12A and the region corresponding to the side of the pixel 12. According to this, the imaging device 100 can further simplify the process conditions of the manufacturing process of the pixel unit 13.

Furthermore, in a case where the low refraction region 140 is provided in a region corresponding to each side of the pixel 12, as illustrated in Fig. 4C, the diagonal region 12A of each of the pixels 12 may be embedded with an inorganic material having a refractive index lower than that of the color filter 130, such as silicon oxide (SiO₂), silicon nitride (SiN), or silicon oxynitride (SiON), a resin material such as a styrene resin, an acrylic resin, a styrene-acrylic copolymer resin, or a siloxane resin, or a low-k material such as SiOF, SiOC, or porous silica. According to this, in the diagonal region 12A of each of the pixels 12, the light transmitted through the color filter 130 and the intermediate layer 120 and traveling to the adjacent pixel 12 can be reflected by the material having the refractive index lower than that of the color filter 130, so that color mixing with the adjacent pixel 12 can be more reliably suppressed.

### (2.2. Modifications)

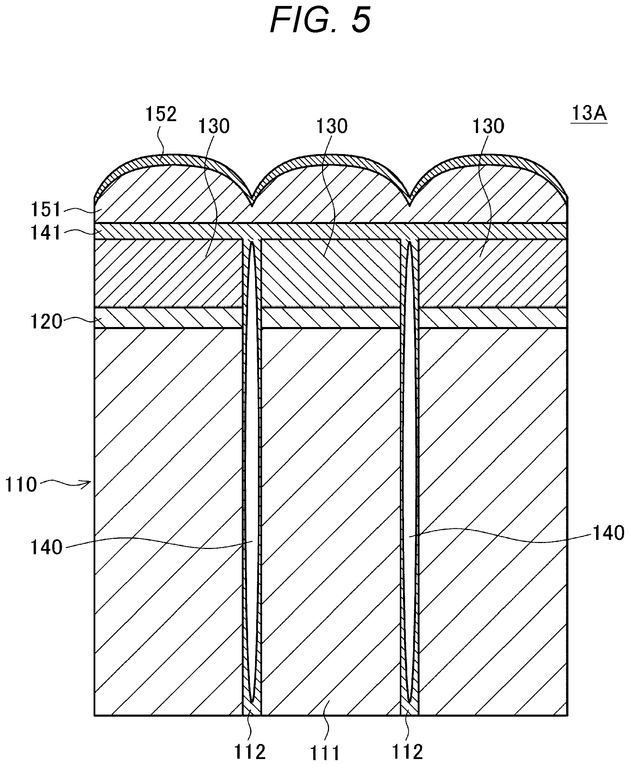

Next, first to 23rd modifications of the pixel unit 13 of the imaging device 100 according to the present embodiment will be described with reference to Figs. 5 to 29C.

### (First Modification)

Fig. 5 is a longitudinal cross-sectional view illustrating a cross-sectional configuration of a pixel unit 13A according to a first modification. As illustrated in Fig. 5, the pixel unit 13A according to the first modification is different from the pixel unit 13 illustrated in Fig. 2 in that the low refraction region 140 is provided to extend from between the color filters 130 and between the intermediate layers 120 to the inside of the pixel separation wall 112.

Specifically, the low refraction region 140 is provided to extend from between the color filters 130 to the inside of the pixel separation wall 112 near the surface of the semiconductor substrate 110. The pixel unit 13A according to the first modification can suppress leakage of light between the photoelectric conversion units 111 of the adjacent pixels 12 in the low refraction region 140. Therefore, the pixel unit 13A according to the first modification can further suppress color mixing between the adjacent pixels 12.

### (Second Modification)

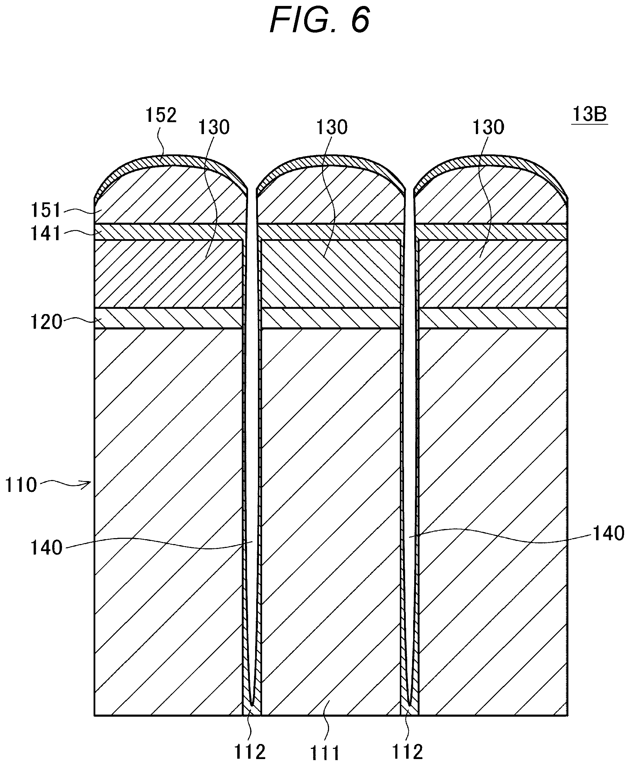

Fig. 6 is a longitudinal cross-sectional view illustrating a cross-sectional configuration of a pixel unit 13B according to a second modification. As illustrated in Fig. 6, the pixel unit 13B according to the second modification is different from the pixel unit 13A illustrated in Fig. 5 in that the low refraction region 140 is provided to extend from between the color filters 130 and between the intermediate layers 120 to the on-chip lens 151 side.

Specifically, the low refraction region 140 is provided so as to extend from between the color filters 130 to the inside of the pixel separation wall 112 near the surface of the semiconductor substrate 110 and to extend to the on-chip lens 151 side to separate the on-chip lens 151 for each pixel 12. The pixel unit 13B according to the second modification can suppress leakage of light between the photoelectric conversion units 111 of the adjacent pixels 12 in the low refraction region 140. Furthermore, the pixel unit 13B according to the second modification can suppress leakage of light between the on-chip lenses 151 of the adjacent pixels 12 in the low refraction region 140. Therefore, the pixel unit 13B according to the second modification can further suppress color mixing between the adjacent pixels 12.

### (Third Modification)

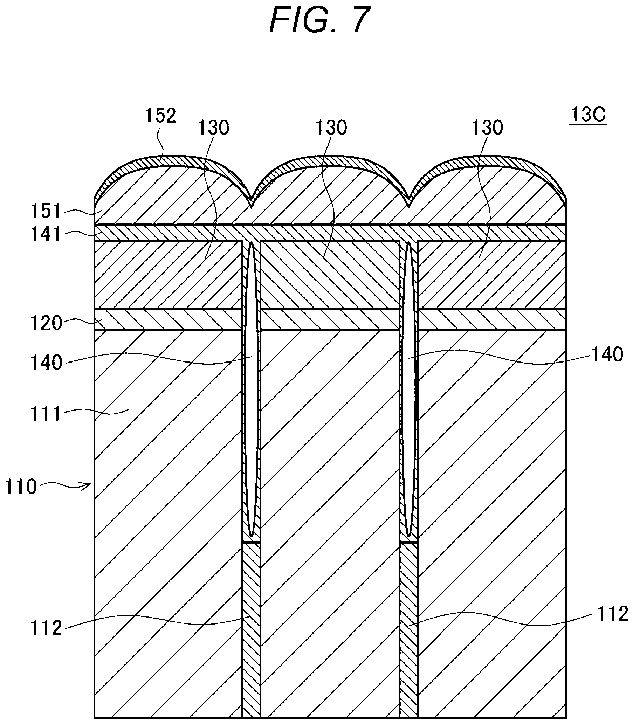

Fig. 7 is a longitudinal cross-sectional view illustrating a cross-sectional configuration of a pixel unit 13C according to a third modification. As illustrated in Fig. 7, the pixel unit 13C according to the third modification is different from the pixel unit 13 illustrated in Fig. 2 in that the low refraction region 140 is provided to extend from between the color filters 130 and between the intermediate layers 120 to the inside of the pixel separation wall 112.

Specifically, the low refraction region 140 is provided to extend from between the color filters 130 to the inside of the pixel separation wall 112 in the middle of the semiconductor substrate 110. The pixel unit 13C according to the third modification can suppress leakage of light between the photoelectric conversion units 111 of the adjacent pixels 12 in the low refraction region 140. Therefore, the pixel unit 13C according to the third modification can further suppress color mixing between the adjacent pixels 12.

### (Fourth Modification)

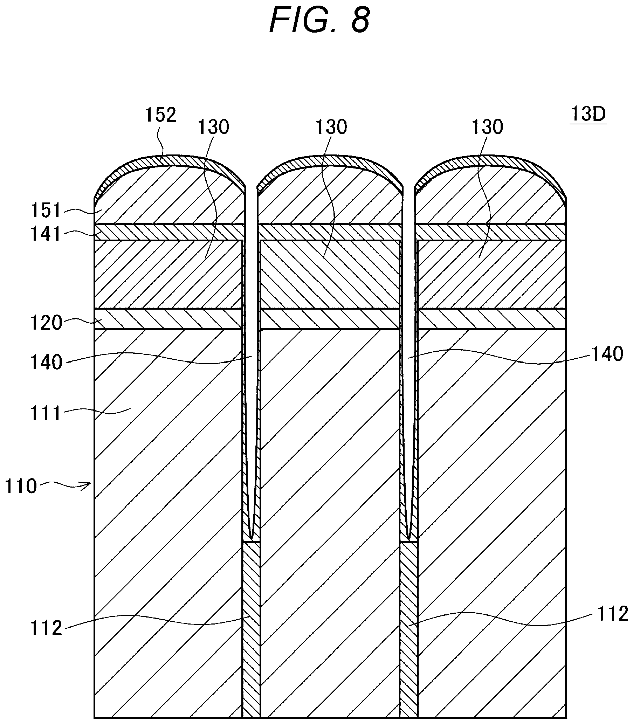

Fig. 8 is a longitudinal cross-sectional view illustrating a cross-sectional configuration of a pixel unit 13D according to a fourth modification. As illustrated in Fig. 8, the pixel unit 13D according to the fourth modification is different from the pixel unit 13C illustrated in Fig. 7 in that the low refraction region 140 is provided to extend from between the color filters 130 and between the intermediate layers 120 to the on-chip lens 151 side.

Specifically, the low refraction region 140 extends from between the color filters 130 to the inside of the pixel separation wall 112 in the middle of the semiconductor substrate 110 and extends to the on-chip lens 151 side, and is provided to separate the on-chip lens 151 for each pixel 12. The pixel unit 13D according to the fourth modification can suppress leakage of light between the photoelectric conversion units 111 of the adjacent pixels 12 in the low refraction region 140. Furthermore, the pixel unit 13D according to the fourth modification can suppress leakage of light between the on-chip lenses 151 of the adjacent pixels 12 in the low refraction region 140. Therefore, the pixel unit 13D according to the fourth modification can further suppress color mixing between the adjacent pixels 12.

### (Fifth Modification)

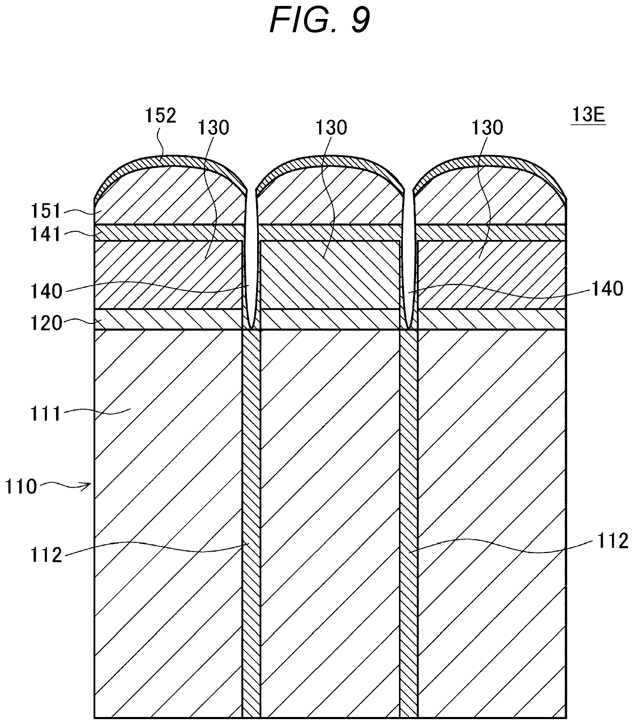

Fig. 9 is a longitudinal cross-sectional view illustrating a cross-sectional configuration of a pixel unit 13E according to a fifth modification. As illustrated in Fig. 9, the pixel unit 13E according to the fifth modification is different from the pixel unit 13 illustrated in Fig. 2 in that the low refraction region 140 is provided to extend from between the color filters 130 and between the intermediate layers 120 to the on-chip lens 151 side.

Specifically, the low refraction region 140 is provided so as to extend to the on-chip lens 151 side and separate the on-chip lens 151 for each pixel 12. The pixel unit 13E according to the fifth modification can suppress leakage of light between the on-chip lenses 151 of the adjacent pixels 12 in the low refraction region 140. Therefore, the pixel unit 13E according to the fifth modification can further suppress color mixing between the adjacent pixels 12.

### (Sixth Modification)

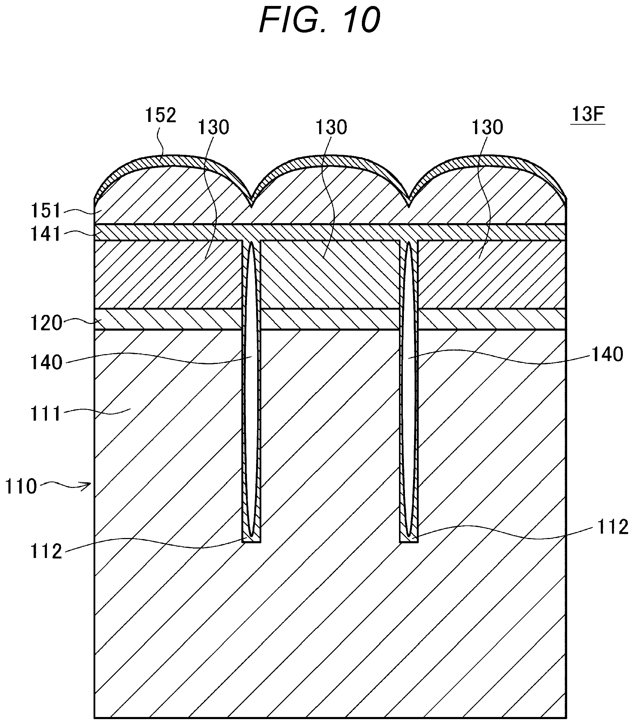

Fig. 10 is a longitudinal cross-sectional view illustrating a cross-sectional configuration of a pixel unit 13F according to a sixth modification. As illustrated in Fig. 10, the pixel unit 13F according to the sixth modification is different from the pixel unit 13 illustrated in Fig. 2 in that the low refraction region 140 is provided to extend from between the color filters 130 and between the intermediate layers 120 to the inside of the pixel separation wall 112.

Specifically, the pixel separation wall 112 is provided to extend to the middle of the semiconductor substrate 110 in the thickness direction of the semiconductor substrate 110. Furthermore, the low refraction region 140 is provided to extend from between the color filters 130 to the inside of the pixel separation wall 112 in the middle of the semiconductor substrate 110. The pixel unit 13F according to the sixth modification can suppress leakage of light between the photoelectric conversion units 111 of the adjacent pixels 12 in the low refraction region 140. Therefore, the pixel unit 13F according to the seventh modification can further suppress color mixing between the adjacent pixels 12.

### (Seventh Modification)

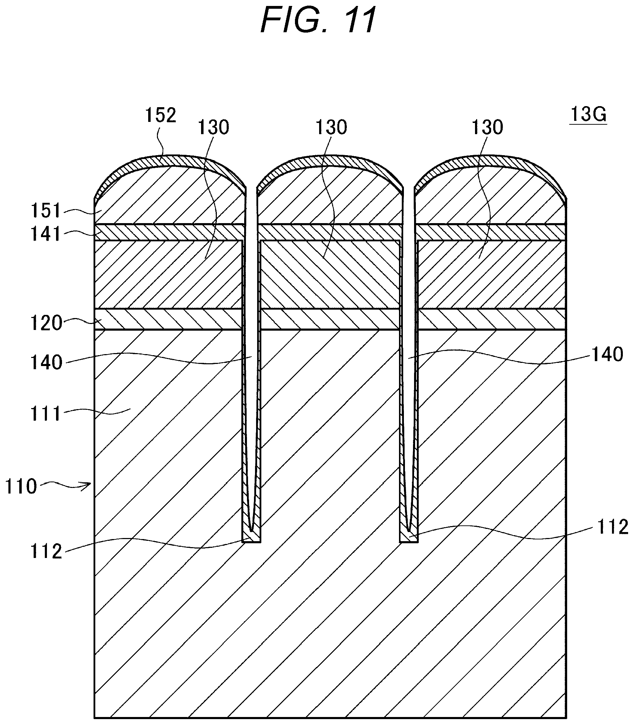

Fig. 11 is a longitudinal cross-sectional view illustrating a cross-sectional configuration of a pixel unit 13G according to a seventh modification. As illustrated in Fig. 11, the pixel unit 13G according to the seventh modification is different from the pixel unit 13F illustrated in Fig. 10 in that the low refraction region 140 is provided to extend from between the color filters 130 and between the intermediate layers 120 to the on-chip lens 151 side.

Specifically, the low refraction region 140 is provided to extend from between the color filters 130 to the inside of the pixel separation wall 112 in the middle of the semiconductor substrate 110, and is provided to extend to the on-chip lens 151 side to separate the on-chip lens 151 for each pixel 12. The pixel unit 13G according to the seventh modification can suppress leakage of light between the photoelectric conversion units 111 of the adjacent pixels 12 in the low refraction region 140. Furthermore, the pixel unit 13G according to the seventh modification can suppress leakage of light between the on-chip lenses 151 of the adjacent pixels 12 in the low refraction region 140. Therefore, the pixel unit 13G according to the seventh modification can further suppress color mixing between the adjacent pixels 12.

### (Eighth Modification)

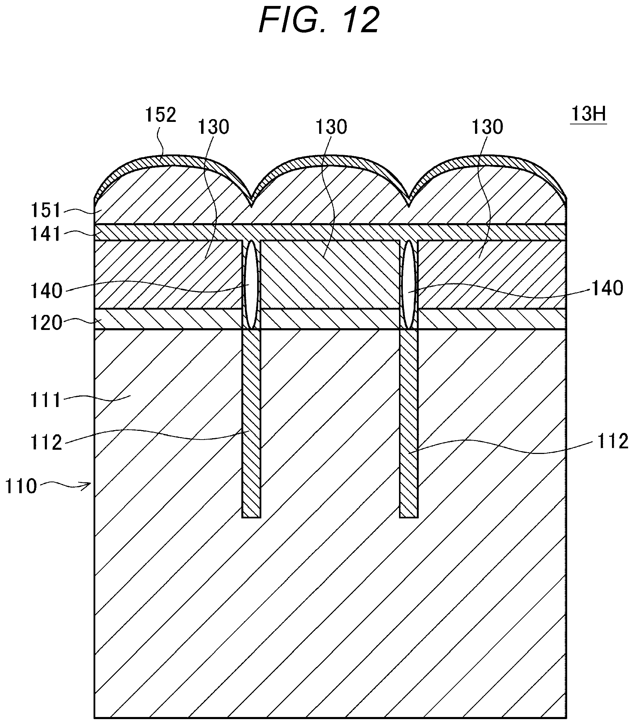

Fig. 12 is a longitudinal cross-sectional view illustrating a cross-sectional configuration of a pixel unit 13H according to an eighth modification. As illustrated in Fig. 12, the pixel unit 13H according to the eighth modification is different from the pixel unit 13 illustrated in Fig. 2 in that the pixel separation wall 112 is provided to extend to the middle of the semiconductor substrate 110 in the thickness direction of the semiconductor substrate 110.

Even in the pixel unit 13H according to the eighth modification, the pixel separation wall 112 can electrically separate the photoelectric conversion units 111 of the adjacent pixels 12. Therefore, even in the pixel unit 13H according to the eighth modification, color mixing between the adjacent pixels 12 can be suppressed, similarly to the pixel unit 13 illustrated in Fig. 2.

### (Ninth Modification)

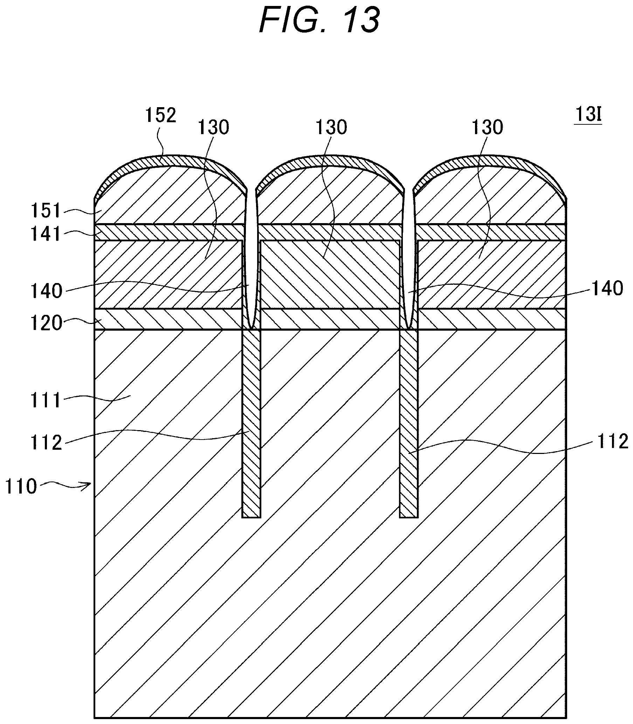

Fig. 13 is a longitudinal cross-sectional view illustrating a cross-sectional configuration of a pixel unit 131 according to a ninth modification. As illustrated in Fig. 13, the pixel unit 131 according to the ninth modification is different from the pixel unit 13H illustrated in Fig. 12 in that the low refraction region 140 is provided to extend from between the color filters 130 and between the intermediate layers 120 to the on-chip lens 151 side.

Specifically, the low refraction region 140 is provided so as to extend to the on-chip lens 151 side and separate the on-chip lens 151 for each pixel 12. The pixel unit 131 according to the ninth modification can suppress leakage of light between the on-chip lenses 151 of the adjacent pixels 12 in the low refraction region 140. Therefore, the pixel unit 131 according to the ninth modification can further suppress color mixing between the adjacent pixels 12.

### (10th Modification)

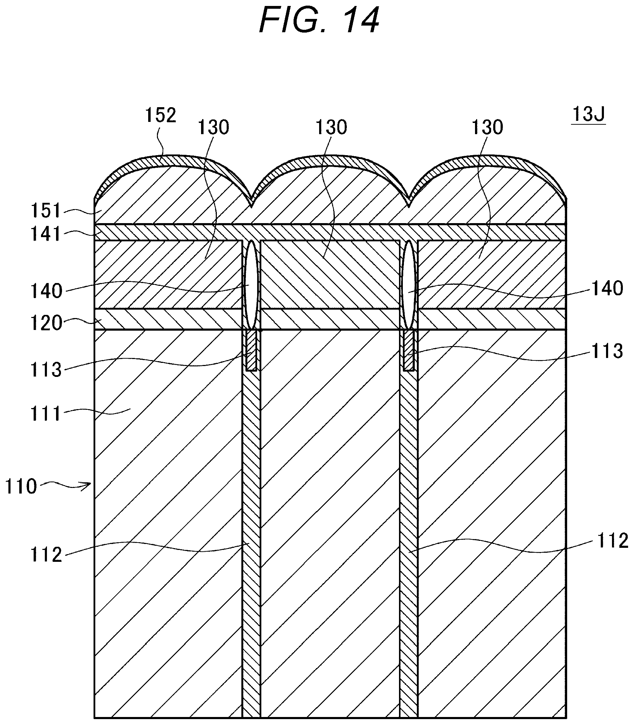

Fig. 14 is a longitudinal cross-sectional view illustrating a cross-sectional configuration of a pixel unit 13J according to a 10th modification. As illustrated in Fig. 14, the pixel unit 13J according to the 10th modification is different from the pixel unit 13 illustrated in Fig. 2 in that a light shielding unit 113 is provided inside the pixel separation wall 112.

The light shielding unit 113 is provided so as to be embedded inside the pixel separation wall 112 on the intermediate layer 120 side. For example, the light shielding unit 113 may be constituted by a conductive material such as tungsten (W), aluminum (Al), copper (Cu), titanium nitride (TiN), or polysilicon (poly-Si) capable of shielding light. Alternatively, the light shielding unit 113 may be constituted by an organic resin material containing a carbon black pigment or a titanium black pigment. The light shielding unit 113 shields light leaking into the adjacent pixels 12 by the photoelectric conversion unit 111 in the vicinity of the intermediate layer 120, so that color mixing between the adjacent pixels 12 can be further suppressed. According to this, the pixel unit 13J according to the 10th modification can further suppress color mixing between the adjacent pixels 12.

### (11th Modification)

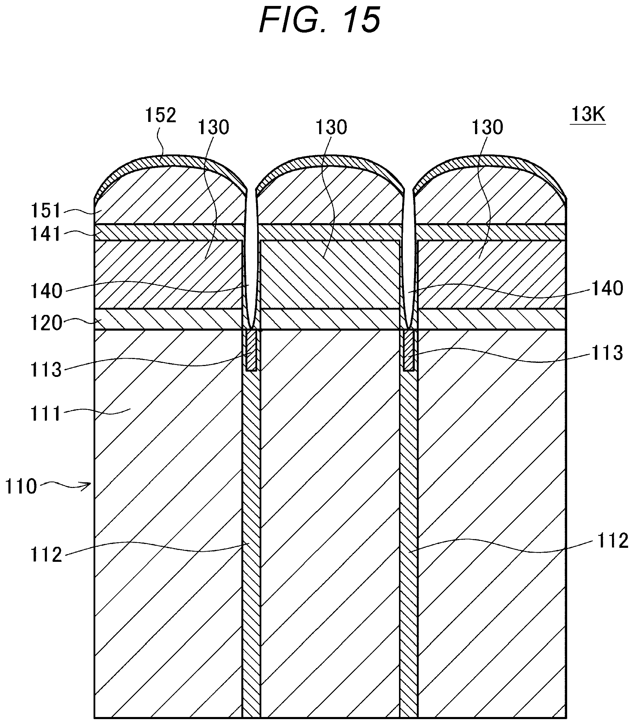

Fig. 15 is a longitudinal cross-sectional view illustrating a cross-sectional configuration of a pixel unit 13K according to an 11th modification. As illustrated in Fig. 15, the pixel unit 13K according to the 11th modification is different from the pixel unit 13J illustrated in Fig. 14 in that the low refraction region 140 is provided to extend from between the color filters 130 and between the intermediate layers 120 to the on-chip lens 151 side.

Specifically, the low refraction region 140 is provided so as to extend to the on-chip lens 151 side and separate the on-chip lens 151 for each pixel 12. The pixel unit 13K according to the 11th modification can suppress leakage of light between the on-chip lenses 151 of the adjacent pixels 12 in the low refraction region 140. Therefore, the pixel unit 13K according to the 11th modification can further suppress color mixing between the adjacent pixels 12.

### (12th Modification)

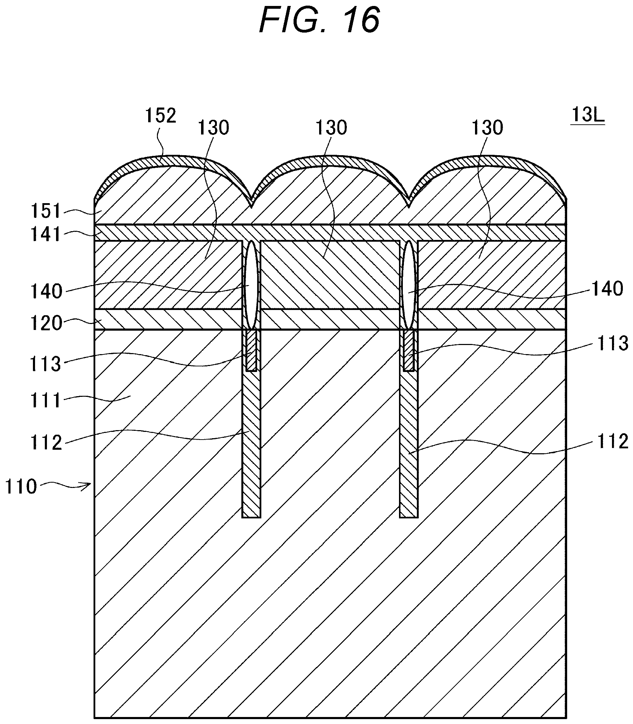

Fig. 16 is a longitudinal cross-sectional view illustrating a cross-sectional configuration of a pixel unit 13L according to a 12th modification. As illustrated in Fig. 16, the pixel unit 13L according to the 12th modification is different from the pixel unit 13J illustrated in Fig. 14 in that the pixel separation wall 112 is provided to extend to the middle of the semiconductor substrate 110 in the thickness direction of the semiconductor substrate 110.

Even in the pixel unit 13L according to the 12th modification, the pixel separation wall 112 can electrically separate the photoelectric conversion units 111 of the adjacent pixels 12. Therefore, even in the pixel unit 13L according to the 12th modification, color mixing between the adjacent pixels 12 can be suppressed, similarly to the pixel unit 13J illustrated in Fig. 14.

### (13th Modification)

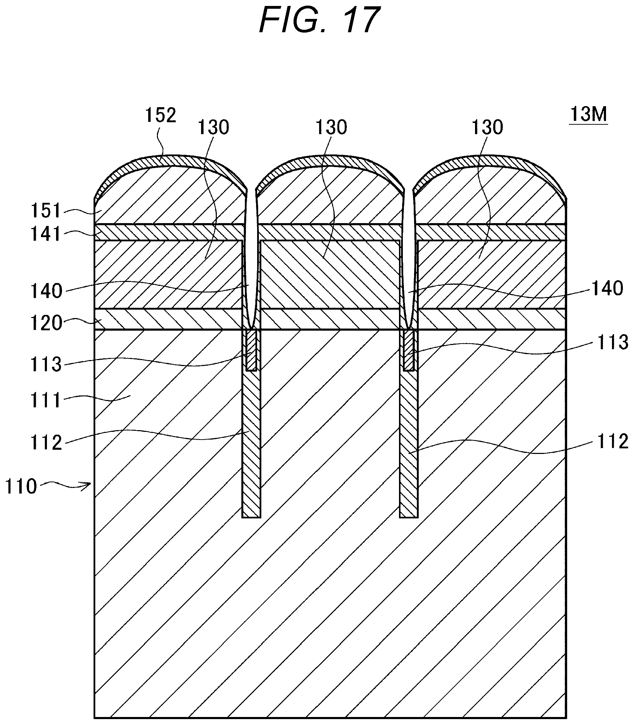

Fig. 17 is a longitudinal cross-sectional view illustrating a cross-sectional configuration of a pixel unit 13M according to a 13th modification. As illustrated in Fig. 17, the pixel unit 13M according to the 13th modification is different from the pixel unit 13L illustrated in Fig. 16 in that the low refraction region 140 is provided to extend from between the color filters 130 and between the intermediate layers 120 to the on-chip lens 151 side.

Specifically, the low refraction region 140 is provided so as to extend to the on-chip lens 151 side and separate the on-chip lens 151 for each pixel 12. The pixel unit 13M according to the 13th modification can suppress leakage of light between the on-chip lenses 151 of the adjacent pixels 12 in the low refraction region 140. Therefore, the pixel unit 13M according to the 13th modification can further suppress color mixing between the adjacent pixels 12.

### (14th Modification)

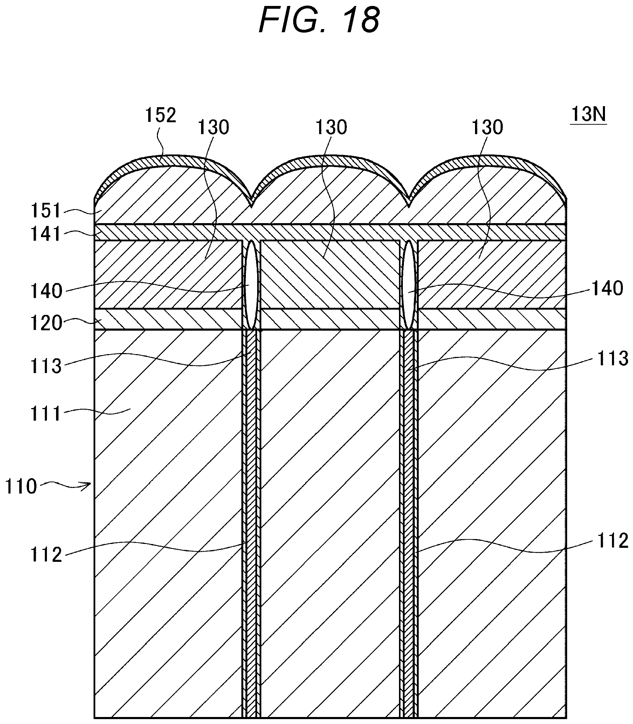

Fig. 18 is a longitudinal cross-sectional view illustrating a cross-sectional configuration of a pixel unit 13N according to a 14th modification. As illustrated in Fig. 18, the pixel unit 13N according to the 14th modification is different from the pixel unit 13J illustrated in Fig. 14 in that the light shielding unit 113 is provided so as to extend inside the pixel separation wall 112 and penetrate the semiconductor substrate 110.

Since the pixel unit 13N according to the 14th modification can shield light leaking into the photoelectric conversion units 111 of the adjacent pixels 12 by the light shielding unit 113 over the entire pixel separation wall 112, color mixing between the adjacent pixels 12 can be further suppressed.

### (15th Modification)

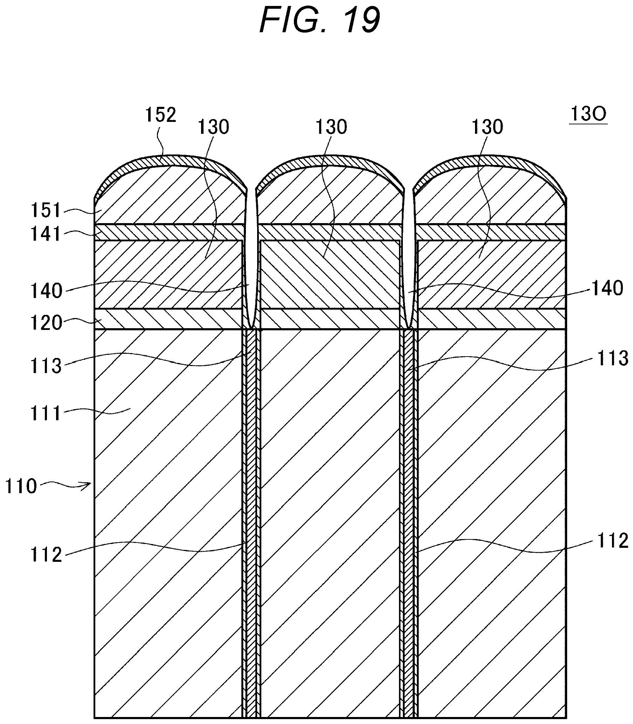

Fig. 19 is a longitudinal cross-sectional view illustrating a cross-sectional configuration of a pixel unit 13O according to a 15th modification. As illustrated in Fig. 19, the pixel unit 13O according to the 15th modification is different from the pixel unit 13N illustrated in Fig. 18 in that the low refraction region 140 is provided to extend from between the color filters 130 and between the intermediate layers 120 to the on-chip lens 151 side.

Specifically, the low refraction region 140 is provided so as to extend to the on-chip lens 151 side and separate the on-chip lens 151 for each pixel 12. In the pixel unit 13O according to the 15th modification, leakage of light between the on-chip lenses 151 of the adjacent pixels 12 can be suppressed in the low refraction region 140. Therefore, the pixel unit 13O according to the 15th modification can further suppress color mixing between the adjacent pixels 12.

### (16th Modification)

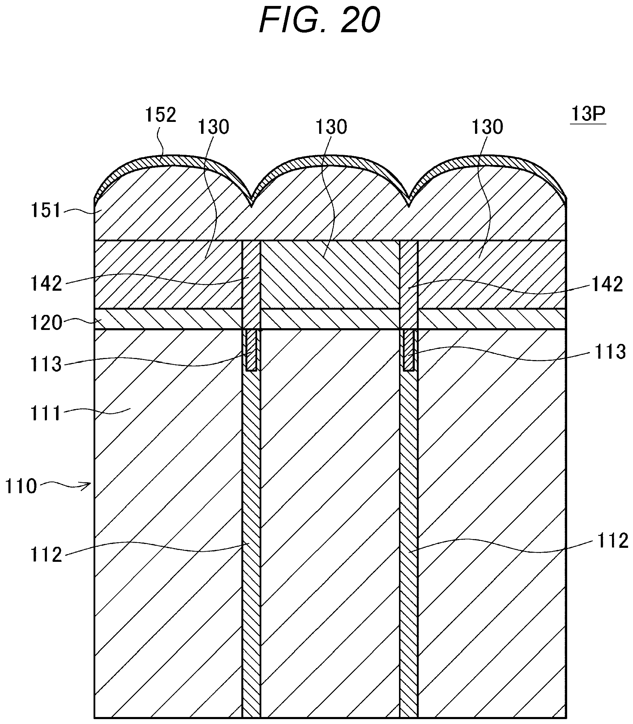

Fig. 20 is a longitudinal cross-sectional view illustrating a cross-sectional configuration of a pixel unit 13P according to a 16th modification. As illustrated in Fig. 20, the pixel unit 13P according to the 16th modification is different from the pixel unit 13J illustrated in Fig. 14 in that the low refraction region 140 is provided as a low refraction layer 142 instead of a gap.

The low refraction layer 142 is constituted by a material having a refractive index lower than that of the color filter 130, and is provided between the color filters 130 provided for the respective pixels 12 and between the intermediate layers 120 provided for the respective pixels 12. The material having a refractive index lower than that of the color filter 130 is, for example, an inorganic material such as silicon oxide (SiO₂), silicon nitride (SiN), or silicon oxynitride (SiON), a resin material such as a styrene resin, an acrylic resin, a styrene-acrylic copolymer resin, or a siloxane resin, or a low-k material such as SiOF, SiOC, or porous silica. The low refraction layer 142 can cause the color filter 130 and the intermediate layer 120 to function as a waveguide in which a high refractive index material is sandwiched between low refractive index materials.

According to this, the pixel unit 13P according to the 16th modification can reflect light traveling to the adjacent pixel 12 at the interface between the low refraction layer 142 and the color filter 130 and the interface between the low refraction layer 142 and the intermediate layer 120. Therefore, even in the pixel unit 13P according to the 16th modification, color mixing between the adjacent pixels 12 can be suppressed, similarly to the pixel unit 13J illustrated in Fig. 14.

### (17th Modification)

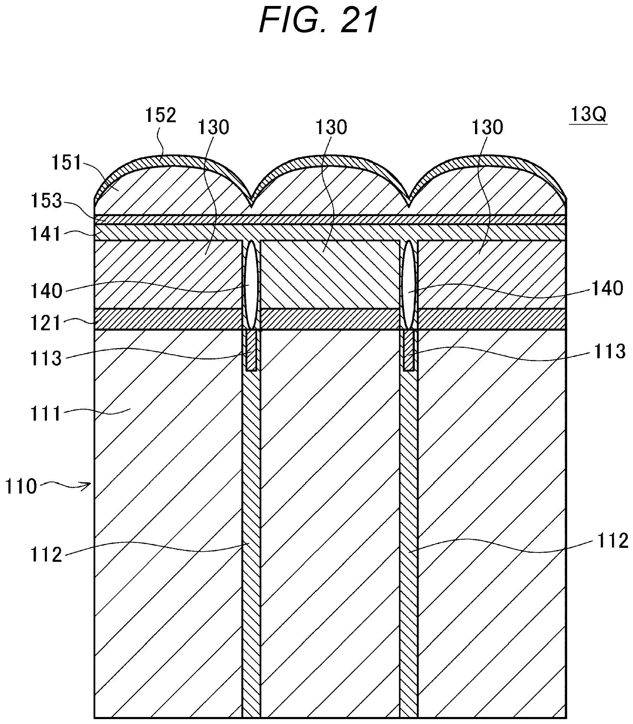

Fig. 21 is a longitudinal cross-sectional view illustrating a cross-sectional configuration of a pixel unit 13Q according to a 17th modification. As illustrated in Fig. 21, the pixel unit 13Q according to the 17th modification is different from the pixel unit 13J illustrated in Fig. 14 in that an antireflection layer 153 is provided between the insulating layer 141 and the on-chip lens 151, and an antireflection intermediate layer 121 is provided instead of the intermediate layer 120.

The antireflection intermediate layer 121 and the antireflection layer 153 include, for example, a dielectric multilayer film. The antireflection intermediate layer 121 and the antireflection layer 153 suppress reflection of incident light at an interface between layers existing from the on-chip lens 151 to the semiconductor substrate 110, so that it is possible to improve light incident efficiency on the photoelectric conversion unit 111.

Note that the antireflection intermediate layer 121 and the antireflection layer 153 may be provided in a configuration other than the dielectric multilayer film as long as they have an antireflection function. For example, the antireflection intermediate layer 121 and the antireflection layer 153 may be provided as layers having a motheye structure.

According to this, the pixel unit 13Q according to the 17th modification can further improve the incident efficiency of light on the photoelectric conversion unit 111 by further suppressing reflection of incident light.

### (18th Modification)

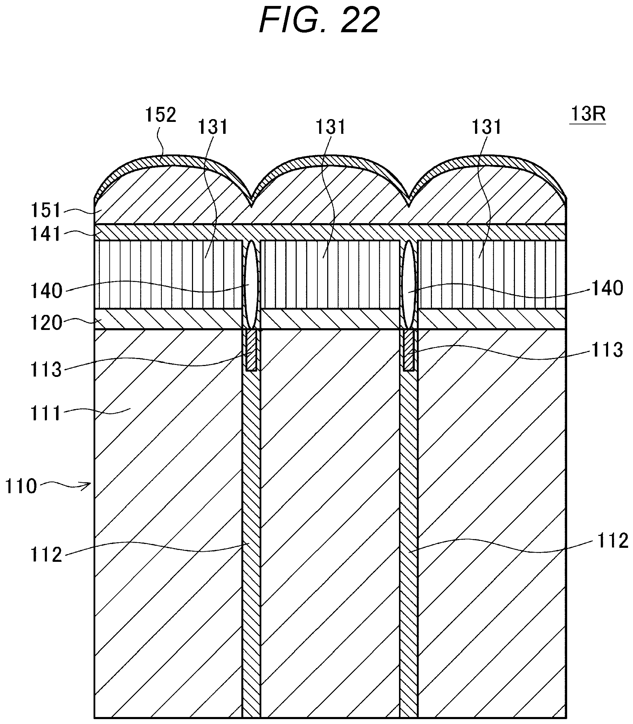

Fig. 22 is a longitudinal cross-sectional view illustrating a cross-sectional configuration of a pixel unit 13R according to an 18th modification. As illustrated in Fig. 22, the pixel unit 13R according to the 18th modification is different from the pixel unit 13J illustrated in Fig. 14 in that an inorganic color filter 131 is provided instead of the color filter 130.

The inorganic color filter 131 is a filter that selectively transmits light (for example, red light, green light, and blue light) in a predetermined wavelength band by a structure of a dielectric laminated film, a photonic crystal, a quantum dot, a metamaterial, or the like, instead of a pigment or a dye. The inorganic color filter 131 is less likely to be discolored by ultraviolet rays, heat, or the like than a pigment or a dye. Therefore, the pixel unit 13R according to the 18th modification can suppress color mixing between adjacent pixels 12, similarly to the pixel unit 13J illustrated in Fig. 14, even under a more severe environment.

### (19th Modification)

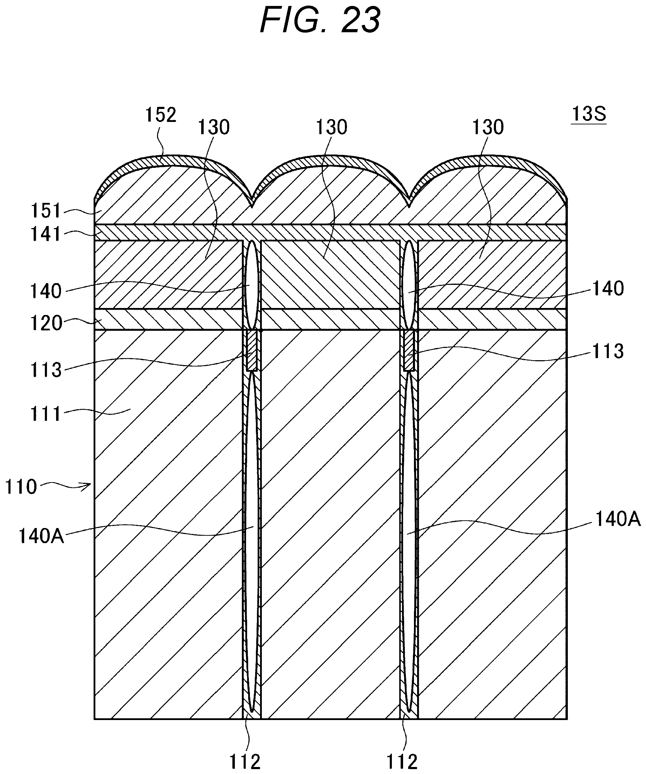

Fig. 23 is a longitudinal cross-sectional view illustrating a cross-sectional configuration of a pixel unit 13S according to a 19th modification. As illustrated in Fig. 23, the pixel unit 13S according to the 19th modification is different from the pixel unit 13J illustrated in Fig. 14 in that a low refraction region 140A is further provided in a portion where the light shielding unit 113 is not provided in the pixel separation wall 112.

The low refraction region 140A is a region having a refractive index lower than that of the pixel separation wall 112. The low refraction region 140A can reflect light leaking into the photoelectric conversion unit 111 of the adjacent pixel 12 by being provided to extend inside the pixel separation wall 112 in a portion where the light shielding unit 113 is not provided. Similarly to the low refraction region 140, the low refraction region 140A may be a gap, and may be constituted by an inorganic material such as silicon oxide (SiO₂), silicon nitride (SiN), or silicon oxynitride (SiON), a resin material such as a styrene resin, an acrylic resin, a styrene-acrylic copolymer resin, or a siloxane resin, or a low-k material such as SiOF, SiOC, or porous silica.

According to this, since the pixel unit 13S according to the 19th modification can shield or reflect light leaking into the photoelectric conversion unit 111 of the adjacent pixel 12 over the entire pixel separation wall 112, color mixing between the adjacent pixels 12 can be further suppressed.

### (20th Modification)

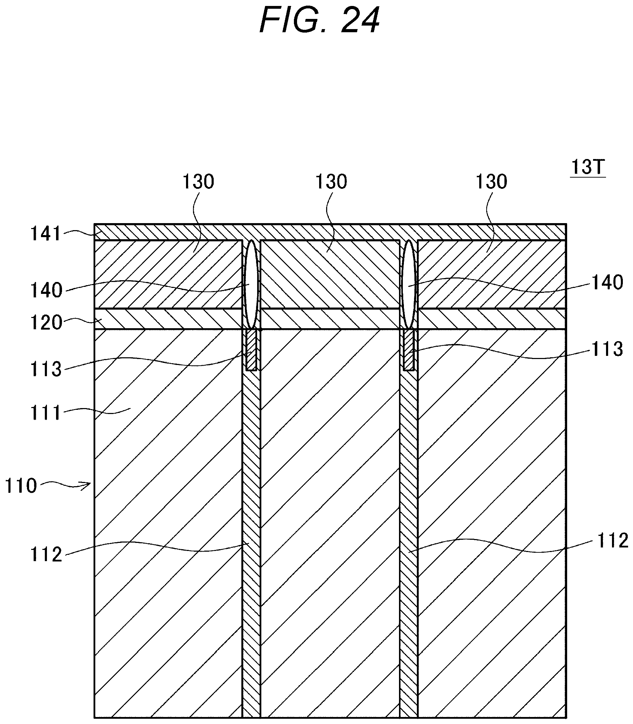

Fig. 24 is a longitudinal cross-sectional view illustrating a cross-sectional configuration of a pixel unit 13T according to a 20th modification. As illustrated in Fig. 24, the pixel unit 13T according to the 20th modification is different from the pixel unit 13J illustrated in Fig. 14 in that the on-chip lens 151 is not provided.

Even in the pixel unit 13T according to the 20th modification, color mixing between the adjacent pixels 12 can be suppressed, similarly to the pixel unit 13J illustrated in Fig. 14.

### (21st Modification)

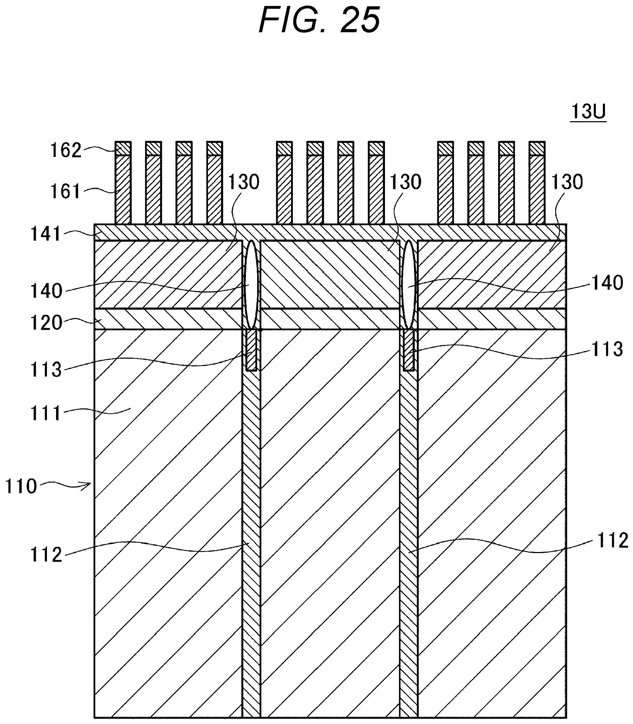

Fig. 25 is a longitudinal cross-sectional view illustrating a cross-sectional configuration of a pixel unit 13U according to a 21st modification. As illustrated in Fig. 25, the pixel unit 13U according to the 21st modification is different from the pixel unit 13J illustrated in Fig. 14 in that a phase difference lens 161 is provided instead of the on-chip lens 151.

The phase difference lens 161 is a lens that exhibits a light condensing function by using a phase difference of incident light due to a metamaterial structure. Note that an antireflection layer 162 may be provided on the light incident surface of the phase difference lens 161.

In the pixel unit 13U according to the 21st modification, even in a case where the phase difference lens 161 is used instead of the on-chip lens 151 that is a hemispherical convex lens, incident light can be condensed for each pixel 12. Therefore, even in the pixel unit 13T according to the 21st modification, color mixing between the adjacent pixels 12 can be suppressed, similarly to the pixel unit 13J illustrated in Fig. 14.

### (22nd Modification)

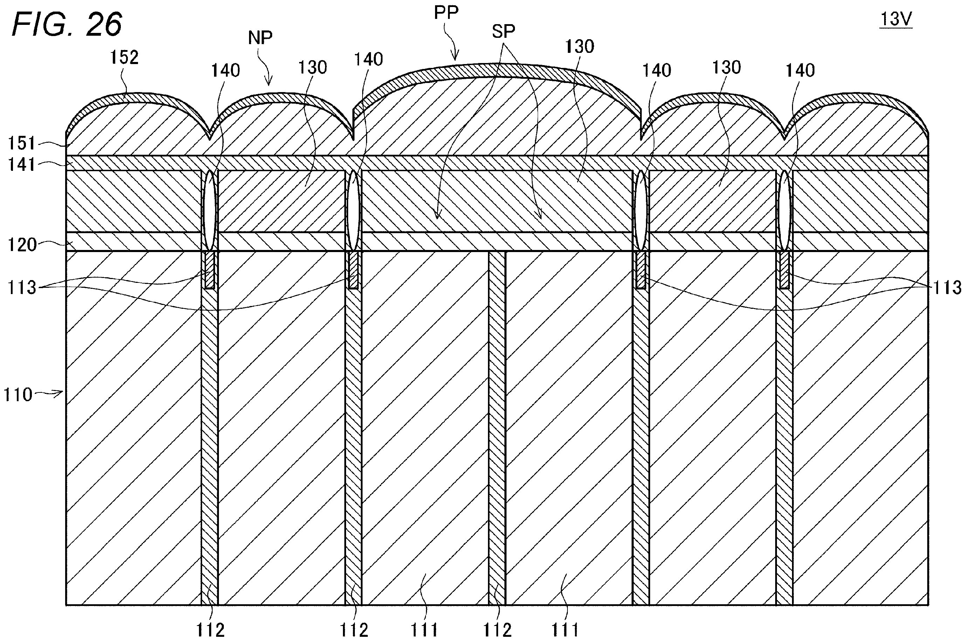

Fig. 26 is a longitudinal cross-sectional view illustrating a cross-sectional configuration of a pixel unit 13V according to a 22nd modification. As illustrated in Fig. 26, the pixel unit 13V according to the 22nd modification is different from the pixel unit 13J illustrated in Fig. 14 in that a normal pixel NP and a phase difference pixel PP are mixed.

The phase difference pixel PP includes a plurality of subpixels SP and one on-chip lens 151 provided on the plurality of subpixels SP. The phase difference pixel PP can detect the distance to the subject on the basis of the pixel signal obtained in each of the plurality of subpixels SP. The low refraction region 140 is not provided between the subpixels SP, but is provided between the phase difference pixel PP and the normal pixel NP. Even in a case where the pixel unit 13V according to the 22nd modification includes the normal pixel NP and the phase difference pixel PP, it is possible to suppress color mixing between the phase difference pixel PP and the normal pixel NP or between the normal pixels NP similarly to the pixel unit 13J illustrated in Fig. 14.

Furthermore, in the pixel unit 13V according to the 22nd modification, the on-chip lens 151 provided in the phase difference pixel PP is provided so as to be higher in height than the on-chip lens 151 provided in the normal pixel NP. According to this, the on-chip lens 151 provided in the phase difference pixel PP can control the focal position on the side of the on-chip lens 151 so that the separation ratio in the subpixel SP is improved. Therefore, the pixel unit 13V according to the 22nd modification can improve the phase difference amount of the phase difference pixel PP.

### (23rd Modification)

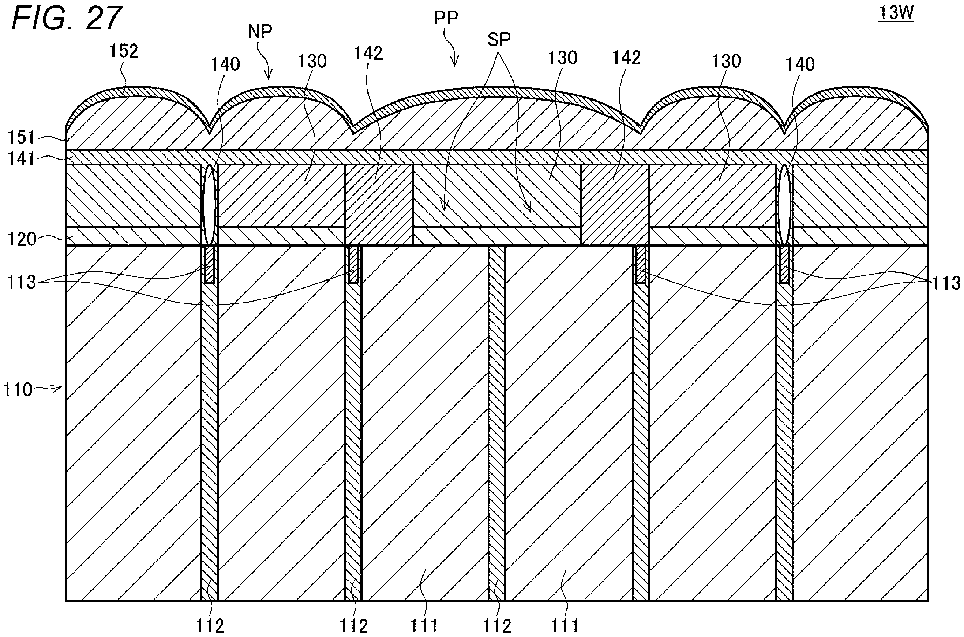

Fig. 27 is a longitudinal cross-sectional view illustrating a cross-sectional configuration of a pixel unit 13W according to a 23rd modification. As illustrated in Fig. 27, the pixel unit 13W according to the 23rd modification is different from the pixel unit 13J illustrated in Fig. 14 in that the normal pixel NP and the phase difference pixel PP are mixed. Since the normal pixel NP and the phase difference pixel PP have been described in the pixel unit 13V according to the 22nd modification, the description thereof is omitted here.

In the pixel unit 13W according to the 23rd modification, the low refraction layer 142 having a width larger than that of the low refraction region 140 provided between the normal pixels NP is provided between the phase difference pixel PP and the normal pixel NP. According to this, the phase difference pixel PP can control the focus on the side of the on-chip lens 151 such that the separation ratio in the subpixel SP is improved by the waveguide effect by the low refraction layer 142. Therefore, the pixel unit 13W according to the 23rd modification can improve the phase difference amount of the phase difference pixel PP.

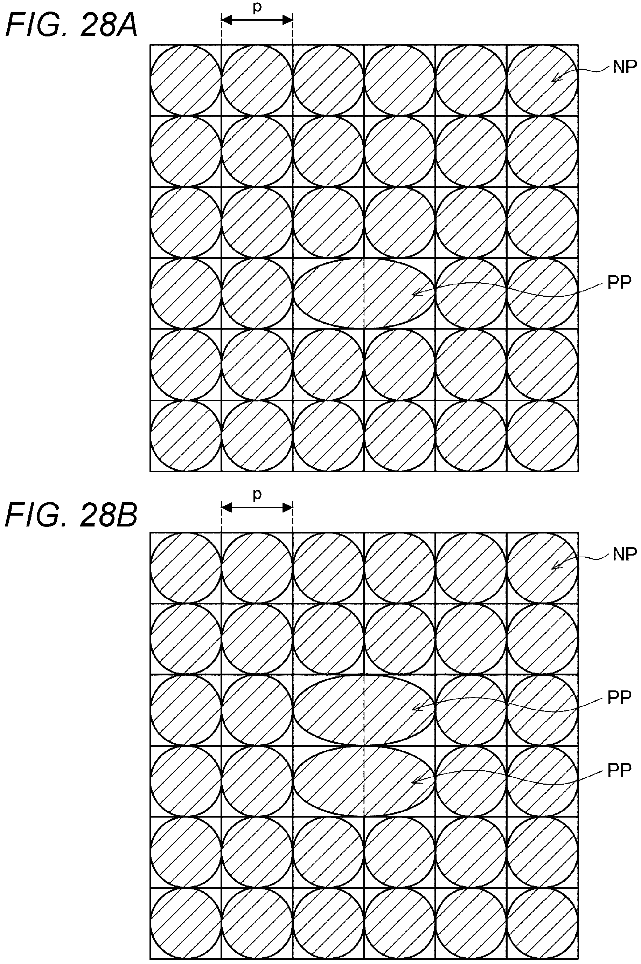

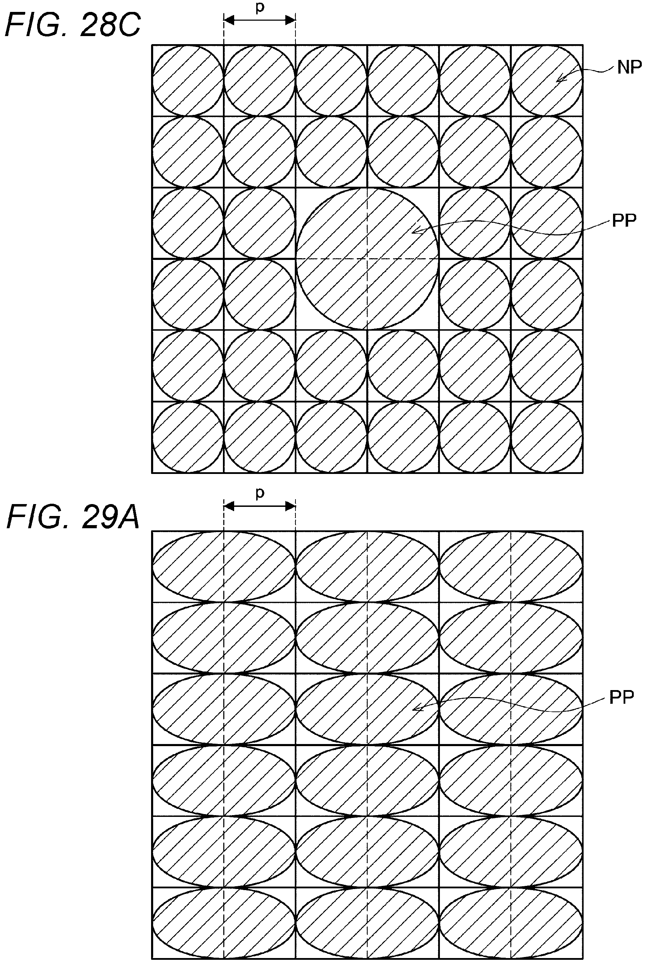

Here, planar arrangement examples of the phase difference pixels PP in the pixel unit 13V according to the 22nd modification and the pixel unit 13W according to the 23rd modification will be described with reference to Figs. 28A to 29C. Figs. 28A to 28C are plan views illustrating examples of planar arrangements in a case where the phase difference pixel PP and the normal pixel NP are mixed. Figs. 29A to 29C are plan views illustrating examples of planar arrangements in a case of only the phase difference pixels PP.

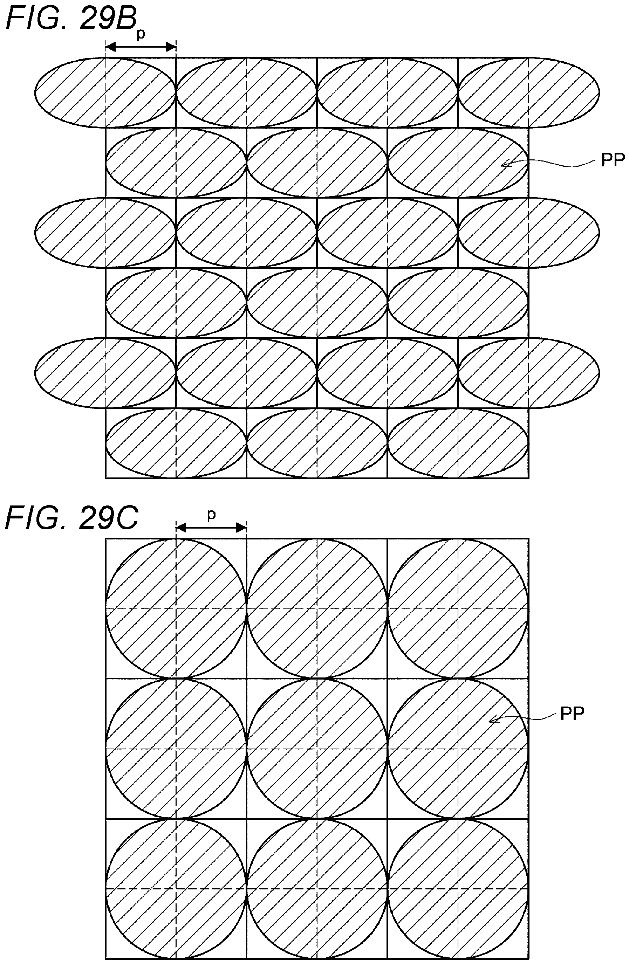

As illustrated in Figs. 28A, 28B, 29A, and 29B, for example, the phase difference pixel PP may be provided in a size of 2p × 1p in a case where the pixel pitch of the normal pixel NP is p. In such a case, the phase difference pixel PP can include two subpixels SP.

The phase difference pixel PP may be provided alone among the normal pixels NP as illustrated in Fig. 28A, or a plurality of phase difference pixels PP may be provided side by side among the normal pixels NP as illustrated in Fig. 28B. Furthermore, the phase difference pixel PP may be provided in a region in which only the phase difference pixels PP are arranged as illustrated in Figs. 29A and 29B. In such a case, the phase difference pixels PP may be arranged in a matrix as illustrated in Fig. 29A, or may be alternately arranged as illustrated in Fig. 29B.

Furthermore, as illustrated in Figs. 28C and 29C, for example, the phase difference pixels PP may be provided with a size of 2p × 2p in a case where the pixel pitch of the normal pixels NP is p. In such a case, the phase difference pixel PP can include four subpixels SP.

The phase difference pixel PP may be provided alone among the normal pixels NP as illustrated in Fig. 28C. Furthermore, the phase difference pixel PP may be provided in a region in which only the phase difference pixels PP are arranged as illustrated in Fig. 29C. In such a case, the phase difference pixels PP may be arranged in a matrix as illustrated in Fig. 29C.

### <3. Second Embodiment>

### (3.1. Configuration of Pixel Unit)

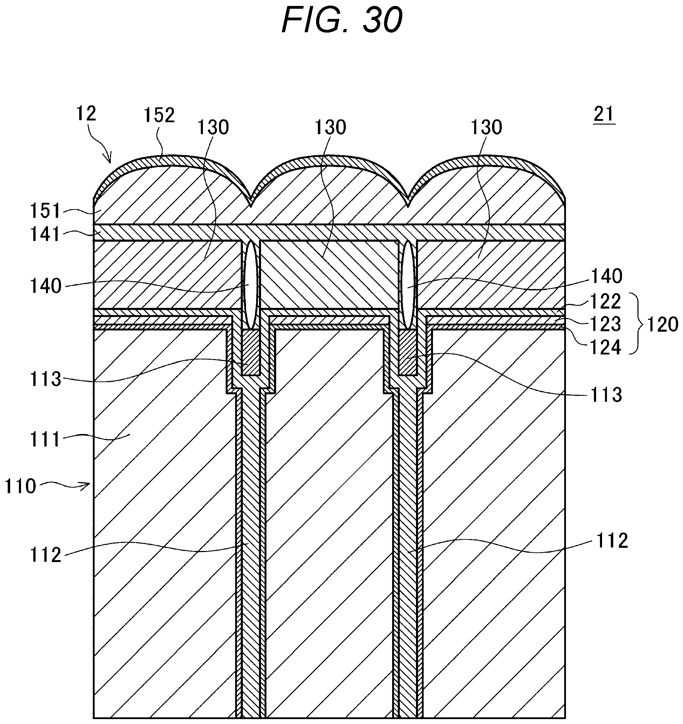

Next, a cross-sectional configuration of a pixel unit 21 according to a second embodiment of the present disclosure will be described with reference to Fig. 30. Fig. 30 is a longitudinal cross-sectional view illustrating a cross-sectional configuration of the pixel unit 21.

As illustrated in Fig. 30, the pixel unit 21 includes the semiconductor substrate 110, the intermediate layer 120, the color filter 130, the insulating layer 141, the on-chip lens 151, and the antireflection film 152.

The semiconductor substrate 110 is, for example, a substrate having a thickness of 1 µm to 6 µm and constituted by silicon (Si). The semiconductor substrate 110 is provided with a photoelectric conversion unit 111 that generates a signal charge corresponding to the amount of received incident light for each pixel 12. The photoelectric conversion unit 111 is, for example, a photodiode, and is configured by providing a semiconductor region of a second conductivity type (for example, N-type) inside a semiconductor region of a first conductivity type (for example, P-type) for each pixel 12.

Furthermore, the photoelectric conversion units 111 provided for the respective pixels 12 are electrically separated from each other by a pixel separation wall 112 constituted by an insulating material. The pixel separation wall 112 may be constituted by, for example, an insulating material such as silicon oxide (SiO₂), silicon nitride (SiN), or silicon oxynitride (SiON), and may be provided to extend in the thickness direction of the semiconductor substrate 110.

Furthermore, the pixel separation wall 112 is provided with the light shielding unit 113. Specifically, the light shielding unit 113 is provided on the intermediate layer 120 side of the pixel separation wall 112. For example, the light shielding unit 113 may be constituted by a conductive material such as tungsten (W), aluminum (Al), copper (Cu), titanium nitride (TiN), or polysilicon (poly-Si) capable of shielding light, or may be constituted by an organic resin material containing a carbon black pigment or a titanium black pigment. The light shielding unit 113 shields light leaking into the adjacent pixels 12, thereby further suppressing color mixing between the adjacent pixels 12.

The intermediate layer 120 is a functional layer provided on the semiconductor substrate 110 with an insulating material. The intermediate layer 120 is provided on the semiconductor substrate 110 separately for each pixel 12 in the low refraction region 140.

In the second embodiment, the intermediate layer 120 is configured by sequentially stacking a fixed charge layer 124, a reflection control layer 123, and a dielectric layer 122 from the semiconductor substrate 110 side.

The dielectric layer 122 is a layer constituted by a dielectric material and extending from the pixel separation wall 112 along the bottom surface and the side surface of the light shielding unit 113 and the lower surface of the color filter 130. Specifically, the dielectric layer 122 is provided to extend from the pixel separation wall 112 so as to surround the lower surface and the side surface of the light shielding unit 113 provided on the intermediate layer 120 side of the pixel separation wall 112. The dielectric layer 122 further extends above the semiconductor substrate 110 and is provided along the lower surface of the color filter 130.

The dielectric layer 122 is constituted by the same insulating material (that is, the dielectric material) as the pixel separation wall 112, and may be formed in the same process as the pixel separation wall 112. For example, the pixel separation wall 112 and the dielectric layer 122 may be configured by depositing silicon oxide (SiO₂), silicon nitride (SiN), silicon oxynitride (SiON), or the like using atomic layer deposition (ALD). In such a case, the thickness of the dielectric layer 122 provided along the side surface of the light shielding unit 113 is at least substantially the same as the thickness of the dielectric layer 122 provided along the lower surface of the light shielding unit 113. Furthermore, the thickness of the dielectric layer 122 provided along the lower surface of the color filter 130 may be substantially the same as the thickness of the dielectric layer 122 provided along the side surface and the lower surface of the light shielding unit 113.

However, the thickness of the dielectric layer 122 provided along the side surface of the light shielding unit 113 may be thinner than the thickness of the dielectric layer 122 provided along the lower surface of the light shielding unit 113. In such a case, the pixel unit 21 can further improve characteristics such as color mixing suppression and quantum efficiency of the pixel 12.

The fixed charge layer 124 is constituted by a material having a negative fixed charge, and is provided between the dielectric layer 122 and the semiconductor substrate 110. Specifically, the fixed charge layer 124 may be constituted by a high dielectric material having a negative fixed charge such as hafnium oxide (HfO₂), zirconium oxide (ZrO₂), aluminum oxide (Al₂O₃), tantalum oxide (Ta₂O₅), titanium oxide (TiO₂), magnesium oxide (MgO), yttrium oxide (Y₂O₃), or an oxide of a lanthanoid. Since the fixed charge layer 124 can form a region in which positive charges are accumulated in the interface region with the semiconductor substrate 110 by negative fixed charges, generation of dark current between the dielectric layer 122 and the semiconductor substrate 110 can be suppressed.

Furthermore, the fixed charge layer 124 may be provided to extend between the semiconductor substrate 110 and the dielectric layer 122 provided on the side surface of the light shielding unit 113 and the pixel separation wall 112 continuous with the dielectric layer 122. For example, the fixed charge layer 124 may be provided so as to be interposed between the semiconductor substrate 110 and the dielectric layer 122 and the pixel separation wall 112 constituted by an insulating material (that is, the dielectric material). In such a case, similarly, the fixed charge layer 124 can suppress generation of a dark current between the dielectric layer 122 and the pixel separation wall 112 and the semiconductor substrate 110 due to a negative fixed charge.

The reflection control layer 123 is constituted by a material having a refractive index higher than the refractive index of the dielectric layer 122 and lower than the refractive index of the semiconductor substrate 110, and is provided between the fixed charge layer 124 and the dielectric layer 122. For example, the reflection control layer 123 may be provided between the fixed charge layer 124 provided on the surface of the semiconductor substrate 110 and the dielectric layer 122 provided on the lower surface of the color filter 130. Since the reflection control layer 123 can suppress reflection of light at the interface with the dielectric layer 122 or the interface with the semiconductor substrate 110, it is possible to improve the incident efficiency of light on the photoelectric conversion unit 111.

The color filter 130 is provided for each pixel 12 on the intermediate layer 120, and selectively transmits light (for example, red light (R), green light (G), and blue light (B)) in a wavelength band corresponding to each pixel 12. The color filter 130 may be provided in a predetermined RGB array such as a Bayer array, for example.

As an example, the color filter 130 may be provided by adding a pigment or dye to a transparent resin that transmits visible light. As another example, the color filter 130 may include a transparent filter constituted by a transparent resin that transmits visible light, an ND filter obtained by adding carbon black to a transparent resin, or the like.

In the pixel unit 21, the color filter 130 and the intermediate layer 120 are separated for each pixel 12 by the low refraction region 140 extending in the thickness direction of the semiconductor substrate 110. Note that, in the second embodiment, the low refraction region 140 only needs to separate at least one layer of the dielectric layer 122, the reflection control layer 123, and the fixed charge layer 124 included in the intermediate layer 120 for each pixel 12.

The low refraction region 140 is a region having a refractive index lower than that of the color filter 130. For example, the low refraction region 140 may be a region having a refractive index of 1.0 or more and 1.35 or less. The low refraction region 140 is provided between the color filters 130 provided for each pixel 12 and between the intermediate layers 120 provided for each pixel 12. As a result, the low refraction region 140 can cause the color filter 130 and the intermediate layer 120 to function as a waveguide in which the high refractive index material is sandwiched between the low refractive index materials. Therefore, since the low refraction region 140 can reflect the light traveling to the adjacent pixel 12 at the interface with the color filter 130 and the interface with the intermediate layer 120, the incident efficiency of the light on the photoelectric conversion unit 111 can be improved.

The low refraction region 140 may be constituted by any material as long as the refractive index is lower than that of the color filter 130. For example, the low refraction region 140 may be a gap, and may be constituted by an inorganic material such as silicon oxide (SiO₂), silicon nitride (SiN), or silicon oxynitride (SiON), or a resin material such as a styrene resin, an acrylic resin, a styrene-acrylic copolymer resin, or a siloxane resin. Furthermore, the low refraction region 140 may be constituted by a so-called low-k material such as SiOF, SiOC, or porous silica.

The insulating layer 141 is constituted by an insulating material on the color filter 130. For example, the insulating layer 141 is provided by forming a film of silicon oxide (SiO₂) or the like on the color filter 130. According to this, the insulating layer 141 is formed with a high coverage on the color filter 130 separated for each pixel 12, so that the upper end can be sealed without being embedded while the low refraction region 140 between the color filters 130 is kept as a gap.

The on-chip lens 151 is provided for each pixel 12 on the insulating layer 141. The on-chip lens 151 may be constituted by, for example, a resin material such as a styrene resin, an acrylic resin, a styrene-acrylic copolymer resin, or a siloxane resin. The on-chip lens 151 condenses the light incident on the pixel 12, so that the light incident on the pixel 12 can be efficiently incident on the photoelectric conversion unit 111.

Furthermore, the antireflection film 152 may be formed on the surface layer of the on-chip lens 151. The antireflection film 152 is configured as, for example, a dielectric multilayer film. The antireflection film 152 can suppress reflection of light incident on the on-chip lens 151.

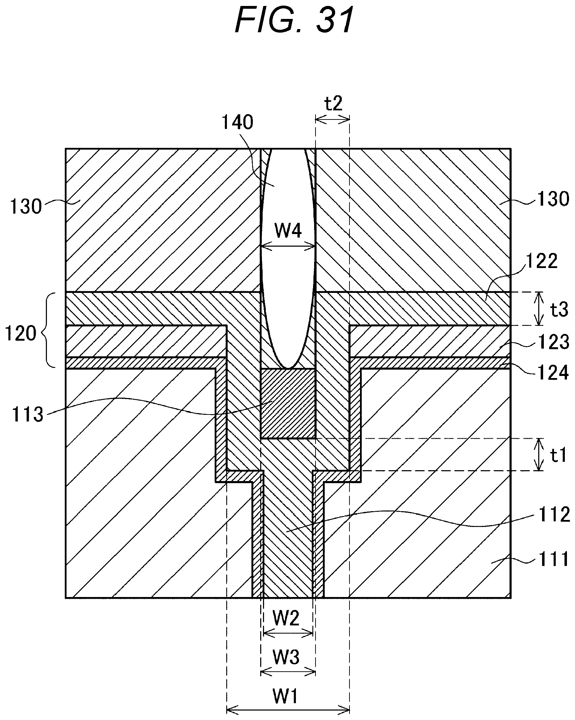

Here, the dimensions of the light shielding unit 113, the dielectric layer 122, the pixel separation wall 112, and the low refraction region 140 will be more specifically described with reference to Fig. 31. Fig. 31 is an enlarged longitudinal cross-sectional view of the vicinity of the light shielding unit 113 in Fig. 30.

As illustrated in Fig. 31, the thickness of the dielectric layer 122 provided along the lower surface of the light shielding unit 113 is t1, the thickness of the dielectric layer 122 provided along the side surface of the light shielding unit 113 is t2, and the thickness of the dielectric layer 122 provided along the lower surface of the color filter 130 is t3. At this time, the dielectric layer 122 may be provided so as to satisfy t1 = t2, and may be further provided so as to satisfy t1 = t2 = t3. Such a dielectric layer 122 can be formed by using atomic layer deposition (ALD) capable of depositing a highly accurate and uniform film on an arbitrary structure. Further, the dielectric layer 122 may be provided such that t2 is smaller than t1 or t3. Since the thickness of the dielectric layer 122 provided along the side surface of the light shielding unit 113 becomes thinner, the pixel unit 21 can suppress color mixing between adjacent pixels 12 and can further enhance the quantum efficiency of the photoelectric conversion unit 111.

Furthermore, the sum of the thickness of the dielectric layer 122 provided along both side surfaces of the light shielding unit 113 and the width of the light shielding unit 113 is W1, and the width of the pixel separation wall 112 is w2. At this time, the dielectric layer 122 and the pixel separation wall 112 may be provided so as to satisfy W1 > W2. Since the light shielding unit 113 is provided with a width that makes the total width of the light shielding unit 113 and the dielectric layer 122 larger than the width of the pixel separation wall 112, color mixing between adjacent pixels 12 can be further suppressed.

Furthermore, the width of the light shielding unit 113 is W3, and the width of the low refraction region 140 is W4. At this time, the light shielding unit 113 and the low refraction region 140 may be provided so as to satisfy W3 = W4, or may be provided so as to satisfy W3 < W4. Since the light shielding unit 113 is provided with at least the same width as the width of the low refraction region 140, color mixing between the adjacent pixels 12 can be further suppressed.

### (3.2. Modifications)

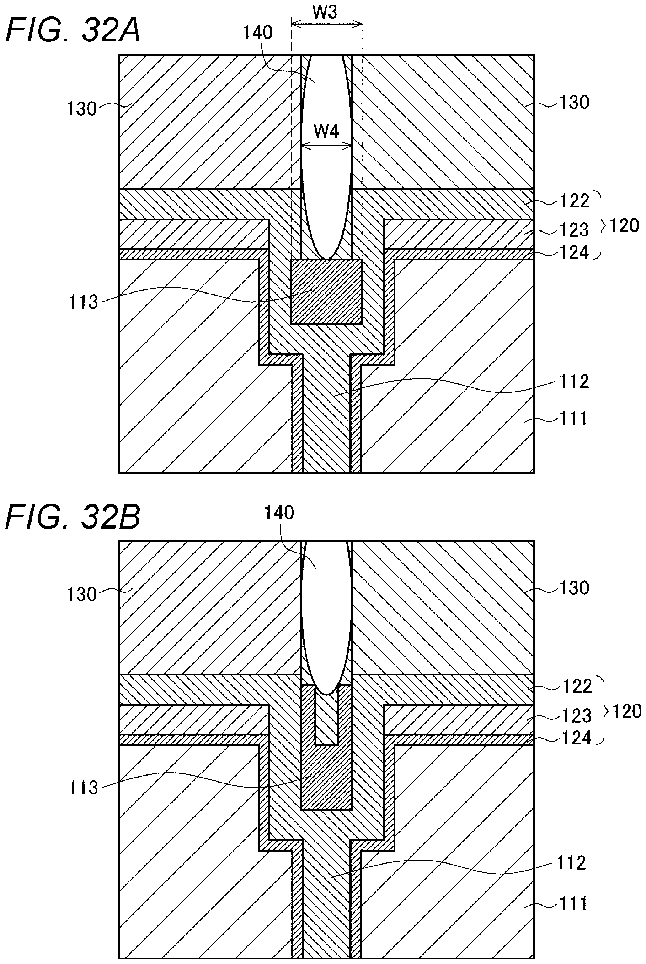

Next, first to 23rd modifications of the pixel unit 21 of the imaging device 100 according to the present embodiment will be described with reference to Figs. 32A to 67.

### (First Modification)

Figs. 32A to 32F are longitudinal cross-sectional views illustrating variations of the configuration in the vicinity of the light shielding unit 113. As illustrated in Figs. 32A to 32F, in the pixel unit 21 according to the first modification, variations may be added to the configuration in the vicinity of the light shielding unit 113.

As illustrated in Fig. 32A, the light shielding unit 113 may be provided such that the width W3 of the light shielding unit 113 is wider than the width W4 of the low refraction region 140. By providing the light shielding unit 113 with a wider width, color mixing between the adjacent pixels 12 can be further suppressed.

As illustrated in Fig. 32B, the light shielding unit 113 may be provided to extend to the upper side along the inner surface of the opening in which the low refraction region 140 is provided. For example, the light shielding unit 113 may be provided to extend to the upper side along the inner surface of the concave structure by attaching a conductive material to the inner surface of the concave structure formed by the dielectric layer 122. Even in such a case, the light shielding unit 113 can suppress color mixing between the adjacent pixels 12.

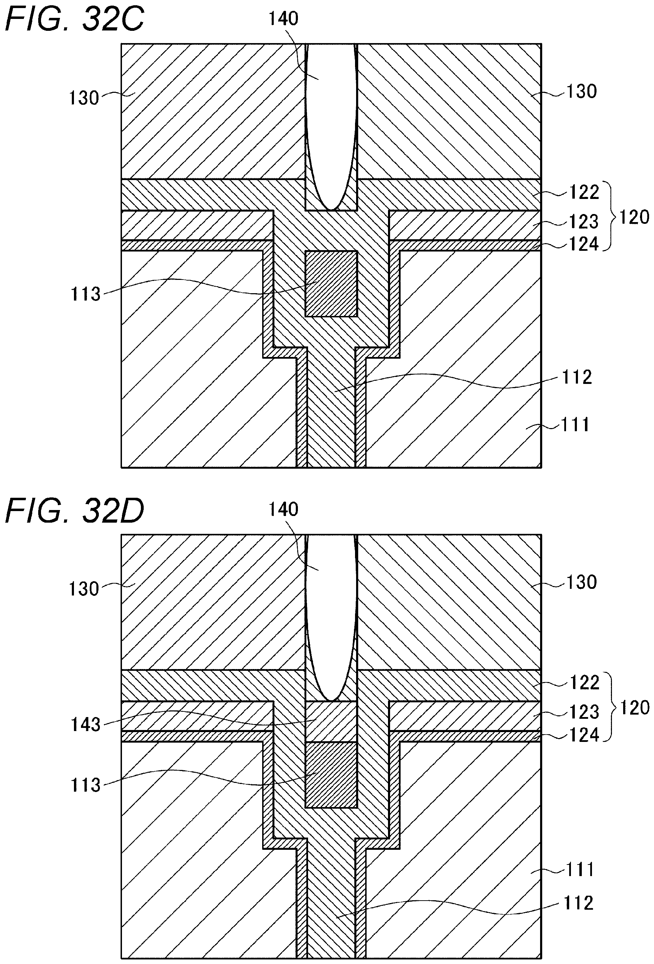

As illustrated in Figs. 32C and 32D, the light shielding unit 113 and the low refraction region 140 may be provided so as not to be in contact with each other.

As an example, as illustrated in Fig. 32C, the dielectric layer 122 may be provided between the light shielding unit 113 and the low refraction region 140. In such a case, since the dielectric layer 122 can protect the light shielding unit 113 from the influence that may occur in the process of forming the low refraction region 140, characteristic deterioration of the light shielding unit 113 can be prevented.

As another example, as illustrated in Fig. 32D, a low refraction layer 143 constituted by an insulating material having a refractive index lower than that of the dielectric layer 122 may be provided between the light shielding unit 113 and the low refraction region 140. In such a case, since the low refraction layer 143 can protect the light shielding unit 113 from the influence that may occur in the process of forming the low refraction region 140, characteristic deterioration of the light shielding unit 113 can be suppressed. In addition, since the low refraction layer 143 can form the waveguide having the high refractive index material sandwiched between the low refractive index materials up to immediately above the light shielding unit 113, it is possible to improve the incident efficiency of light to the photoelectric conversion unit 111.

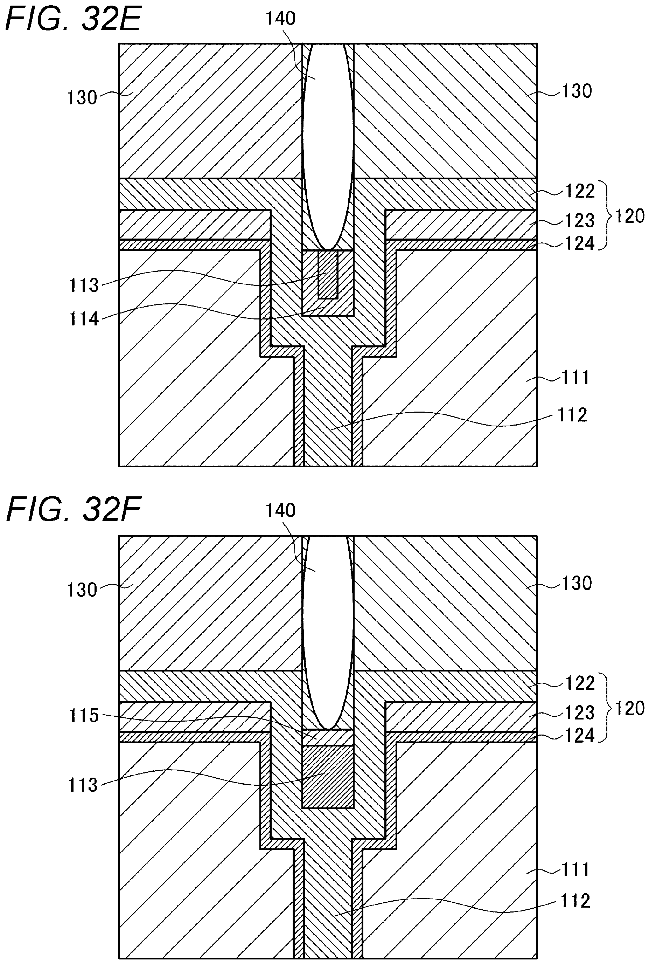

As illustrated in Fig. 32E, a diffusion prevention layer 114 constituted by Ti, TiN, or the like may be provided between the light shielding unit 113 and the dielectric layer 122. The diffusion prevention layer 114 can prevent mutual diffusion of atoms between the dielectric layer 122 and the light shielding unit 113. Therefore, the diffusion prevention layer 114 can prevent characteristic deterioration of the dielectric layer 122 and the light shielding unit 113.

As illustrated in Fig. 32F, a cap layer 115 constituted by Ti, TiN, or the like may be provided on the upper surface of the light shielding unit 113. Since the cap layer 115 can protect the light shielding unit 113 from the influence that may occur in the process of forming the low refraction region 140, characteristic deterioration of the light shielding unit 113 can be prevented. Furthermore, since the cap layer 115 constituted by Ti, TiN, or the like can shield light leaking into the adjacent pixels 12 similarly to the light shielding unit 113, it is also possible to suppress color mixing between the adjacent pixels 12.

### (Second Modification)

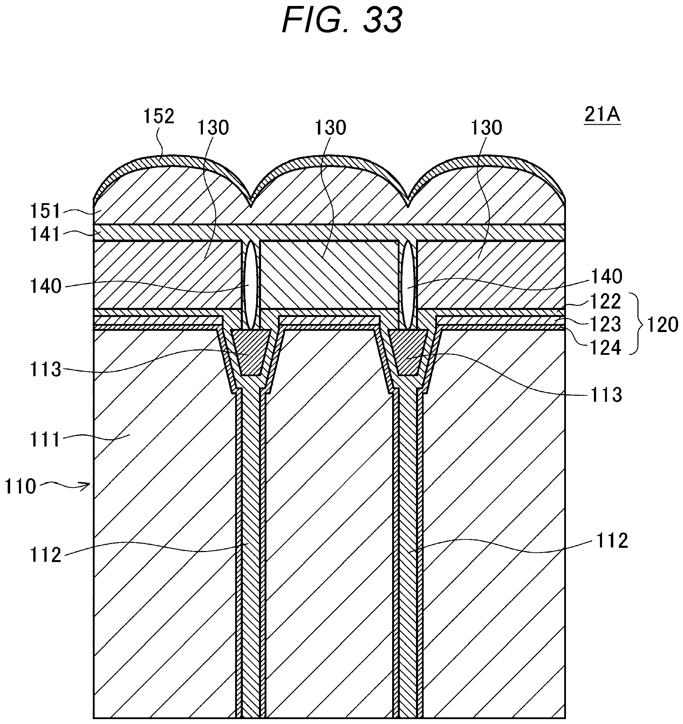

Fig. 33 is a longitudinal cross-sectional view illustrating a cross-sectional configuration of a pixel unit 21A according to a second modification. As illustrated in Fig. 33, the pixel unit 21A according to the second modification is different from the pixel unit 21 illustrated in Fig. 30 in that the light shielding unit 113 is provided in a reverse tapered shape.

Specifically, the light shielding unit 113 may be provided in a reverse tapered shape expanding toward the upper side where the color filter 130 and the low refraction region 140 are provided. Since the light shielding unit 113 having such a reverse tapered shape is easier to form than the light shielding unit 113 having a non-tapered shape, it is possible to reduce the difficulty in the manufacturing process of the pixel unit 21A.

### (Third Modification)

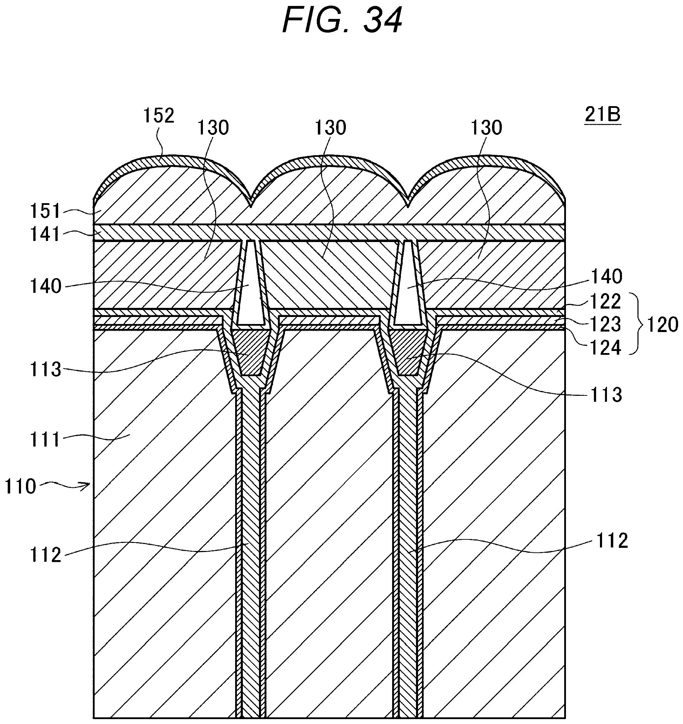

Fig. 34 is a longitudinal cross-sectional view illustrating a cross-sectional configuration of a pixel unit 21B according to a third modification. As illustrated in Fig. 34, the pixel unit 21B according to the third modification is different from the pixel unit 21A illustrated in Fig. 33 in that the low refraction region 140 is further provided in a tapered shape.

Specifically, the low refraction region 140 may be provided in a tapered shape that narrows toward the upper side where the on-chip lens 151 is provided. In a case where such a tapered low refraction region 140 is formed as a gap, the upper end can be easily sealed with the insulating layer 141, so that the difficulty in the manufacturing process of the pixel unit 21A can be reduced.

### (Fourth Modification)

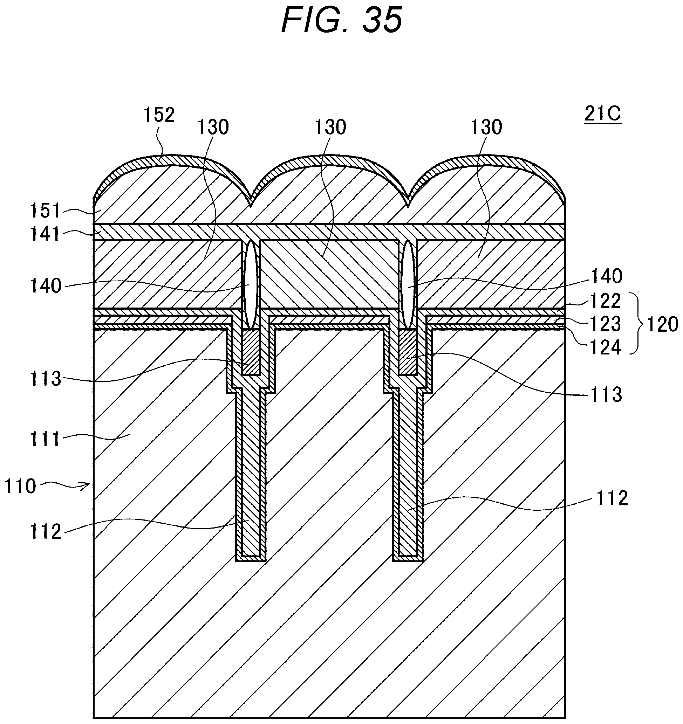

Fig. 35 is a longitudinal cross-sectional view illustrating a cross-sectional configuration of a pixel unit 21C according to a fourth modification. As illustrated in Fig. 35, the pixel unit 21C according to the fourth modification is different from the pixel unit 21 illustrated in Fig. 30 in that the pixel separation wall 112 is provided to extend to the middle of the semiconductor substrate 110 in the thickness direction of the semiconductor substrate 110.

Specifically, the pixel separation wall 112 is provided to extend to the middle of the semiconductor substrate 110, so that the photoelectric conversion units 111 of the adjacent pixels 12 can be electrically separated, similarly to the pixel unit 21 illustrated in Fig. 30. Therefore, the pixel unit 21C according to the fourth modification can suppress color mixing between adjacent pixels 12, similarly to the pixel unit 21 illustrated in Fig. 30.

### (Fifth Modification)

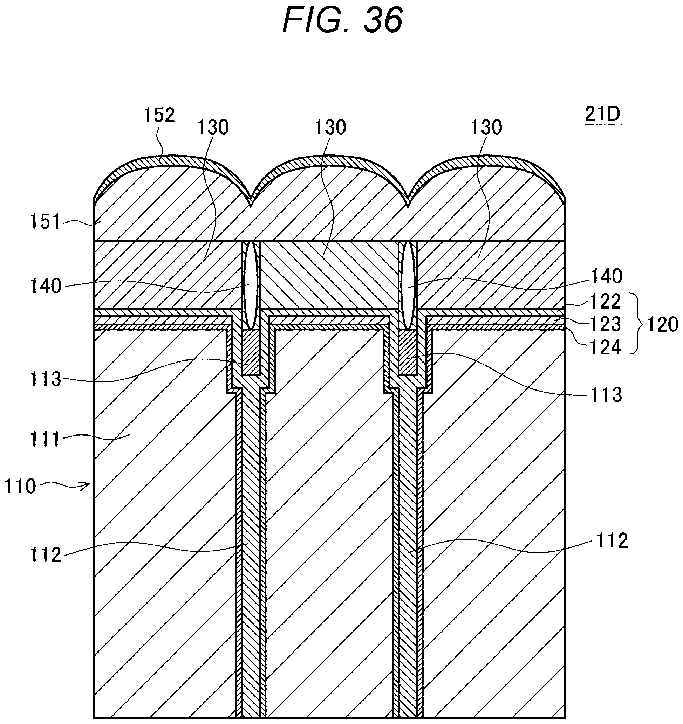

Fig. 36 is a longitudinal cross-sectional view illustrating a cross-sectional configuration of a pixel unit 21D according to a fifth modification. As illustrated in Fig. 36, the pixel unit 21D according to the fifth modification is different from the pixel unit 21 illustrated in Fig. 30 in that the insulating layer 141 is not provided.

Specifically, in a case where the low refraction region 140 is a gap, the pixel unit 21D can form the low refraction region 140 by sealing the upper end of the gap with the on-chip lens 151. Furthermore, in a case where the low refraction region 140 includes a low refractive material having a refractive index lower than that of the color filter 130, the pixel unit 21D can form the low refraction region 140 by embedding the low refractive material between the color filters 130 and between the intermediate layers 120.

According to this, the pixel unit 21D according to the fifth modification can appropriately form the low refraction region 140, and thus, it is possible to suppress color mixing between the adjacent pixels 12, similarly to the pixel unit 21 illustrated in Fig. 30.

### (Sixth Modification)

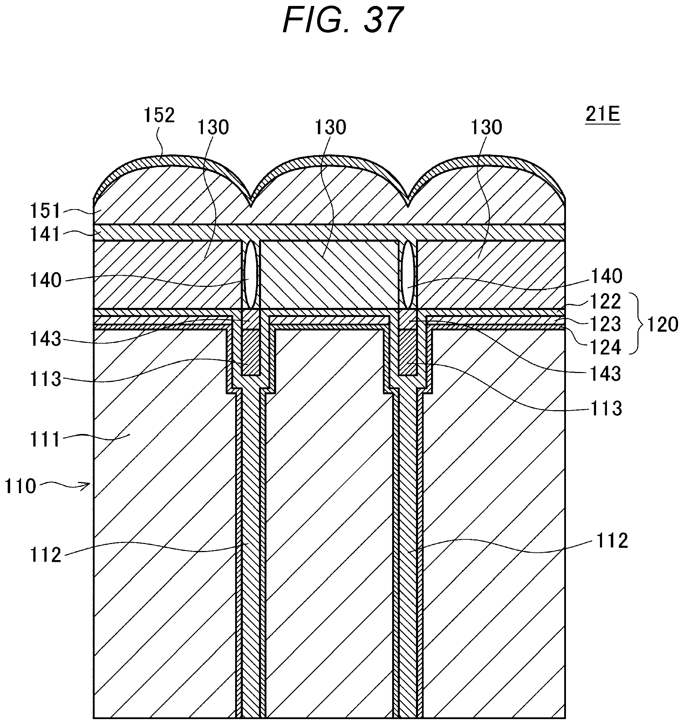

Fig. 37 is a longitudinal cross-sectional view illustrating a cross-sectional configuration of a pixel unit 21E according to a sixth modification. As illustrated in Fig. 37, the pixel unit 21E according to the sixth modification is different from the pixel unit 21 illustrated in Fig. 30 in that the low refraction layer 143 constituted by an insulating material having a refractive index lower than that of the dielectric layer 122 is provided between the light shielding unit 113 and the low refraction region 140.

Specifically, the low refraction layer 143 is constituted by an inorganic material having a refractive index lower than that of the dielectric layer 122, such as silicon oxide (SiO₂), silicon nitride (SiN), or silicon oxynitride (SiON), or a resin material such as a styrene resin, an acrylic resin, a styrene-acrylic copolymer resin, or a siloxane resin. Since the low refraction layer 143 can protect the light shielding unit 113 from the influence that may occur in the process of forming the low refraction region 140, characteristic deterioration of the light shielding unit 113 can be suppressed. In addition, since the low refraction layer 143 can form the waveguide having the high refractive index material sandwiched between the low refractive index materials up to immediately above the light shielding unit 113, it is possible to improve the incident efficiency of light to the photoelectric conversion unit 111.

### (Seventh Modification)

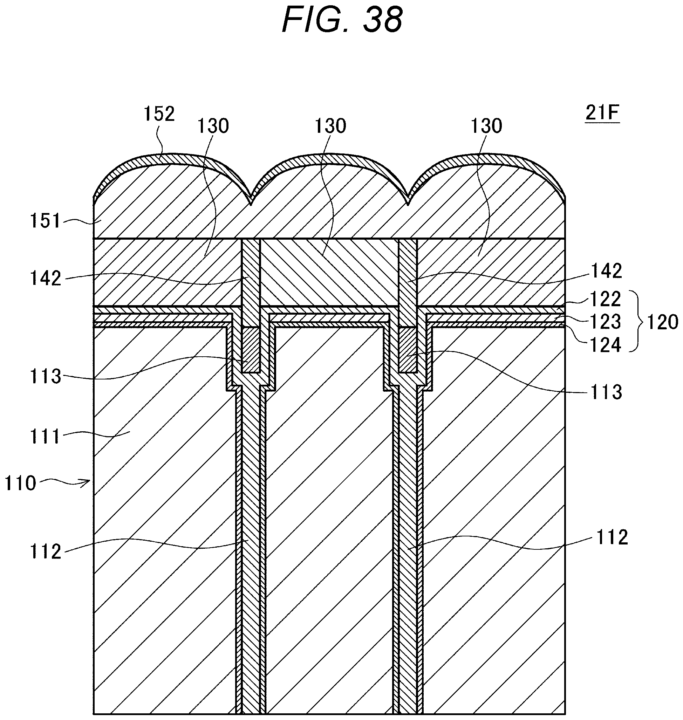

Fig. 38 is a longitudinal cross-sectional view illustrating a cross-sectional configuration of a pixel unit 21F according to a seventh modification. As illustrated in Fig. 38, the pixel unit 21F according to the seventh modification is different from the pixel unit 21 illustrated in Fig. 30 in that the low refraction region 140 is provided not as a gap but as the low refraction layer 142.

The low refraction layer 142 is constituted by a material having a refractive index lower than that of the color filter 130, and is provided between the color filters 130 provided for the respective pixels 12 and between the intermediate layers 120. The material having a refractive index lower than that of the color filter 130 is, for example, an inorganic material such as silicon oxide (SiO₂), silicon nitride (SiN), or silicon oxynitride (SiON), a resin material such as a styrene resin, an acrylic resin, a styrene-acrylic copolymer resin, or a siloxane resin, or a low-k material such as SiOF, SiOC, or porous silica. Similarly to the low refraction region 140 provided as a gap, the low refraction layer 142 can cause the color filter 130 and the intermediate layer 120 to function as a waveguide in which a high refractive index material is sandwiched between low refractive index materials.

According to this, the pixel unit 21F according to the seventh modification can reflect light traveling to the adjacent pixel 12 at the interface between the low refraction layer 142 and the color filter 130 and the interface between the low refraction layer 142 and the intermediate layer 120. Therefore, the pixel unit 21F according to the seventh modification can suppress color mixing between adjacent pixels 12, similarly to the pixel unit 21 illustrated in Fig. 30.

### (Eighth Modification)

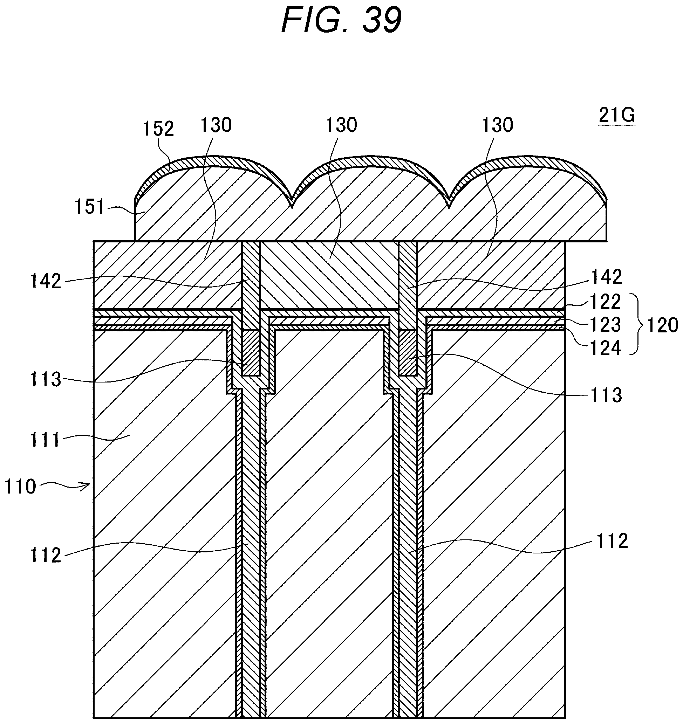

Figs. 39 to 41 are longitudinal cross-sectional views illustrating cross-sectional configurations of pixel units 21G, 21H, and 211 according to an eighth modification. As illustrated in Figs. 39 to 41, the pixel units 21G, 21H, and 211 according to the eighth modification are provided such that the configuration on the upper side (that is, the light incident surface side) of the semiconductor substrate 110 is shifted in the light incident direction in order to allow light having a large incident angle to be more efficiently incident on the photoelectric conversion unit 111. Such a shift is referred to as pupil correction or the like, and is performed, for example, in the pixel 12 provided in a region having a large incident angle of light, such as a peripheral edge of the pixel region.

Note that, in the pixel units 21G, 21H, and 211 according to the eighth modification, the low refraction region 140 is provided as the low refraction layer 142 instead of the gap. In a case where the low refraction region 140 is provided as the low refraction layer 142, the pixel units 21G, 21H, and 21I can more easily shift the configuration on the upper side of the semiconductor substrate 110 as compared with a case where the low refraction region 140 is a gap.

Specifically, as illustrated in Fig. 39, the on-chip lens 151 may be provided to be shifted in the light incident direction with respect to the color filter 130 and the low refraction layer 142.

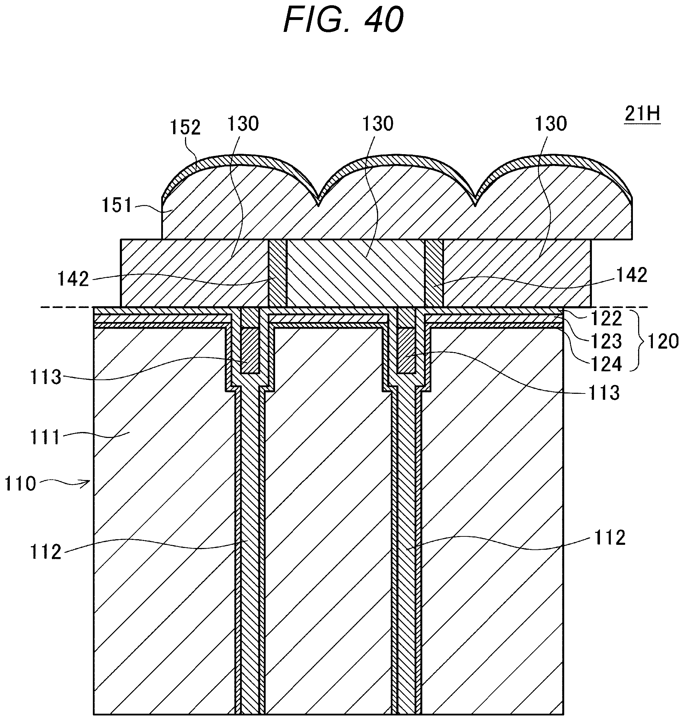

As illustrated in Fig. 40, the on-chip lens 151, the color filter 130, and the low refraction layer 142 may be provided to be shifted in the incident direction of light with respect to the dielectric layer 122. Furthermore, the on-chip lens 151 may be further shifted in the light incident direction with respect to the color filter 130 and the low refraction layer 142.

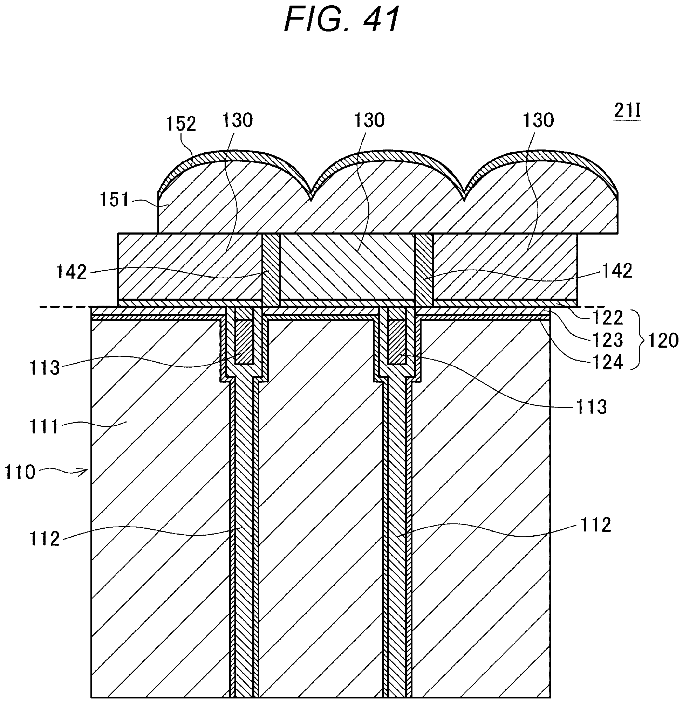

As illustrated in Fig. 41, the on-chip lens 151, the color filter 130, the low refraction layer 142, and the dielectric layer 122 may be provided to be shifted in the incident direction of light with respect to the reflection control layer 123. Furthermore, the on-chip lens 151, the color filter 130, and the low refraction layer 142 may be provided to be shifted in the incident direction of light with respect to the dielectric layer 122, and the on-chip lens 151 may be provided to be further shifted in the incident direction of light with respect to the color filter 130 and the low refraction layer 142.

According to this, the pixel units 21G, 21H, and 21I according to the eighth modification can cause light having a large incident angle to be incident on the photoelectric conversion unit 111 more efficiently. Therefore, the pixel units 21G, 21H, and 21I according to the eighth modification can cause light to be incident on the photoelectric conversion unit 111 more efficiently even in the pixel 12 at the peripheral edge of the pixel region.

### (Ninth Modification)

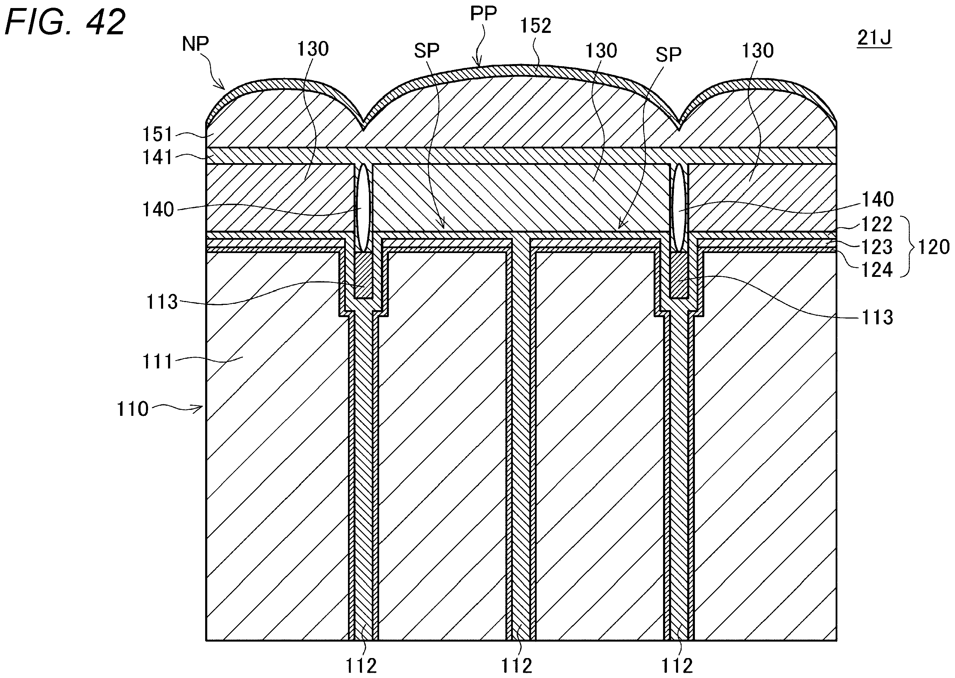

Fig. 42 is a longitudinal cross-sectional view illustrating a cross-sectional configuration of a pixel unit 21J according to a ninth modification. As illustrated in Fig. 42, the pixel unit 21J according to the ninth modification is different from the pixel unit 21 illustrated in Fig. 30 in that the normal pixel NP and the phase difference pixel PP are mixed.

Specifically, the phase difference pixel PP includes a plurality of subpixels SP and one on-chip lens 151 provided on the plurality of subpixels SP. The phase difference pixel PP can detect the distance to the subject on the basis of the pixel signal obtained in each of the plurality of subpixels SP. The low refraction region 140 is not provided between the subpixels SP, but is provided between the phase difference pixel PP and the normal pixel NP. The pixel unit 21J according to the ninth modification can suppress color mixing between the phase difference pixel PP and the normal pixel NP or between the normal pixels NP.

### (10th Modification)

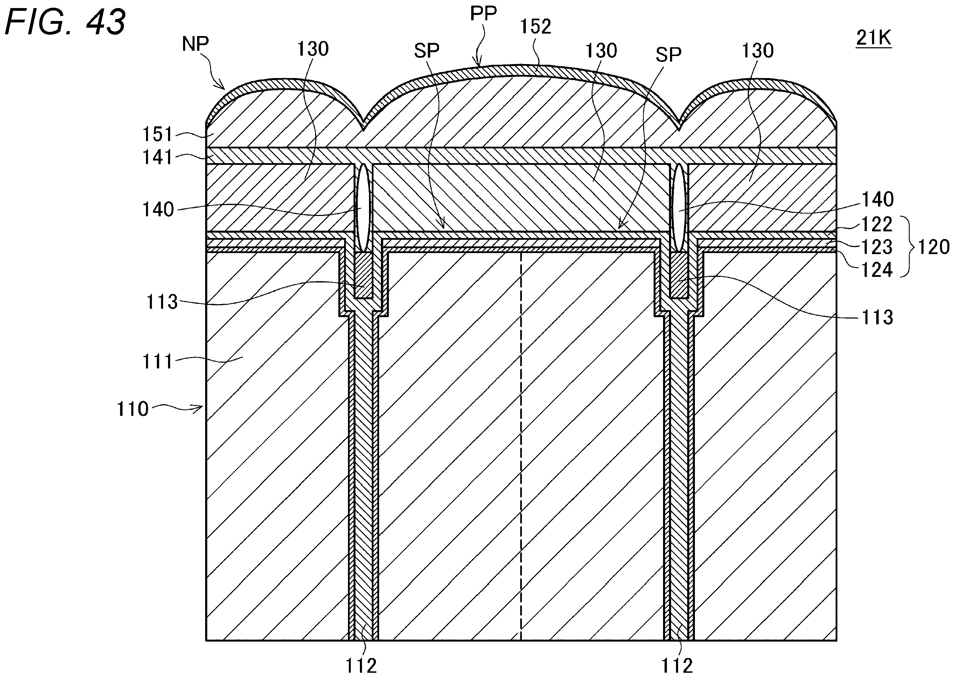

Fig. 43 is a longitudinal cross-sectional view illustrating a cross-sectional configuration of a pixel unit 21K according to a 10th modification. As illustrated in Fig. 43, the pixel unit 21K according to the 10th modification is different from the pixel unit 21J illustrated in Fig. 42 in that each of the subpixels SP is not separated by the pixel separation wall 112.

In the pixel unit 21K according to the 10th modification, each of the subpixels SP is electrically separated from each other by a mode of introducing a conductivity type impurity into the semiconductor substrate 110. For example, each of the subpixels SP may be electrically separated from each other by forming a low conductivity region into which no conductivity type impurity is introduced between the subpixels SP. According to this, similarly to the pixel unit 21J illustrated in Fig. 42, the pixel unit 21K according to the 10th modification can cause a part of the pixels 12 to function as the phase difference pixel PP that detects the distance to the subject.

### (11th Modification)

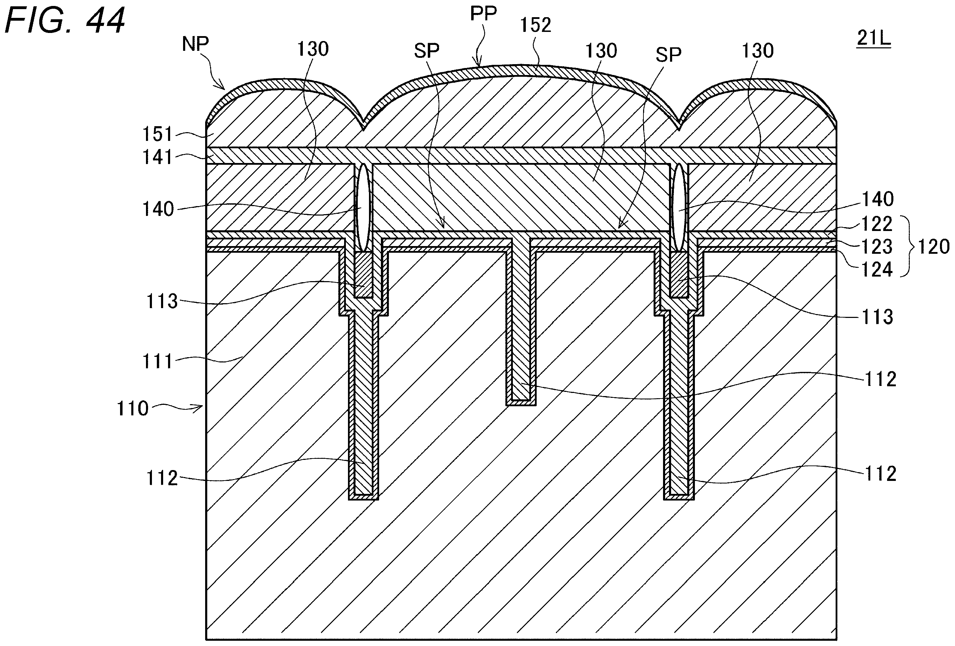

Fig. 44 is a longitudinal cross-sectional view illustrating a cross-sectional configuration of a pixel unit 21L according to an 11th modification. As illustrated in Fig. 44, the pixel unit 21L according to the 11th modification is different from the pixel unit 21J illustrated in Fig. 42 in that the pixel separation wall 112 is provided to extend to the middle of the semiconductor substrate 110 in the thickness direction of the semiconductor substrate 110.

Specifically, the pixel separation wall 112 is provided to extend to the middle of the semiconductor substrate 110, so that the adjacent pixel 12 and the photoelectric conversion unit 111 of the subpixel SP can be electrically separated, similarly to the pixel unit 21J illustrated in Fig. 42. Therefore, similarly to the pixel unit 21J illustrated in Fig. 42, the pixel unit 21L according to the 11th modification can cause a part of the pixels 12 to function as the phase difference pixel PP that detects the distance to the subject.

### (12th Modification)

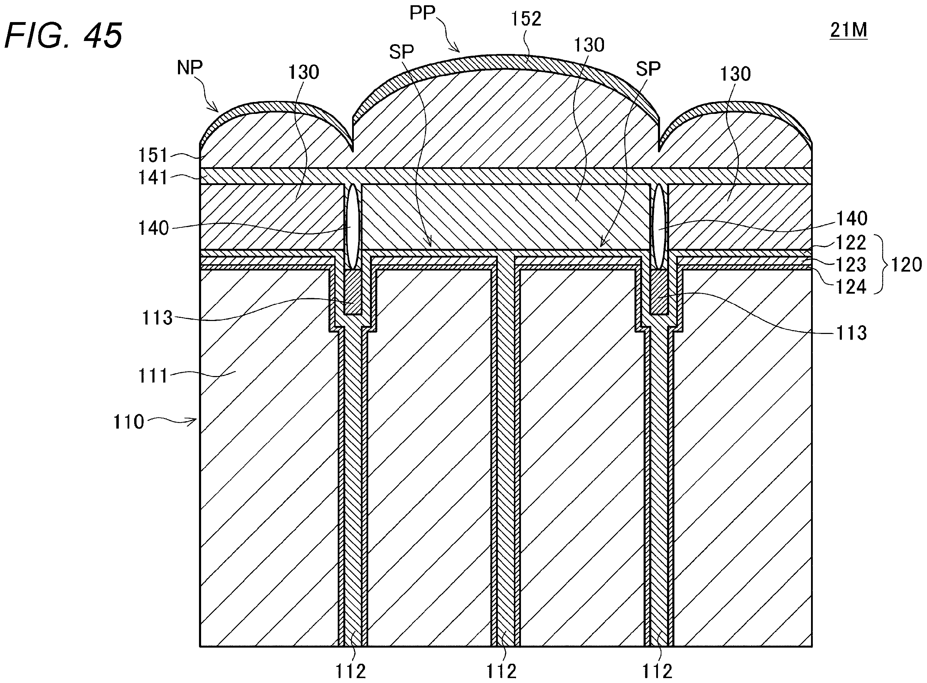

Fig. 45 is a longitudinal cross-sectional view illustrating a cross-sectional configuration of a pixel unit 21M according to a 12th modification. As illustrated in Fig. 45, the pixel unit 21M according to the 12th modification is different from the pixel unit 21J illustrated in Fig. 42 in that the height of the on-chip lens 151 provided in the phase difference pixel PP is higher than the height of the on-chip lens 151 provided in the normal pixel NP.

In the pixel unit 21M according to the 12th modification, the on-chip lens 151 provided in the phase difference pixel PP can shift the focal position to the side of the on-chip lens 151 than the on-chip lens 151 provided in the normal pixel NP. According to this, since the pixel unit 21M according to the 12th modification can improve the separation ratio in the subpixel SP, the phase difference amount of the phase difference pixel PP can be improved.

### (13th Modification)

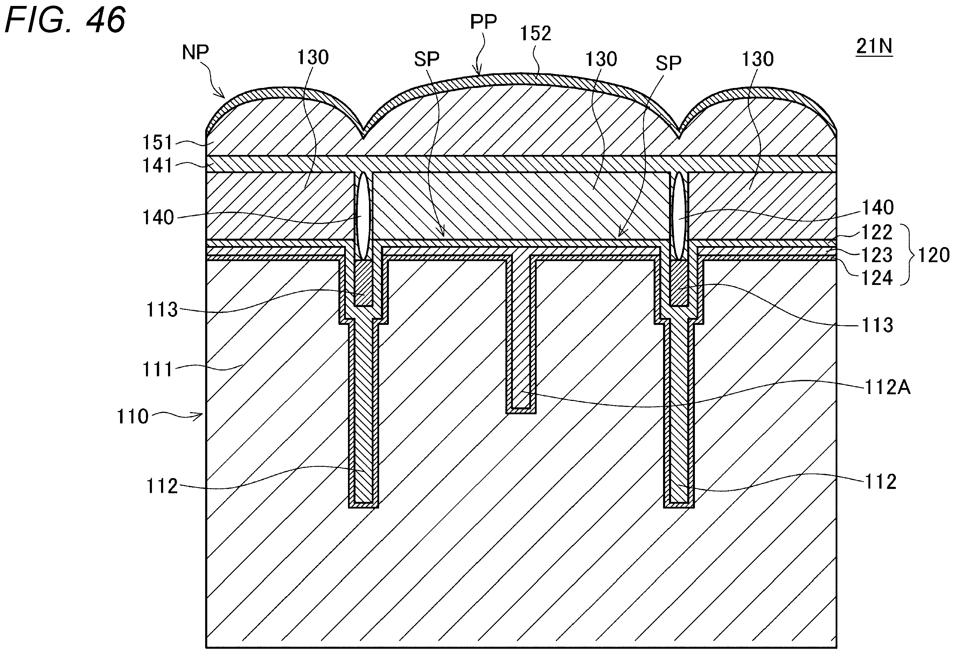

Fig. 46 is a longitudinal cross-sectional view illustrating a cross-sectional configuration of a pixel unit 21N according to a 13th modification. As illustrated in Fig. 46, the pixel unit 21N according to the 13th modification is different from the pixel unit 21L according to the 11th modification illustrated in Fig. 44 in that the pixel separation wall 112A is constituted by a material different from that of the pixel separation wall 112.

Specifically, the pixel separation wall 112 provided between the phase difference pixel PP and the normal pixel NP or between the normal pixels NP is provided to extend to the middle of the semiconductor substrate 110 in the thickness direction of the semiconductor substrate 110. On the other hand, the pixel separation wall 112A provided between the subpixels SP is provided to extend to the middle of the semiconductor substrate 110 in the thickness direction of the semiconductor substrate 110 using an insulating material different from the pixel separation wall 112. The pixel separation wall 112A may be constituted by an insulating material having a higher refractive index than the insulating material constituting the pixel separation wall 112. For example, the pixel separation wall 112A may be constituted by an insulating material having a high refractive index, such as TaO, TiO₂, or HfO. According to this, since the pixel unit 21N according to the 13th modification can improve the separation ratio in the subpixel SP, the phase difference amount of the phase difference pixel PP can be improved.

### (14th Modification)

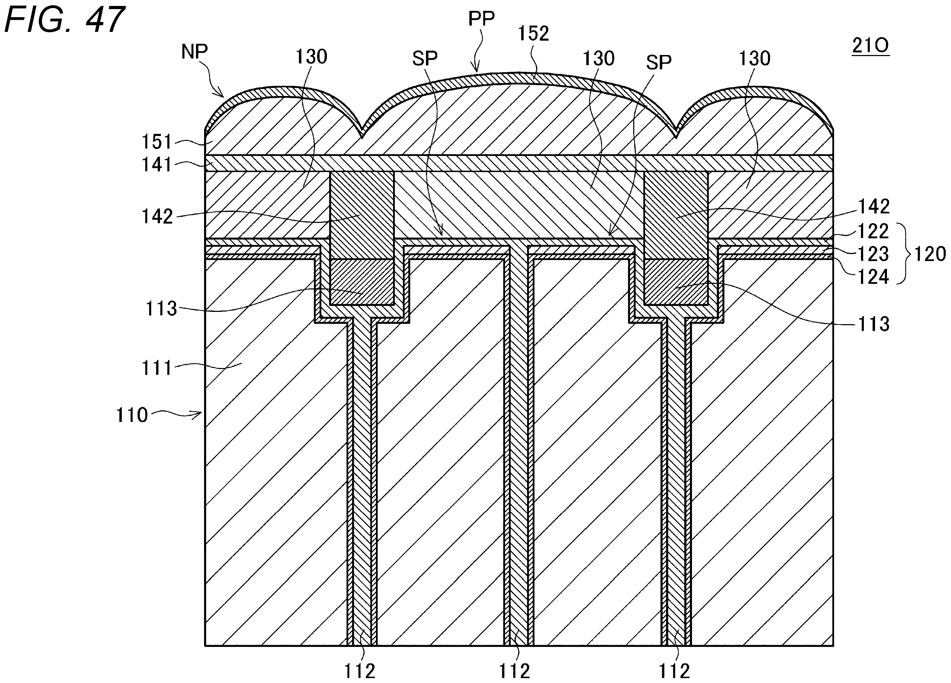

Fig. 47 is a longitudinal cross-sectional view illustrating a cross-sectional configuration of a pixel unit 21O according to a 14th modification. As illustrated in Fig. 47, the pixel unit 21O according to the 14th modification is different from the pixel unit 21J illustrated in Fig. 42 in that a low refraction layer 142 having a width larger than that of the low refraction layer 142 between the normal pixels NP is provided between the phase difference pixel PP and the normal pixel NP.

In the pixel unit 21O according to the 14th modification, in the phase difference pixel PP, the waveguide is narrowed by the low refraction layer 142, so that the focal position can be shifted to the side of the on-chip lens 151 as compared with the normal pixel NP. According to this, since the pixel unit 21O according to the 14th modification can improve the separation ratio in the subpixel SP, the phase difference amount of the phase difference pixel PP can be improved.

The planar arrangement examples of the phase difference pixels PP in the pixel units 21J to 21O according to the ninth to 14th modifications may be similar to the planar arrangement examples illustrated in Figs. 28A to 28C and Figs. 29A to 29C, for example.

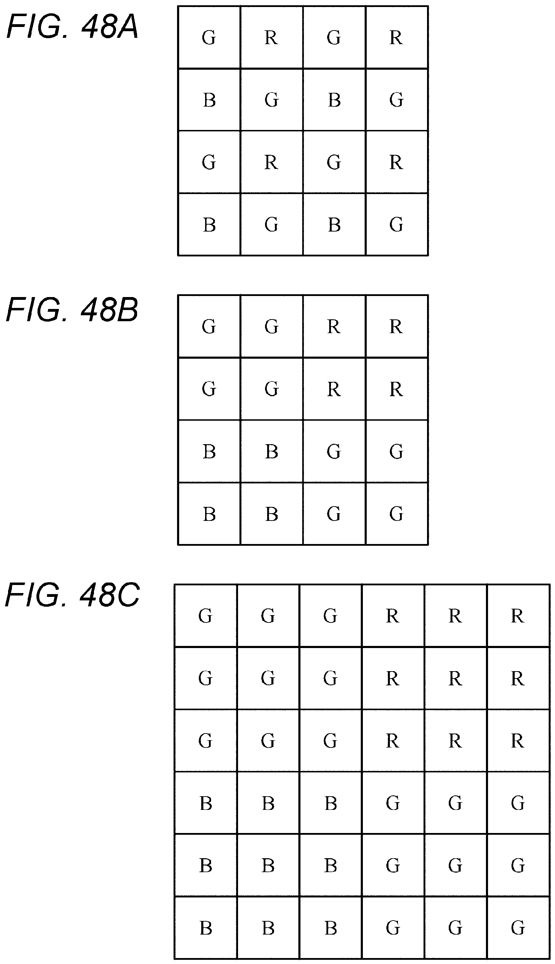

Here, a planar arrangement example of the color filter 130 of the pixel unit 21 according to the second embodiment will be described with reference to Figs. 48A to 48I. Figs. 48A to 48I are plan views illustrating an example of a planar arrangement of the color filters 130 in the pixel unit 21.

For example, as illustrated in Fig. 48A, the color filters 130 may be arranged with four pixels of one red (Red: R) pixel, two green (Green: G) pixels arranged diagonally, and one blue (Blue: B) pixel as one unit.

For example, as illustrated in Fig. 48B, the color filter 130 may be arranged with four red (R) pixels arranged in 2 × 2, eight green (G) pixels in which 2 × 2 pixel groups are arranged diagonally, and four blue (B) pixels arranged in 2 × 2 as one unit.

For example, as illustrated in Fig. 48C, the color filters 130 may be arranged with nine red (R) pixels arranged in 3 × 3, 18 green (G) pixels in which 3 × 3 pixel groups are arranged diagonally, and nine blue (B) pixels arranged in 3 × 3 as one unit.

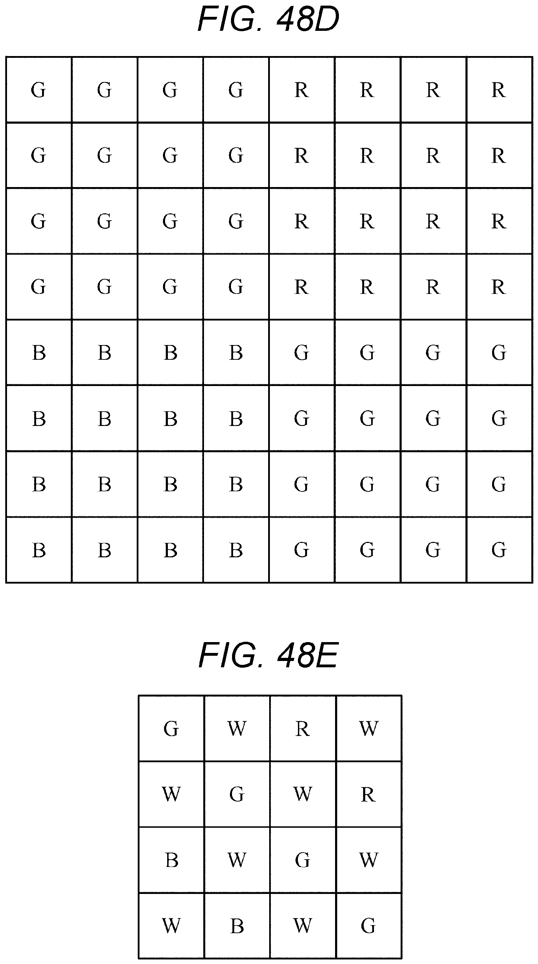

For example, as illustrated in Fig. 48D, the color filters 130 may be arranged with 16 red (R) pixels arranged in 4 × 4, 32 green (G) pixels in which 4 × 4 pixel groups are arranged diagonally, and 16 blue (B) pixels arranged in 4 × 4 as one unit.

For example, as illustrated in Fig. 48E, the color filters 130 may be arranged by combining red (R) pixels, green (G) pixels, blue (B) pixels, and white (W) pixels. Specifically, the red (R) pixel, the green (G) pixel, and the blue (B) pixel may be arranged such that the same color is diagonally arranged with the white (W) pixel as a pair.

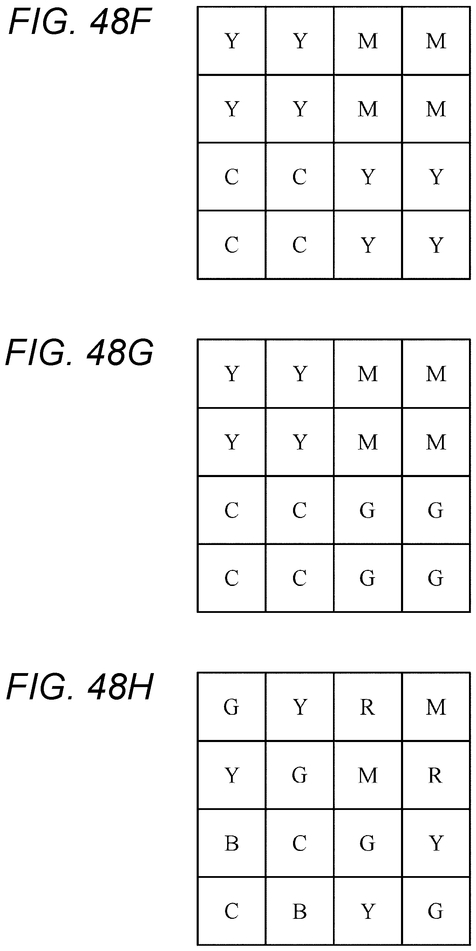

For example, as illustrated in Fig. 48F, the color filters 130 may be arranged with four cyan (Cyan: C) pixels arranged in 2 × 2, eight yellow (Yellow: Y) pixels in which 2 × 2 pixel groups are arranged diagonally, and four magenta (Magenta: M) pixels arranged in 2 × 2 as one unit. Cyan, yellow, and magenta are colors used in a color expression method by so-called decoloring mixing.

For example, as illustrated in Fig. 48G, the color filters 130 may be arranged with four cyan (C) pixels arranged in 2 × 2, four yellow (Y) pixels arranged in 2 × 2, four magenta (M) pixels arranged in 2 × 2, and four green (G) pixels arranged in 2 × 2 as one unit.

For example, as illustrated in Fig. 48H, the color filters 130 may be arranged by combining red (R) pixels, green (G) pixels, blue (B) pixels, cyan (C) pixels, yellow (Y) pixels, and magenta (M) pixels. Specifically, the red (R) pixel, the green (G) pixel, the blue (B) pixel, the cyan (C) pixel, the yellow (Y) pixel, and the magenta (M) pixel may be arranged such that the same color is diagonally arranged with pixels of the same color system as a pair.

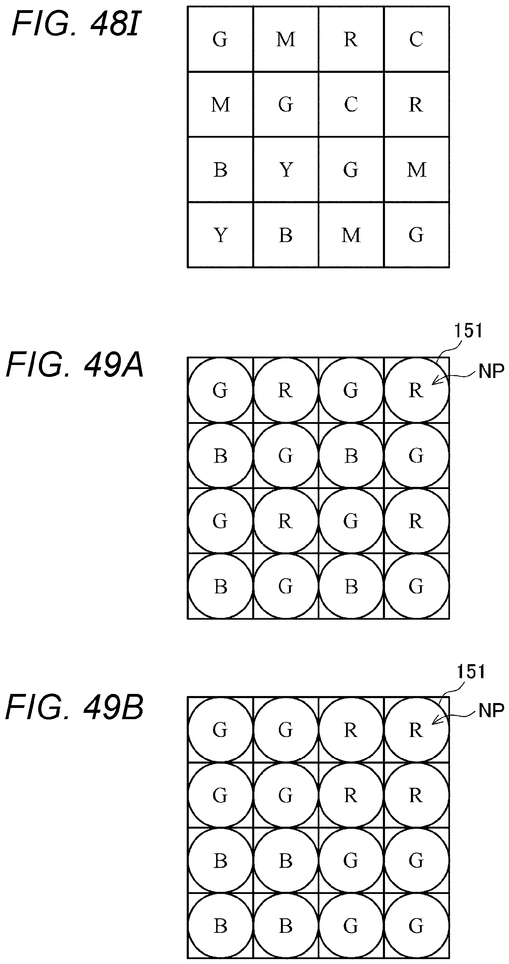

For example, as illustrated in Fig. 48I, the color filters 130 may be arranged by combining red (R) pixels, green (G) pixels, blue (B) pixels, cyan (C) pixels, yellow (Y) pixels, and magenta (M) pixels. Specifically, the red (R) pixel, the green (G) pixel, the blue (B) pixel, the cyan (C) pixel, the yellow (Y) pixel, and the magenta (M) pixel may be arranged such that pixels of complementary colors are paired and the same color is diagonally arranged.

Combinations of the planar arrangement examples of the color filters 130 described with reference to Figs. 48A to 48I and the planar arrangement examples of the normal pixels NP or the phase difference pixels PP are illustrated in Figs. 49A to 49F.

Figs. 49A to 49F are plan views illustrating examples of combinations of the color filters 130 and the normal pixels NP or the phase difference pixels PP.

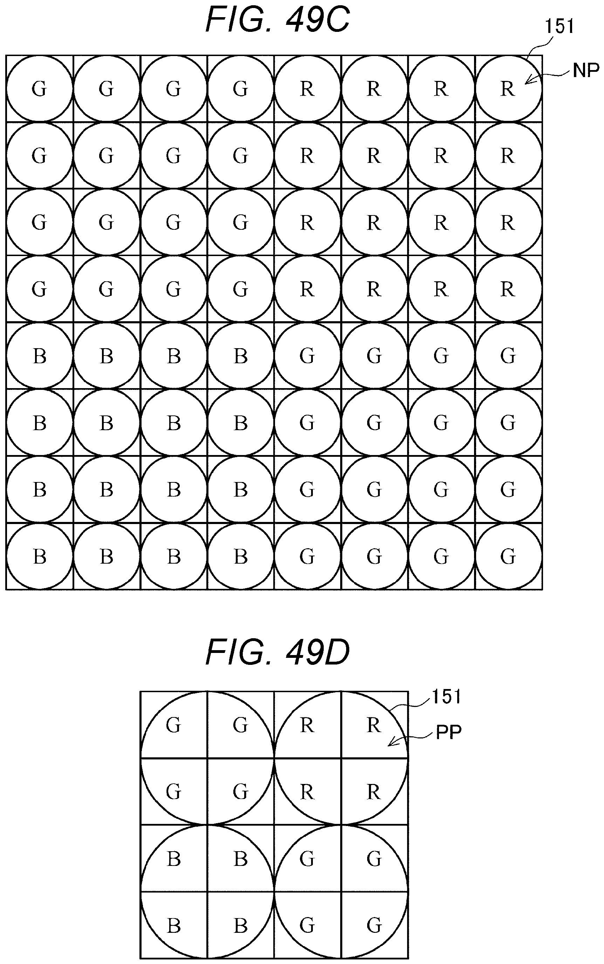

As illustrated in Figs. 49A to 49C, the pixel unit 21 may include normal pixels NP in which 1 × 1 on-chip lenses 151 are placed. At this time, the array of the color filters 130 may be the planar arrangement (Fig. 49A) illustrated in Fig. 48A, the planar arrangement (Fig. 49B) illustrated in Fig. 48B, or the planar arrangement (Fig. 49C) illustrated in Fig. 48D, or may be the RGBW arrangement illustrated in Fig. 48E, the CMY arrangement illustrated in Fig. 48F, or the RGBCMY arrangement illustrated in Fig. 48H or 48I.

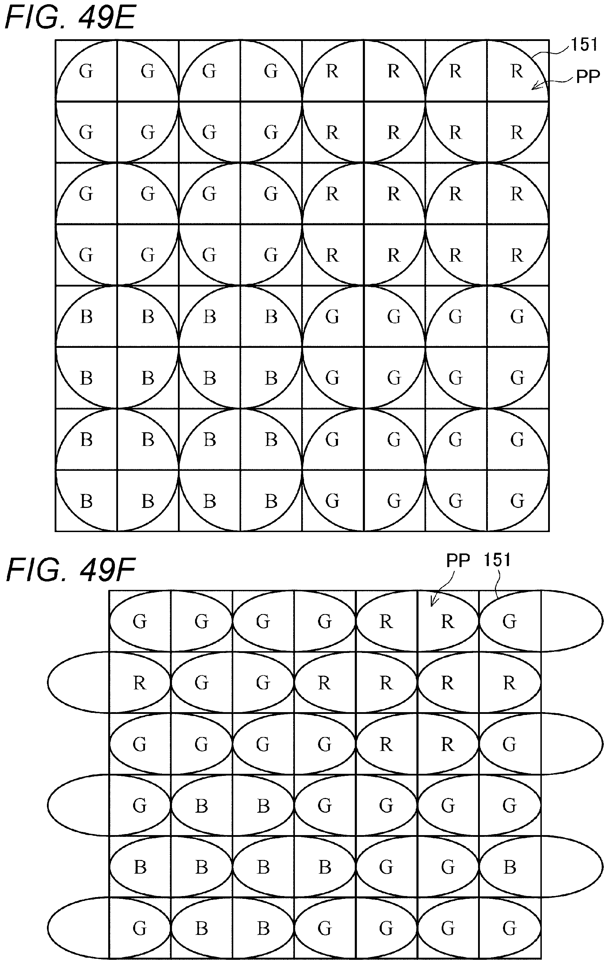

As illustrated in Figs. 49D and 49E, the pixel unit 21 may include phase difference pixels PP in which 2 × 2 on-chip lenses 151 are placed on pixels of the same color. At this time, the arrangement of the color filters 130 may be the planar arrangement illustrated in Fig. 48B (Fig. 49D) or the planar arrangement illustrated in Fig. 48D (Fig. 49E).

As illustrated in Fig. 49F, the pixel unit 21 may include phase difference pixels PP in which 2 × 1 on-chip lenses 151 are placed on pixels of the same color. At this time, the array of the color filters 130 may be a planar arrangement in which two adjacent pixels have the same color and the ratio of red pixels, green pixels, and blue pixels is 1:2:1.

### (15th Modification)

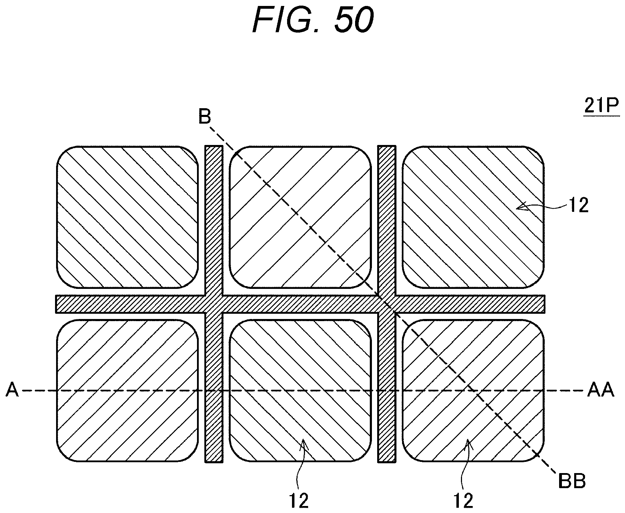

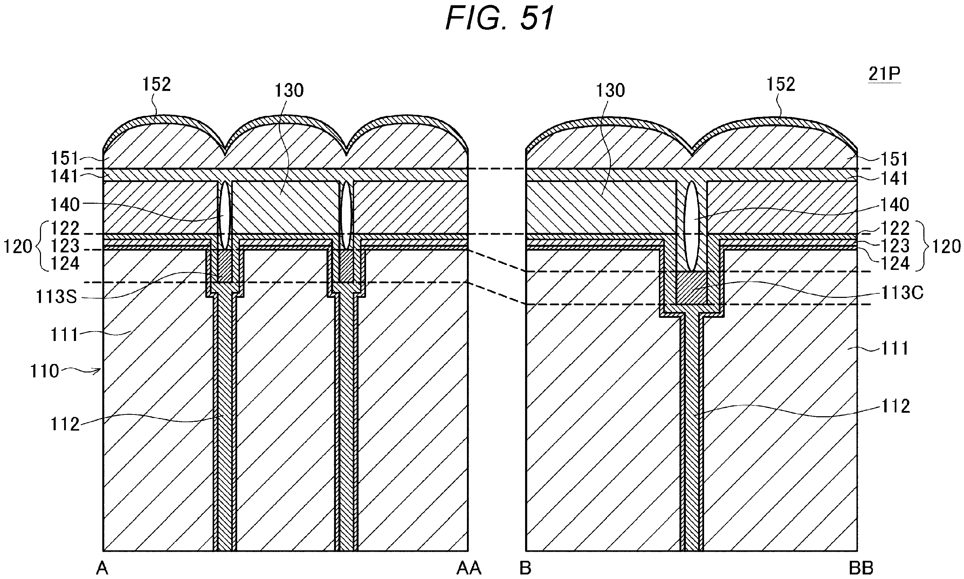

Fig. 50 is a plan view for explaining a configuration of a pixel unit 21P according to a 15th modification. As illustrated in Fig. 50, a cutting line extending in the arrangement direction (lateral direction in Fig. 50) of the pixels 12 arranged in a matrix is defined as an A-AA line, and a cutting line extending in the diagonal direction of the pixels 12 is defined as a B-BB line. Fig. 51 is a longitudinal cross-sectional view illustrating a cross-sectional configuration taken along line A-AA in Fig. 50 and a cross-sectional configuration taken along line B-BB in comparison.

As illustrated in Fig. 51, in the pixel unit 21P according to the 15th modification, a depth and a width at which the light shielding unit 113C is formed between the pixels 12 in the diagonal direction are different from a depth and a width at which a light shielding unit 113S is formed between the pixels 12 in the arrangement direction.

Specifically, the light shielding unit 113C provided between the pixels 12 in the diagonal direction may be provided at a position deeper in the semiconductor substrate 110 than the light shielding unit 113S provided between the pixels 12 in the arrangement direction, and may be provided so as to have a larger width. For example, the lower end of the light shielding unit 113C provided between the pixels 12 in the diagonal direction may be provided below the lower end of the light shielding unit 113S provided between the pixels 12 in the arrangement direction. Furthermore, the width of the light shielding unit 113C provided between the pixels 12 in the diagonal direction may be larger than the width of the light shielding unit 113S provided between the pixels 12 in the arrangement direction. Note that the upper end of the light shielding unit 113C provided between the pixels 12 in the diagonal direction may be provided below the upper end of the light shielding unit 113S provided between the pixels 12 in the arrangement direction, or may be provided on the same plane.

This is considered to be because, since the interval between the pixels 12 in the diagonal direction is wider than the interval between the pixels 12 in the arrangement direction, etching to the semiconductor substrate 110 is more likely to proceed between the pixels 12 in the diagonal direction than between the pixels 12 in the arrangement direction in the process of forming the pixel separation wall 112 or the like. Furthermore, the etching of the semiconductor substrate 110 is optimized for the light shielding unit 113S between the pixels 12 in the arrangement direction. Therefore, the shape of the bottom surface of the light shielding unit 113C between the pixels 12 in the diagonal direction is not optimized, and may be a round shape with rounded corners.

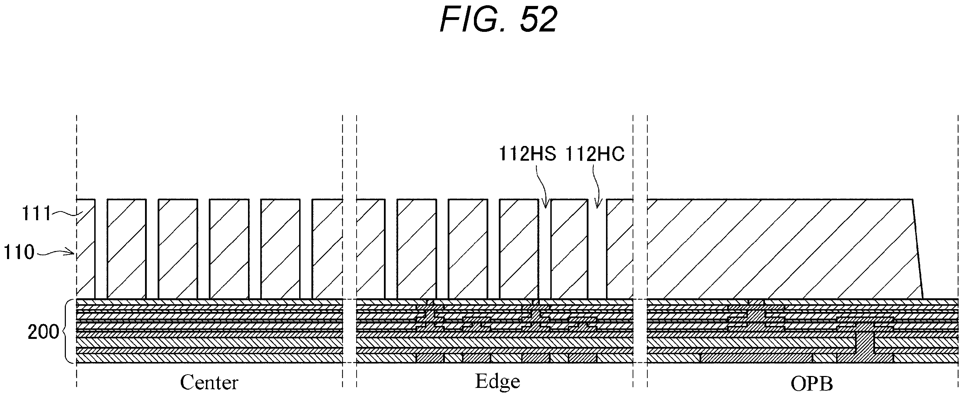

Here, a method of forming the pixel unit 21P according to the 15th modification will be described with reference to Figs. 52 to 64. Figs. 52 to 64 are longitudinal cross-sectional views for explaining a step of forming the pixel unit 21P according to the 15th modification. In Figs. 52 to 64, "Center" indicates a region on the central side of the pixel unit 21P, and "Edge" indicates a region on the peripheral edge side of the pixel unit 21P. In addition, "OPB" indicates an optical black region provided in the pixel unit 21P. The optically black region is a region for detecting dark noise by the light-shielded photoelectric conversion unit 111.

First, as illustrated in Fig. 52, the semiconductor substrate 110 stacked with the circuit layer 200 including the pixel transistor, the wiring, and the like is etched to form openings 112HS and 112HC. For example, the openings 112HS and 112HC may be provided so as to penetrate the semiconductor substrate 110. The opening 112HS is an opening in which the pixel separation wall 112 between the pixels 12 in the arrangement direction is provided, and the opening 112HC is an opening in which the pixel separation wall 112 between the pixels 12 in the diagonal direction is provided. However, since the interval between the pixels 12 in the diagonal direction is wider than the interval between the pixels 12 in the arrangement direction, the width of the opening 112HC is wider than the width of the opening 112HS.

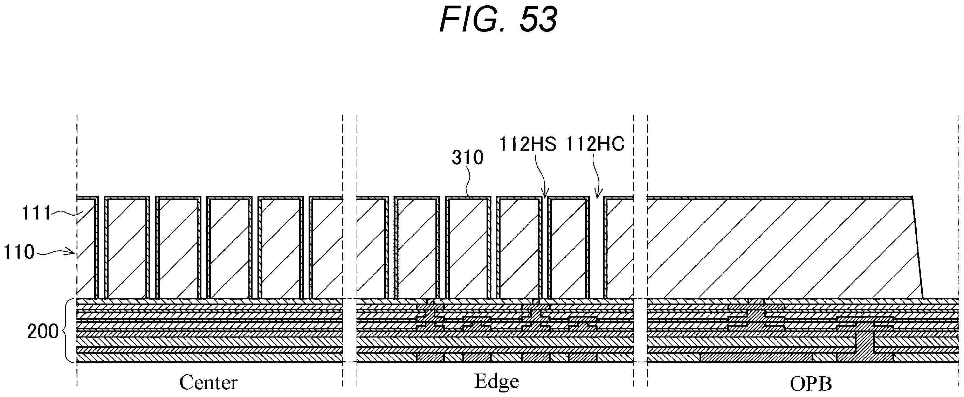

Next, as illustrated in Fig. 53, a protective film 310 is formed on the exposed surface of the semiconductor substrate 110 by ALD. The protective film 310 is constituted by, for example, silicon oxide (SiO₂) or the like, and is formed with a uniform thickness on the exposed surface of the semiconductor substrate 110 including the bottom surface and the inner surface of the openings 112HS and 112HC.

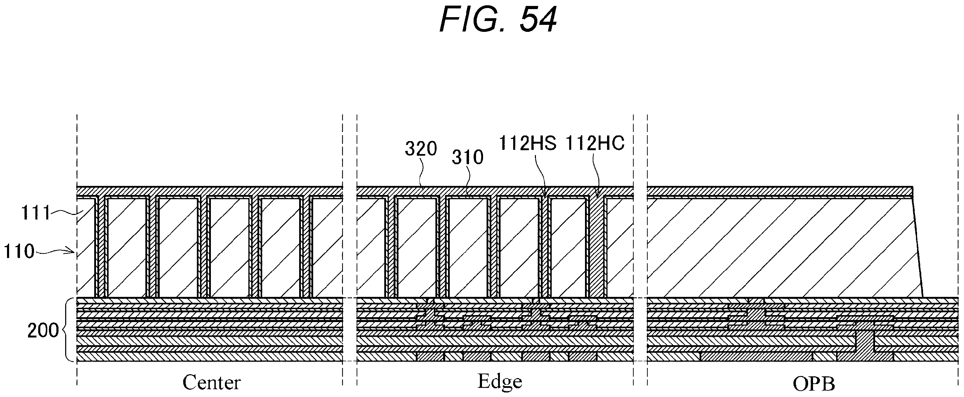

Subsequently, as illustrated in Fig. 54, a resist layer 320 is formed so as to fill the openings 112HS and 112HC and cover the surface of the semiconductor substrate 110. The resist layer 320 may be, for example, an i-line resist.

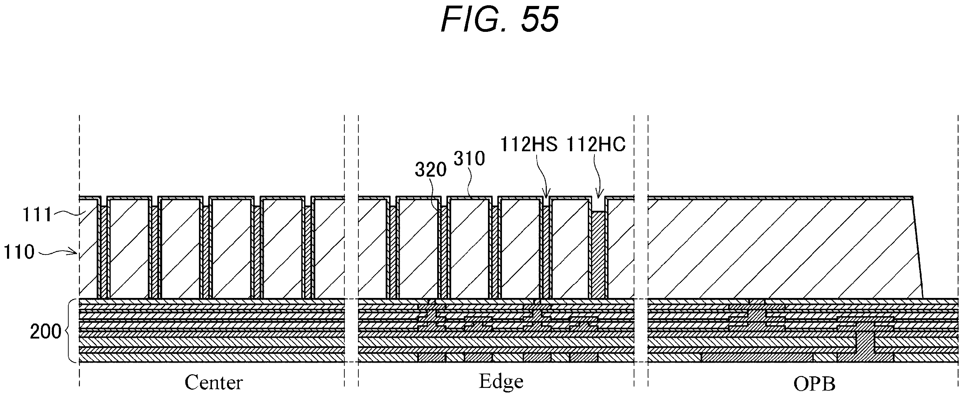

Next, as illustrated in Fig. 55, the entire surface is exposed, so that the resist layer 320 is retracted until the protective film 310 provided on the surface of the semiconductor substrate 110 is exposed. At this time, in the opening 112HC, more of the resist layer 320 than the opening 112HS is retracted by exposure. This is because the width of the opening 112HC is larger than the width of the opening 112HS.

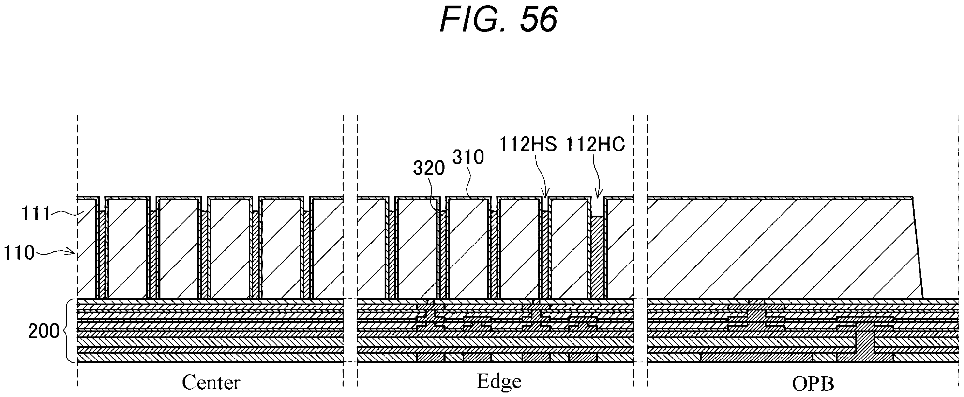

Thereafter, as illustrated in Fig. 56, the entire surface is etched (etched back). As a result, the amount of recession of the resist layer 320 from the surface of the semiconductor substrate 110 is controlled to a target depth.

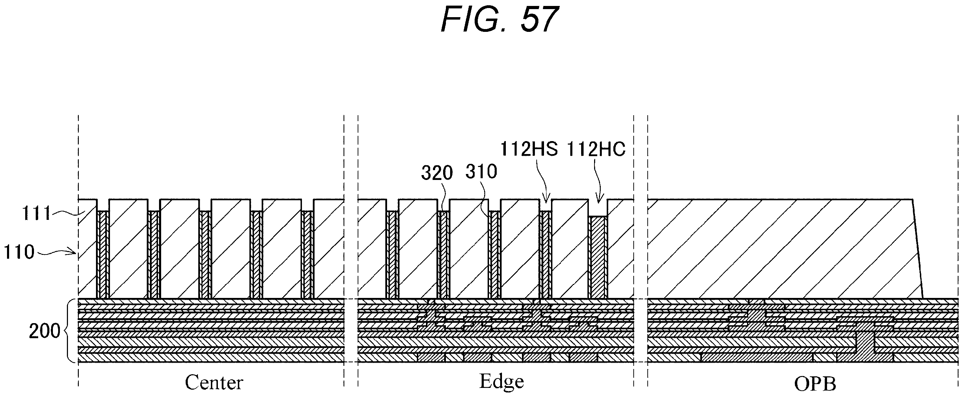

Subsequently, as illustrated in Fig. 57, the protective film 310 which is not masked by the resist layer 320 is removed by etching using DHF (dilute hydrofluoric acid).

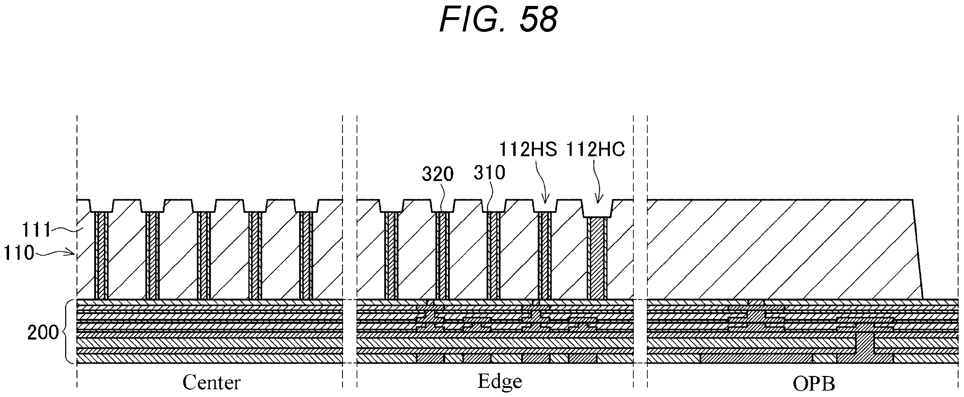

Next, as illustrated in Fig. 58, regions not masked by the protective film 310 and the resist layer 320 of the semiconductor substrate 110 are isotropically etched by chemical dry etching (CDE), whereby the opening widths of the openings 112HC and 112HS are widened.

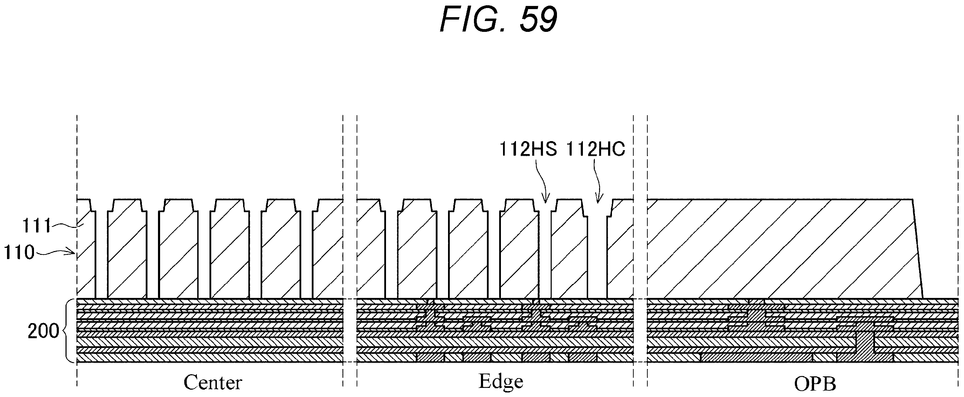

Thereafter, as illustrated in Fig. 59, the protective film 310 and the resist layer 320 are removed.

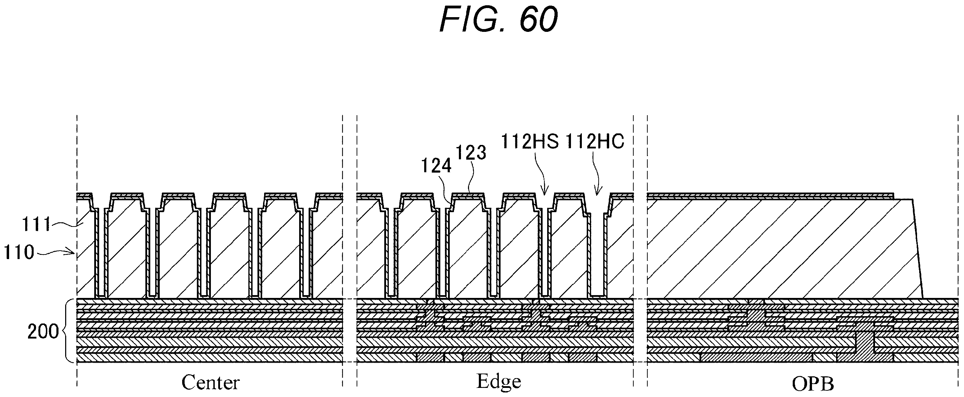

Subsequently, as illustrated in Fig. 60, the fixed charge layer 124 is formed by ALD along the shape of the semiconductor substrate 110. For example, the fixed charge layer 124 is formed with a uniform thickness on the exposed surface of the semiconductor substrate 110 including the bottom surface and the inner surface of the openings 112HC and 112HS. Furthermore, a reflection control layer 123 is further formed on the fixed charge layer 124 provided on the surface of the semiconductor substrate 110.

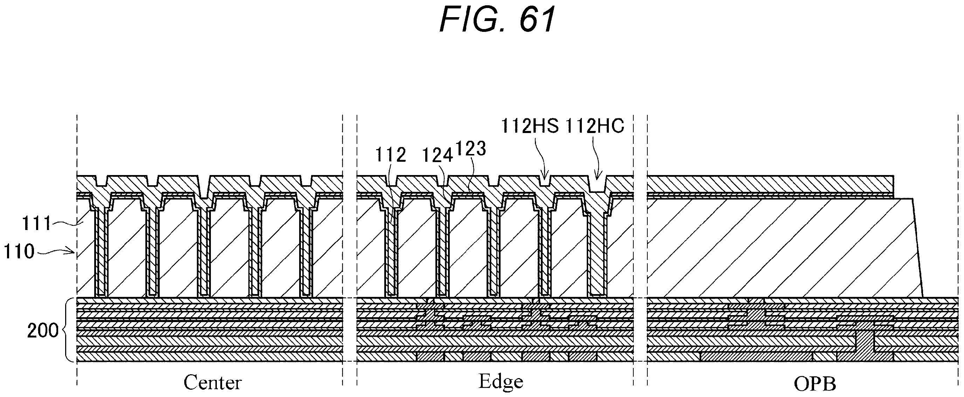

Next, as illustrated in Fig. 61, an insulating material such as SiO₂ is deposited on the fixed charge layer 124 by ALD, thereby embedding a part of the openings 112HC and 112HS. Thus, the pixel separation wall 112 is formed. At this time, the openings 112HC and 112HS are not completely embedded, and a partial concave structure remains on the pixel separation wall 112. The width and depth of the remaining concave structure are larger in the opening 112HC than in the opening 112HS.

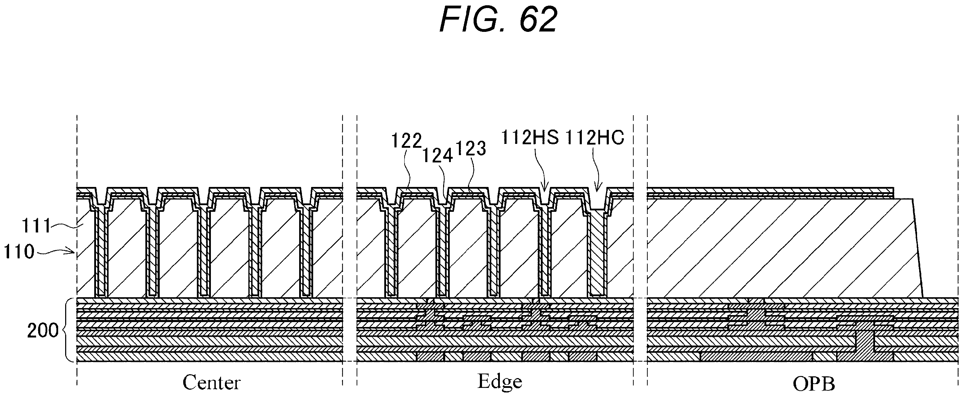

Subsequently, as illustrated in Fig. 62, the thickness of the insulating material on the reflection control layer 123 is controlled by entire surface etching (etch back) by CDE, whereby the dielectric layer 122 is formed.

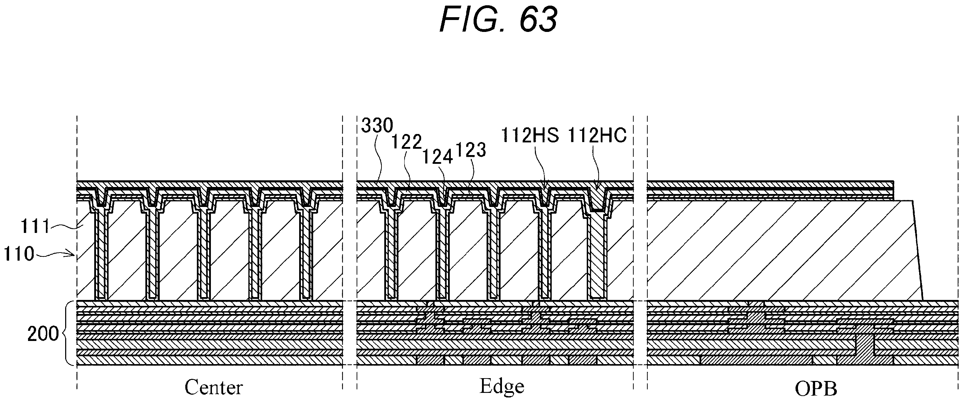

Next, as illustrated in Fig. 63, a light shielding film 330 is formed on the dielectric layer 122 so as to embed the remaining concave structures of the openings 112HC and 112HS. The light shielding film 330 may have, for example, a stacked structure of Ti or TiN and W that prevent diffusion of atoms.

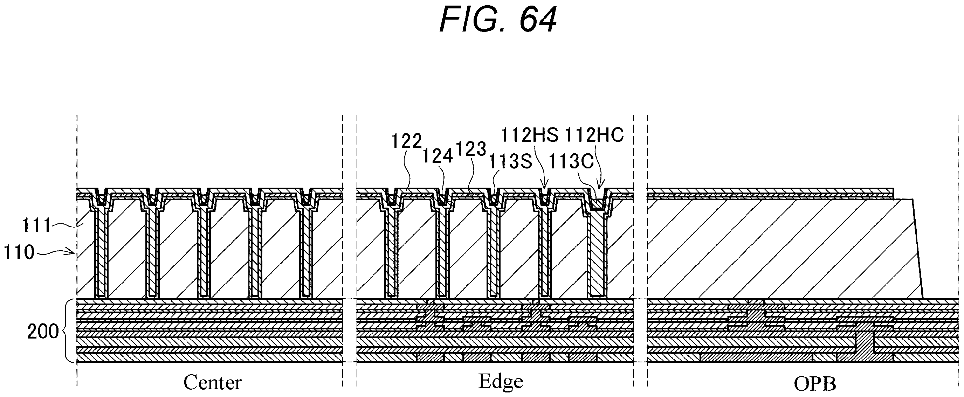

Furthermore, as illustrated in Fig. 64, the light shielding film 330 in a region excluding the insides of the openings 112HC and 112HS is removed by entire surface etching (etch back). Thus, the light shielding unit 113 is formed inside the openings 112HC and 112HS.

Through the above process, the light shielding unit 113C provided between the pixels 12 in the diagonal direction is formed to be wider than the light shielding unit 113S at a position deeper than the light shielding unit 113S provided between the pixels 12 in the arrangement direction.

### (16th Modification)

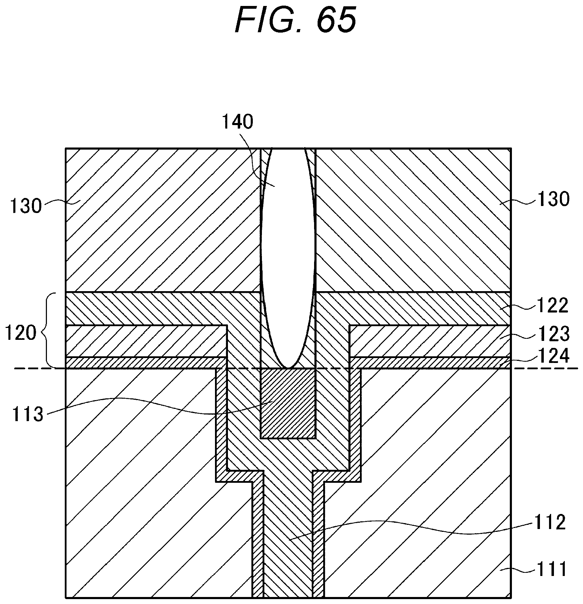

Fig. 65 is a longitudinal cross-sectional view illustrating a configuration in the vicinity of the light shielding unit 113 of a pixel unit according to a 16th modification. As illustrated in Fig. 65, the upper end of the light shielding unit 113 may be provided so as to be on the same plane with the surface of the semiconductor substrate 110. According to this, the light shielding unit 113 can more effectively suppress color mixing due to incidence of light from the adjacent pixels 12. On the other hand, in a case where the upper end of the light shielding unit 113 is shifted upward or downward from the surface position of the surface of the semiconductor substrate 110, color mixing to the adjacent pixels 12 increases, which is not preferable.

Such a positional relationship between the upper end of the light shielding unit 113 and the surface of the semiconductor substrate 110 can be formed by forming the light shielding unit 113 and then planarizing the upper surfaces of the light shielding unit 113 and the semiconductor substrate 110 by chemical mechanical polishing (CMP).

Furthermore, in a case where the upper side of the light shielding unit 113 and the semiconductor substrate 110 is planarized by CMP, the configuration provided on the upper side of the light shielding unit 113 and the semiconductor substrate 110 is temporarily removed. According to this, the dielectric layer 122 on the lower surface of the color filter 130 and the dielectric layers 122 on the side surface and the lower surface of the light shielding unit 113 can be formed separately with different film thicknesses. Therefore, by controlling the film thickness of the dielectric layer 122 on the lower surface of the color filter 130 and the side surface and the lower surface of the light shielding unit 113, color mixing to the adjacent pixels 12 can be more efficiently suppressed.

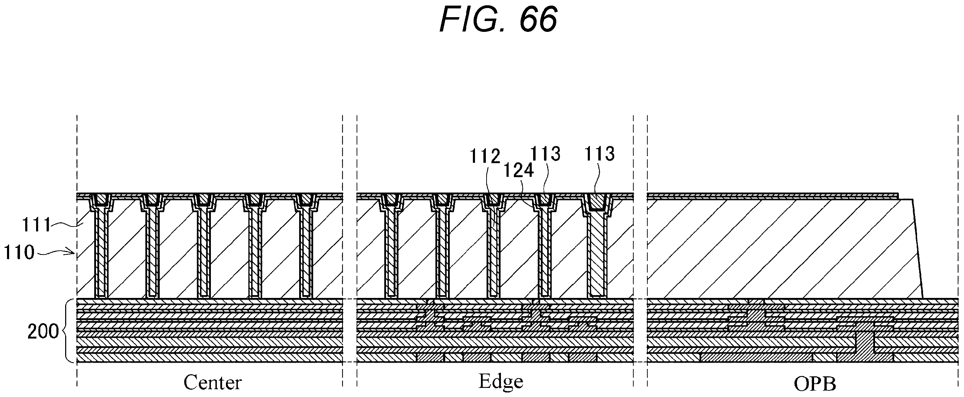

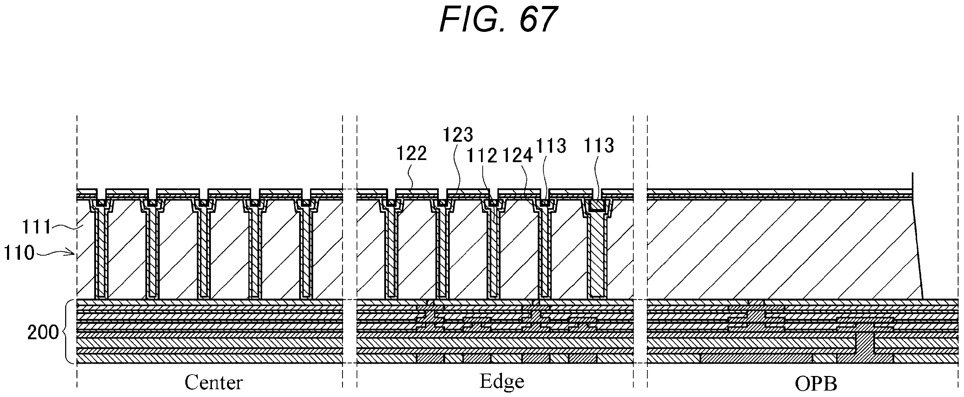

Here, a method of forming the pixel unit according to the 16th modification will be described with reference to Figs. 66 and 67. Figs. 66 and 67 are longitudinal cross-sectional views for explaining a step of forming the pixel unit according to the 16th modification. In Figs. 66 and 67, "Center" indicates a region on the central side of the pixel unit, and "Edge" indicates a region on the peripheral edge side of the pixel unit. In addition, "OPB" indicates an optical black region provided in the pixel unit.

For example, after the step of forming the light shielding film 330 illustrated in Fig. 63, as illustrated in Fig. 66, the dielectric layer 122, the reflection control layer 123, the fixed charge layer 124, and the light shielding film 330 on the semiconductor substrate 110 may be removed by CMP. As a result, the surface of the semiconductor substrate 110 and the upper surface of the light shielding unit 113 are aligned on the same plane.

Thereafter, as illustrated in Fig. 67, the fixed charge layer 124, the reflection control layer 123, and the dielectric layer 122 are formed on the semiconductor substrate 110 again. As a result, in the pixel unit according to the 16th modification, the dielectric layer 122 can be formed with an optimal film thickness on each of the lower surface of the color filter 130 and the side surface and the lower surface of the light shielding unit 113.

### <4. Configuration of Electronic Device>

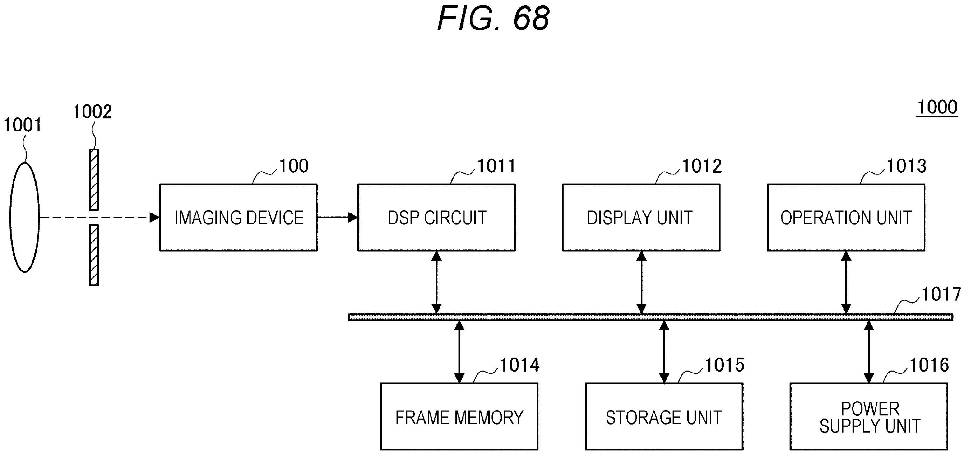

Next, a configuration of an electronic device including the imaging device 100 according to the present embodiment will be described with reference to Fig. 68. Fig. 68 is a block diagram illustrating a configuration example of an electronic device 1000 including the imaging device 100 according to the present embodiment. For example, the electronic device 1000 may be a general electronic device using an imaging device as an image capturing unit (photoelectric conversion unit), such as an imaging device such as a digital camera or a video camera, a mobile terminal device having an imaging function, or a copying machine using an imaging device as an image reading unit. The imaging device may be mounted on the electronic device 1000 in a form formed as one chip, or may be mounted on the electronic device 1000 in a module form having an imaging function in which an imaging section and a signal processing unit or an optical system are packaged together.

As illustrated in Fig. 68, the electronic device 1000 includes an optical lens 1001, a shutter device 1002, the imaging device 100, a digital signal processor (DSP) circuit 1011, a frame memory 1014, a display unit 1012, a storage unit 1015, an operation unit 1013, and a power supply unit 1016. The DSP circuit 1011, the frame memory 1014, the display unit 1012, the storage unit 1015, the operation unit 1013, and the power supply unit 1016 are connected to one another via a bus line 1017.

The optical lens 1001 forms an image of incident light from a subject on an imaging surface of the imaging device 100. The shutter device 1002 controls a light irradiation period and a light shielding period for the imaging device 100.

The imaging device 100 converts the light amount of the incident light formed as an image on the imaging surface by the optical lens 1001 into an electrical signal in units of pixels and outputs the electrical signal as a pixel signal.

The DSP circuit 1011 is a signal processing circuit that performs general camera signal processing on the pixel signal output from the imaging device 100. The DSP circuit 1011 may perform, for example, white balance processing, demosaic processing, gamma correction processing, or the like.

The frame memory 1014 is a temporary data storage unit. The frame memory 1014 is appropriately used for storing data in the process of signal processing in the DSP circuit 1011.

The display unit 1012 includes, for example, a panel type display device such as a liquid crystal panel or an organic electro luminescence (EL) panel. The display unit 1012 can display a moving image or a still image captured by the imaging device 100.

The storage unit 1015 records a moving image or a still image captured by the imaging device 100 in a storage medium such as a hard disk drive, an optical disk, or a semiconductor memory.

The operation unit 1013 issues operation commands for various functions of the electronic device 1000 on the basis of a user's operation.

The power supply unit 1016 is an operation power supply of the DSP circuit 1011, the frame memory 1014, the display unit 1012, the storage unit 1015, and the operation unit 1013. The power supply unit 1016 can appropriately supply power to these supply targets.

### <5. Application Example>

The technology according to the present disclosure (the present technology) can be applied to various products. For example, the technology according to the present disclosure may be realized as a device mounted on any type of moving body such as an automobile, an electric vehicle, a hybrid electric automobile, a motorcycle, a bicycle, a personal mobility, an airplane, a drone, a ship, or a robot.

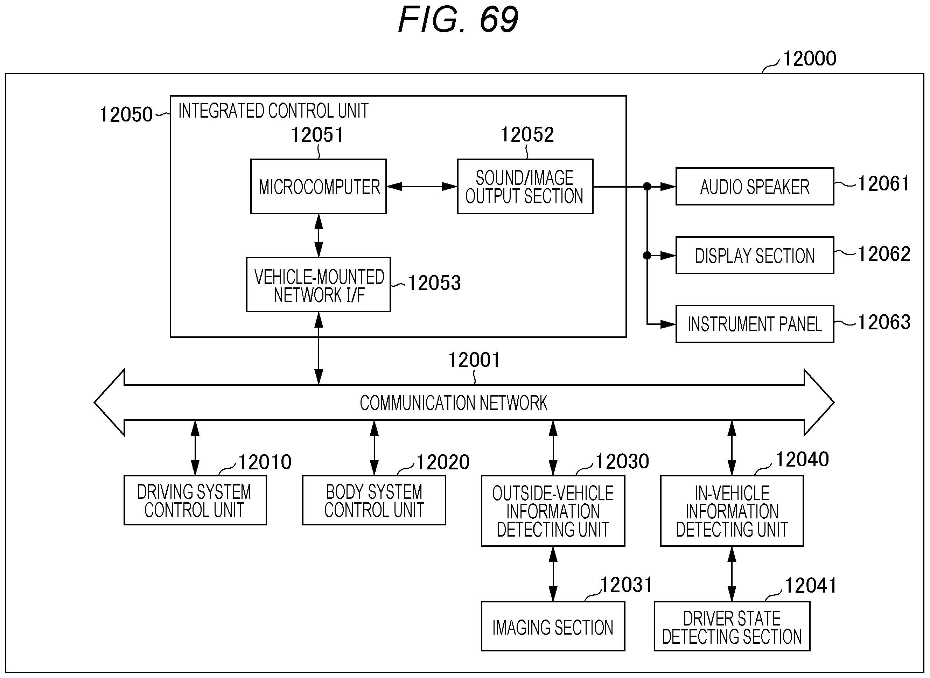

Fig. 69 is a block diagram depicting a schematic configuration example of a vehicle control system as an example of a moving body control system to which the technology according to the present disclosure can be applied.

The vehicle control system 12000 includes a plurality of electronic control units connected to each other via a communication network 12001. In the example depicted in Fig. 69, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

Furthermore, the microcomputer 12051 can output a control command to the body system control unit 12020 on the basis of the information about the outside of the vehicle, which is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of Fig. 69, an audio speaker 12061, a display section 12062, and an instrument panel 12063 are illustrated as the output device. The display section 12062 may, for example, include at least one of an on-board display and a head-up display.

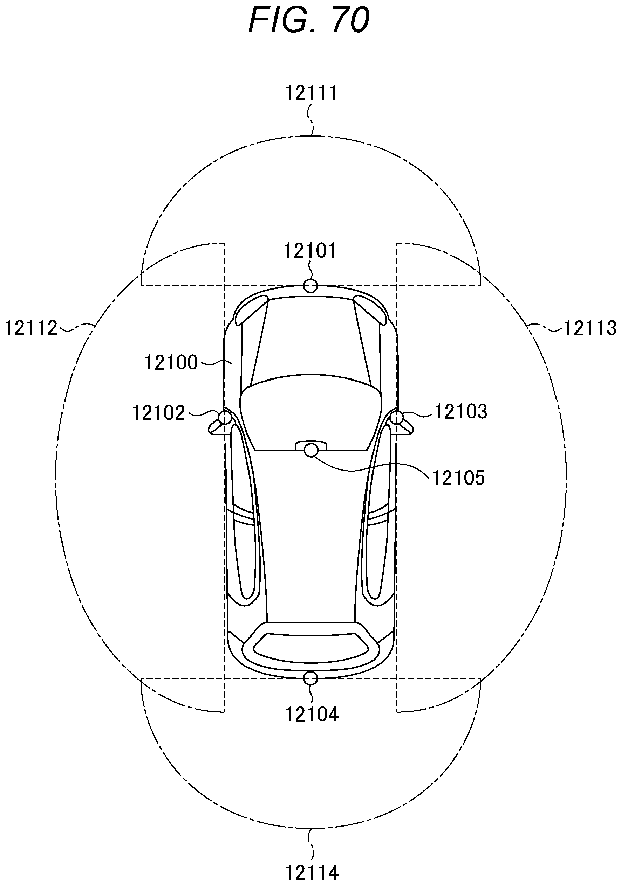

Fig. 70 is a diagram depicting an example of the installation position of the imaging section 12031.

In Fig. 70, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, Fig. 70 depicts an example of imaging ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure can be applied has been described above. The technology according to the present disclosure can be applied to the imaging section 12031 among the configurations described above. By applying the technology according to the present disclosure to the imaging section 12031, it is possible to obtain a captured image with higher definition, and thus, for example, it is possible to recognize an obstacle or a pedestrian in the captured image with higher accuracy. Furthermore, by applying the technology according to the present disclosure to the imaging section 12031, for example, it is possible to reduce driver's fatigue by presenting a more easily viewable captured image.

The preferred embodiments of the present disclosure have been described above in detail with reference to the accompanying drawings, but the technical scope of the present disclosure is not limited to such examples. It is clear that one of ordinary skill in the technical field of the present disclosure may conceive of various modifications or corrections within the scope of the technical idea recited in claims, and it is understood that they also naturally belong to the technical scope of the present disclosure.

Furthermore, the effects described in the present specification are merely exemplary or illustrative, and not restrictive. That is, the technology according to the present disclosure can exhibit other effects apparent to those skilled in the art from the description of the present specification, in addition to the effects above or instead of the effects above.

Note that the following configurations also belong to the technical scope of the present disclosure.
(1) An imaging device including:
   a semiconductor substrate provided with a photoelectric conversion unit for each of pixels two-dimensionally arranged;
   a color filter provided for each of the pixels on the semiconductor substrate;
   an intermediate layer provided between the semiconductor substrate and the color filter; and
   a low refraction region provided between the pixels by separating at least the color filter and the intermediate layer for each of the pixels, the low refraction region having a refractive index lower than a refractive index of the color filter.
(2) The imaging device according to (1), in which the low refraction region includes a gap.
(3) The imaging device according to (2), in which at least a part of an inner wall of the gap is covered with an insulating material.
(4) The imaging device according to any one of (1) to (3), further including an on-chip lens provided on the color filter.
(5) The imaging device according to (4), in which the low refraction region is provided to extend toward the on-chip lens, and separates the on-chip lens for each of the pixels.
(6) The imaging device according to any one of (1) to (5), further including a pixel separation wall that is provided inside the semiconductor substrate and separates the photoelectric conversion unit with an insulating material for each of the pixels.
(7) The imaging device according to (6), in which the pixel separation wall is provided to penetrate the semiconductor substrate.
(8) The imaging device according to (6) or (7), in which the low refraction region is provided to extend to an inside of the pixel separation wall.
(9) The imaging device according to (8), in which the low refraction region extends inside the pixel separation wall and is provided to penetrate the semiconductor substrate.
(10) The imaging device according to (6) or (7), further including a light shielding unit provided inside the pixel separation wall on a side of the intermediate layer.
(11) The imaging device according to (10),
   in which the pixel separation wall is provided to penetrate the semiconductor substrate, and
   the light shielding unit extends inside the pixel separation wall and is provided to penetrate the semiconductor substrate.
(12) The imaging device according to any one of (1) to (11), in which the low refraction region is provided over an entire circumference of the pixel.
(13) The imaging device according to any one of (1) to (12),
   in which the pixel includes a phase difference pixel including a plurality of subpixels, and
   the low refraction region is provided for each phase difference pixel.
(14) The imaging device according to (13), in which one on-chip lens is provided on the plurality of subpixels.
(15) The imaging device according to any one of (1) to (14), in which the intermediate layer includes a layer having a negative fixed charge.
(16) The imaging device according to any one of (1) to (15), in which the color filter contains a pigment or a dye.
(17) The imaging device according to any one of (1) to (16), in which a refractive index of the low refraction region is 1.35 or less.
(18) The imaging device according to (10), in which the intermediate layer includes a dielectric layer extending from the pixel separation wall along a bottom surface and a side surface of the light shielding unit and a lower surface of the color filter.
(19) The imaging device according to (18), in which the intermediate layer further includes a fixed charge layer having a negative fixed charge, provided between the dielectric layer and the semiconductor substrate.
(20) The imaging device according to (19), in which the fixed charge layer extends along a side surface of the dielectric layer and the pixel separation wall.
(21) The imaging device according to (19) or (20), in which the intermediate layer further includes a reflection control layer provided between the dielectric layer and the fixed charge layer, the reflection control layer having a refractive index higher than a refractive index of the dielectric layer and lower than a refractive index of the semiconductor substrate.
(22) The imaging device according to any one of (18) to (21), in which a thickness of the dielectric layer provided along a side surface of the light shielding unit is same as a thickness of the dielectric layer provided along a lower surface of the light shielding unit.
(23) The imaging device according to (22), in which a thickness of the dielectric layer provided along a lower surface of the color filter is same as a thickness of the dielectric layer provided along a side surface and a lower surface of the light shielding unit.
(24) The imaging device according to any one of (18) to (21), in which a thickness of the dielectric layer provided along a side surface of the light shielding unit is thinner than a thickness of the dielectric layer provided along a lower surface of the light shielding unit.
(25) The imaging device according to any one of (18) to (24), in which a width of the light shielding unit is same as a width of the low refraction region or narrower than the width of the low refraction region.
(26) The imaging device according to any one of (18) to (25), in which the light shielding unit and the low refraction region are provided not to be in contact with each other.
(27) The imaging device according to any one of (18) to (26), in which a height of an upper surface of the light shielding unit is same as a height of an upper surface of the semiconductor substrate.
(28) The imaging device according to any one of (18) to (26), in which a position of a lower surface of the light shielding unit provided between the pixels in a diagonal direction of the pixels is lower than a position of a lower surface of the light shielding unit provided between the pixels in an arrangement direction of the pixels.
(29) The imaging device according to (28), in which a width of the light shielding unit provided between the pixels in the diagonal direction of the pixels is wider than a width of the light shielding unit provided between the pixels in the arrangement direction of the pixels.

### REFERENCE SIGNS LIST

- 12: Pixel
- 13: Pixel unit
- 14: Vertical drive circuit
- 15: Column signal processing circuit
- 16: Horizontal drive circuit
- 17: Output circuit
- 18: Control circuit
- 19: Vertical signal line
- 20: Horizontal signal line
- 100: Imaging device
- 110: Semiconductor substrate
- 111: Photoelectric conversion unit
- 112: Pixel separation wall
- 113: Light shielding unit
- 120: Intermediate layer
- 122: Dielectric layer
- 123: Reflection control layer
- 124: Fixed charge layer
- 130: Color filter
- 140: Refraction region
- 141: Insulating layer
- 151: On-chip lens
- 152: Antireflection film
- NP: Normal pixel
- PP: Phase difference pixel
- SP: Subpixel

## Claims

1. An imaging device comprising:
a semiconductor substrate provided with a photoelectric conversion unit for each of pixels two-dimensionally arranged;
a color filter provided for each of the pixels on the semiconductor substrate;
an intermediate layer provided between the semiconductor substrate and the color filter; and
a low refraction region provided between the pixels by separating at least the color filter and the intermediate layer for each of the pixels, the low refraction region having a refractive index lower than a refractive index of the color filter.

2. The imaging device according to claim 1, wherein the low refraction region includes a gap.

3. The imaging device according to claim 2, wherein at least a part of an inner wall of the gap is covered with an insulating material.

4. The imaging device according to claim 1, further comprising an on-chip lens provided on the color filter.

5. The imaging device according to claim 4, wherein the low refraction region is provided to extend toward the on-chip lens, and separates the on-chip lens for each of the pixels.

6. The imaging device according to claim 1, further comprising a pixel separation wall that is provided inside the semiconductor substrate and separates the photoelectric conversion unit with an insulating material for each of the pixels.

7. The imaging device according to claim 6, wherein the pixel separation wall is provided to penetrate the semiconductor substrate.

8. The imaging device according to claim 6, wherein the low refraction region is provided to extend to an inside of the pixel separation wall.

9. The imaging device according to claim 8, wherein the low refraction region extends inside the pixel separation wall and is provided to penetrate the semiconductor substrate.

10. The imaging device according to claim 6, further comprising a light shielding unit provided inside the pixel separation wall on a side of the intermediate layer.

11. The imaging device according to claim 10,
wherein the pixel separation wall is provided to penetrate the semiconductor substrate, and
the light shielding unit extends inside the pixel separation wall and is provided to penetrate the semiconductor substrate.

12. The imaging device according to claim 1, wherein the low refraction region is provided over an entire circumference of the pixel.

13. The imaging device according to claim 1,
wherein the pixel includes a phase difference pixel including a plurality of subpixels, and
the low refraction region is provided for each phase difference pixel.

14. The imaging device according to claim 13, wherein one on-chip lens is provided on the plurality of subpixels.

15. The imaging device according to claim 1, wherein the intermediate layer includes a layer having a negative fixed charge.

16. The imaging device according to claim 1, wherein the color filter contains a pigment or a dye.

17. The imaging device according to claim 1, wherein a refractive index of the low refraction region is 1.35 or less.

18. The imaging device according to claim 10, wherein the intermediate layer includes a dielectric layer extending from the pixel separation wall along a bottom surface and a side surface of the light shielding unit and a lower surface of the color filter.

19. The imaging device according to claim 18, wherein the intermediate layer further includes a fixed charge layer having a negative fixed charge, provided between the dielectric layer and the semiconductor substrate.

20. The imaging device according to claim 19, wherein the fixed charge layer extends along a side surface of the dielectric layer and the pixel separation wall.

21. The imaging device according to claim 19, wherein the intermediate layer further includes a reflection control layer provided between the dielectric layer and the fixed charge layer, the reflection control layer having a refractive index higher than a refractive index of the dielectric layer and lower than a refractive index of the semiconductor substrate.

22. The imaging device according to claim 18, wherein a thickness of the dielectric layer provided along a side surface of the light shielding unit is same as a thickness of the dielectric layer provided along a lower surface of the light shielding unit.

23. The imaging device according to claim 22, wherein a thickness of the dielectric layer provided along a lower surface of the color filter is same as a thickness of the dielectric layer provided along a side surface and a lower surface of the light shielding unit.

24. The imaging device according to claim 18, wherein a thickness of the dielectric layer provided along a side surface of the light shielding unit is thinner than a thickness of the dielectric layer provided along a lower surface of the light shielding unit.

25. The imaging device according to claim 18, wherein a width of the light shielding unit is same as a width of the low refraction region or narrower than the width of the low refraction region.

26. The imaging device according to claim 18, wherein the light shielding unit and the low refraction region are provided not to be in contact with each other.

27. The imaging device according to claim 18, wherein a height of an upper surface of the light shielding unit is same as a height of an upper surface of the semiconductor substrate.

28. The imaging device according to claim 18, wherein a position of a lower surface of the light shielding unit provided between the pixels in a diagonal direction of the pixels is lower than a position of a lower surface of the light shielding unit provided between the pixels in an arrangement direction of the pixels.

29. The imaging device according to claim 28, wherein a width of the light shielding unit provided between the pixels in the diagonal direction of the pixels is wider than a width of the light shielding unit provided between the pixels in the arrangement direction of the pixels.
